(19) Europäisches Patentamt
European Patent Office
Office européen des brevets

(11) **EP 4 063 870 A1**

(12) **EUROPÄISCHE PATENTANMELDUNG**

(43) Veröffentlichungstag:
**28.09.2022  Patentblatt 2022/39**

(21) Anmeldenummer: **21164380.4**

(22) Anmeldetag: **23.03.2021**

(51) Internationale Patentklassifikation (IPC):
**G01R 15/08** (2006.01)

(52) Gemeinsame Patentklassifikation (CPC):
**G01R 15/08**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **Weiss, Roland**
  **91058 Erlangen (DE)**
• **Zapf, Florian**
  **91054 Buckenhof (DE)**

(54) **VERFAHREN UND ELEKTRONISCHE SCHALTUNGSANORDNUNG ZUR KOMBINATION VON AUSGANGSSIGNALEN ELEKTRISCHER SYSTEME MIT VERSCHIEDENEN SIGNAL-FREQUENZBEREICHEN**

(57)    Um Ausgangssignale (ASI1, ASI2) elektrischer Systeme (SY1, SY2) mit verschiedenen Signal-Frequenzbereichen (FB1, FB2) im Zuge einer systemtheoretischen Rekonstruktion eines Signals (ESI) bei der Erfassung einer physikalischen Messgröße (MG, ST) durch eine Signalkombination fehlerminimal oder fehleroptimal kombinieren (kbn) zu können, wird es vorgeschlagen Übertragungsfunktionen $"H_3^k(s)"$, $"H_4^k(s)"$, $H_5(s)$ (ÜF3, ÜF4) von Filtersystemen (FSY1, FSY2) und Filtersignale (FS1, FS2, FS$_K$) zu ermitteln (flt), welche die fehlerfreie oder fehlerminimale, auf ein Kombinationssignal (KSI) basierte Rekonstruktion des Signals (ESI) aus zwei in verschiedenen, z.B. überlappenden oder unterschiedlichen, Frequenzbereichen vorliegenden Teilsignalen - den Ausgangssignalen (ASI1, ASI2) der elektrischer Systeme (SY1, SY2), z.B. einem DC-Sensor (FGW, HES, PW) und einem AC-Sensor (PEM-W, STW) - mit den verschiedenen Frequenzbereichen (FB1, FB2) - in einem möglichst großen Frequenzbereich erlaubt, wobei die beiden Teilsignale bzw. Ausgangssignale (ASI1, ASI2) entstehen, indem die physikalischen Messgröße (MG) durch die zwei elektrischer Systeme (SY1, SY2) als Signalerfassungseinheiten mit verschiedener, z.B. überlappender oder unterschiedlicher, Frequenz-Charakteristik jeweils unabhängig voneinander erfasst wird.

**Beschreibung**

Die Erfindung bezieht sich auf ein Verfahren zur Kombination von Ausgangssignalen elektrischer Systeme mit verschiedenen Signal-Frequenzbereichen gemäß dem Oberbegriff des Patentanspruches 1 und eine Elektronische Schaltungsanordnung zur Kombination von Ausgangssignalen elektrischer Systeme mit verschiedenen Signal-Frequenzbereichen gemäß dem Oberbegriff des Patentanspruches 9.

Ein elektrisches System gemäß der vorliegenden Erfindung und im Sinne einer systemtheoretischen Betrachtung mit den Konzepten Signal und System ist eine abstrakte Beschreibung, d. h. ein Modell eines realen Vorgangs, der Signale umwandelt. Das elektrische System kann in seiner Systemausprägung (Funktionalität, Komplexität,...) beliebig ausgestaltet sein, so z.B. ein Verstärker oder ein Filter, während das Signal als eine veränderliche Größe oder Funktion Informationen darstellt, so z. B. eine physikalische Größe wie einen elektrischen Strom, eine elektrische Spannung etc.

Zur Systembeschreibung dienen die physikalische Anregung und die Reaktion des Systems und das System wird als mathematische Funktion unabhängiger Variablen der Zeit oder auch des Ortes ausgedrückt. Die Anregungen des Systems werden dabei als Eingangssignal, die Reaktionen des Systems als Ausgangssignal bezeichnet und das System stellt im Rahmen des mathematischen Modells stellt eine Beziehung zwischen dem Eingangs- und dem Ausgangssignal her, das bei linearen zeitinvarianten Systemen durch eine Übertragungsfunktion beschrieben wird.

Vor diesem systemtheoretischen Hintergrund können elektrische Systeme mit Ausgangssignalen in verschiedenen Signal-Frequenzbereichen, wenn diese sich zur Rekonstruktion des Eingangssignals kombinieren lassen, vielfältig zur Anwendung kommen, so z.B. im Bereich der Strommessung oder Strom-Sensorik sowie im Bereich der Schwingungsmesstechnik.

Bei der Strommessung oder Strom-Sensorik *(vgl.* Dissertation von B. Hudoffsky "Berührungslose Messung schnell veränderlicher Ströme*"; Uni Stuttgart 2014 <Druckfreigabe 140806>)* kommen sogenannte "Direct Current <DC>"-Sensoren, die von einem Gleichstromwert (DC) bis zu einer mittleren Frequenz, z.B. 200 kHz, messen und/oder sogenannte "Alternate Current <AC>"-Sensoren, die von niedrigen Frequenzen, z.B. 20 Hz, bis zu vergleichsweise hohen Frequenzen von ca. 10 MHz und höher messen, zum Einsatz.

Während der AC-Sensor zum Erfassen einer Messgröße "Strom", z.B. den Strom eines stromdurchflossenen Leiters, beispielsweise als ein PEM-Wandler als Rogowski-Spule mit einem Integrierer (AC-Rogowski-Stromsonden) oder als ein Stromwandler mit Sekundär-Shunt ausgebildet sein kann, ist der DC-Sensor zum Erfassen der Messgröße "Strom", z.B. wieder den Strom eines stromdurchflossenen Leiters, beispielsweise als ein Fluxgate-Wandler in Closed Loop-Ausführung oder ein Hall Effect Sensor sowohl in Open Loop- als auch in Closed Loop-Ausführung oder als ein Pearson-Wandler mit "wide-band current transformer"-Charakteristik und einem sekundären Shunt ausgebildet.

Auf diese Weise können Ströme als Messgröße in einem breitem Frequenzspektrum von einer niedrigen Frequenz des DC-Sensors bis zur oberen Frequenz des AC-Sensors gemessen werden. Diese Kombination der Strommessung würde sich z.B. durch mechanische Flexibilität auszeichnen, da beide Messprinzipien eine mechanisch flexible Realisierung mittels einer Feldsonde ermöglichen.

Die Realisierung eines mechanisch flexiblen DC-Sensors ist beispielsweise aus EP 3671226 A1 bekannt. Das hierbei verwendete Grundprinzip zur Strommessung wurde zum Beispiel in WO 2018185151 A1 vorgestellt. Des Weiteren sind aus EP 3561524 A1 AC- und DC-Sensoren bekannt, welche ohne das Auftrennen der Strombahn montiert werden können. Eine besonders vorteilhafte Bauform für DC-Sensoren, die für die Montage auf einer Strombahn geöffnet werden können, wurde in WO 2020151926 A1 vorgestellt.

Aus der WO 2017/197269 A1 ist ein Messsystem bekannt, dass durch Anpassung des DC-Signals eines magnetoresistiven Sensors mittels Tiefpassfilterung und durch die Anpassung des AC-Signals einer Rogowski-Spule mit einem Bandpassfilter, beide Einzelsensorsignale für eine gemeinsame Strommessung verwenden kann. Dabei wurde aber nicht berücksichtigt, dass durch die begrenzten Frequenzbereiche der Sensoren, die zudem meistens nicht genau spezifiziert sind, Fehler auftreten.

Nach dem derzeitigen Stand der Technik wird häufig das Signal der Rogowski-Spule durch eine spezifische Übertragungsfunktion die über weite Bereiche einem Tiefpassfilter erster Ordnung entspricht an das Signal eines DC-Sensors angepasst. Dabei wird davon ausgegangen, dass die Übertragungsfunktion des DC-Sensors im Detail bekannt ist und sich über Temperatur, Magnetfeld oder Zeit nicht verändert.

Ein Schaltungskonzept, das den Einsatz von "Current Transformer <CT>" als AC-Sensor oder die handelsübliche Kombination aus Rogowski-Spule mit integriertem Integrator/Integrierer als AC-Sensor und einem der vorstehend genannten Realisierungsoptionen als DC-Sensor in Bezug auf Übertragungsfunktionen betrachtet, wurde bisher nicht thematisiert.

Da die Übertragungsfunktion von AC-Sensoren und von DC-Sensoren in den Datenblättern häufig nicht exakt spezifiziert wird oder die relevanten Parameter, wie Eckfrequenz (auch als -3dB Frequenz bezeichnet) üblicherweise einer gewissen Drift, z.B. verursacht durch Temperaturveränderung oder Alterung, unterliegt, gibt es ein Interesse an einer diesbezüglichen substanziellen Verbesserung gegenüber dem Stand der Technik.

Der hierbei häufigste Ansatz, um diese Verbesserung zu erreichen, ist jedoch die Erweiterung des Frequenzbereiches des jeweils verwendeten Sensortyps durch vergleichsweise spezifische Maßnahmen, wie z.B. den Einsatz besserer Materialien, den Einsatz von besseren sensitiven Elementen, der Verwendung von neuen Sensortechnologien usw.

Die der Erfindung zugrundeliegende Aufgabe besteht darin, ein Verfahren und eine Elektronische Schaltungsanordnung zur Kombination von Ausgangssignalen elektrischer Systeme mit verschiedenen Signal-Frequenzbereichen anzugeben, mit dem bzw. der im Zuge einer systemtheoretischen Rekonstruktion eines Signals bei der Erfassung einer physikalischen Messgröße eine fehlerminimale oder fehleroptimale Kombination der Ausgangssignale erzielt werden kann.

Diese Aufgabe wird ausgehend von dem im Oberbegriff des Patentanspruchs 1 definierten Verfahren durch die im Kennzeichen des Patentanspruches 1 angegebenen Merkmale gelöst.

Darüber hinaus wird die Aufgabe ausgehend von der im Oberbegriff des Patentanspruchs 9 definierten Elektronischen Schaltungsanordnung durch die im Kennzeichen des Patentanspruches 9 angegebenen Merkmale gelöst.

Die der Erfindung gemäß den unabhängigen Ansprüchen 1 und 9 zugrundeliegende Idee besteht darin, Übertragungsfunktionen von Filtersystemen und Filtersignale zu ermitteln (Filterung), welche eine fehlerfreie oder fehlerminimale, auf ein Kombinationssignal basierte Rekonstruktion eines Erfassungssignals bei der Erfassung einer physikalischen Messgröße, z.B. einen Strom, als Eingangssignal für die systemtheoretische Rekonstruktion durch eine Signalkombination aus zwei in verschiedenen, z.B. überlappenden oder unterschiedlichen, Frequenzbereichen vorliegenden Teilsignalen - Ausgangssignalen elektrischer Systeme, z.B. eines "Alternate Current <AC>"-Sensors (AC-Sensors) und eines "Direct Current <DC>"-Sensors (DC-Sensors), mit verschiedenen Frequenzbereichen und Grenzfrequenzen (Grenzkreisfrequenzen) - in einem möglichst großen Frequenzbereich erlaubt, wobei die beiden Teilsignale bzw. Ausgangssignale entstehen, indem die physikalischen Messgröße durch die beiden elektrischen Systeme als Signalerfassungseinheiten mit verschiedener, z.B. überlappender oder unterschiedlicher, Frequenz-Charakteristik jeweils unabhängig voneinander erfasst wird.

Diese Idee wird gemäß den Ansprüchen 1 und 9 umgesetzt, indem die Teilsignale - ein erstes Ausgangssignal eines ersten elektrischen Systems, z.B. des DC-Sensors, mit einer ersten Grenzkreisfrequenz $\omega_{SY1}$ und einer ersten Übertragungsfunktion m-ter Ordnung $"H_1^m(s)"$ sowie ein zweites Ausgangssignal eines zweiten elektrischen Systems, z.B. des AC-Sensors, mit einer zweiten Grenzkreisfrequenz $\omega_{SY2}$ und einer zweiten Übertragungsfunktion p-ter Ordnung $"H_2^p(s)"$ - gefiltert und nach der Filterung zur Erzeugung des Kombinationssignals kombiniert werden, und dabei

- im Zuge der Filterung ein durch eine dritte Übertragungsfunktion k-ter Ordnung $"H_3^k(s)"$ eines ersten Filtersystems im Verhältnis zu dem ersten Ausgangssignal bestimmbares, erstes Filtersignal mit einer Filter-Grenzkreisfrequenz $\omega_0$ generiert wird,

- im Zuge der Filterung in Bezug auf eine vierte Übertragungsfunktion k-ter Ordnung $"H_4^k(s)"$ eines zweiten Filtersystems

   (**a**) ein durch die dritte Übertragungsfunktion k-ter Ordnung $"H_3^k(s)"$ eines weiteren ersten Filtersystems des zweiten Filtersystems im Verhältnis zu dem zweiten Ausgangssignal bestimmbares, zweites Filtersignal mit der Filter-Grenzkreisfrequenz $\omega_0$ generiert wird oder

   (**b**) ein durch die dritte Übertragungsfunktion k-ter Ordnung $"H_3^k(s)"$ eines weiteren ersten Filtersystems im Verhältnis zu dem zweiten Ausgangssignal bestimmbares, zweites Filtersignal mit der Filter-Grenzkreisfrequenz $\omega_0$ und ein durch eine fünfte Übertragungsfunktion $"H_5(s)"$ eines Kompensation-Filtersystems im Verhältnis zu dem zweiten Ausgangssignal bestimmbares Kompensation-Filtersignal generiert werden,

   - im Zuge der Kombination in Bezug auf die dritte Übertragungsfunktion k-ter Ordnung $"H_3^k(s)"$ des ersten Filtersystems und die vierte Übertragungsfunktion k-ter Ordnung $"H_4^k(s)"$ des zweiten Filtersystems

   (**c**) das zweite Ausgangssignal, das zweite Filtersignal und das erste Filtersignal für eine asymmetrische oder symmetrische Erzeugung des Kombinationssignals zumindest eines von beiden, additiv und subtraktiv, mit Maßgabe von $"H_3^k(s) + H_4^k(s)) = 1"$ verknüpft werden oder

(**d**) das zweite Ausgangssignal, das zweite Filtersignal, das Kompensation-Filtersignal und das erste Filtersignal für eine asymmetrische und kompensatorische oder symmetrische und kompensatorische Erzeugung des Kombinationssignals zumindest eines von beiden, additiv und subtraktiv, mit Maßgabe von

$$"H_3^k(s) \times H_1^m(s) + H_4^k(s) \times H_2^p(s) = 1"$$

verknüpft werden. Zur Ermittlung der Übertragungsfunktionen der Filtersysteme und Filtersignale sowie zur Erzeugung des Kombinationssignals gilt für die Filter-Grenzkreisfrequenz $\omega_0$ jedes Filtersystems k-ter Ordnung - gemäß den Ansprüchen 2 und 10 - (**1**) im Zuge der systemtheoretischen Rekonstruktion des Eingangssignals infolge

- der durch die beiden elektrischen Systeme, z.B. den DC-Sensor und den AC-Sensor, mit den Grenzkreisfrequenzen $\omega_{SY1}$, $\omega_{SY2}$ und den Übertragungsfunktionen m-ter Ordnung oder p-ter Ordnung $"H_1^m(s)"$, $"H_2^p(s)"$ erfassten physikalischen Größe und
- den durch die Übertragungsfunktionen im Verhältnis zu dem Eingangssignal bestimmbaren Ausgangssignalen sowie (**2**) unter der Voraussetzung, dass die m-te Ordnung gleich der p-ten Ordnung, also m=p, ist, folgender funktionaler Zusammenhang zu den Grenzkreisfrequenzen $\omega_{SY1}$, $\omega_{SY2}$ :

$$\omega_0 = \sqrt{\omega_{SY1} \times \omega_{SY2}}$$

Weiterhin ist es für die Ermittlung der Übertragungsfunktionen der Filtersysteme und der Filtersignale sowie für die Erzeugung des Kombinationssignals zweckmäßig und vorteilhaft, wenn - gemäß den Ansprüchen 3 und 11 - auf der Basis eines Standard-Tiefpasses mit einer Verstärkung von "1" und einer Standard-Tiefpass-Übertragungsfunktion j-ter Ordnung mit Koeffizienten abhängig von einer Tiefpass-Filterapproximation, z.B. Butterworth oder Bessel,

$$"H_{TP}^j(s_n) = \frac{1}{1+a_1 s_n + a_2 s_n^2 + \dots + a_j s_n^j}"\ \mathtt{mit}\ s_n = s/\omega_0$$

- die erste Übertragungsfunktion m-ter Ordnung $"H_1^m(s)"$, wenn das erste elektrische System bzw. der DC-Sensor ein Tiefpass gemäß dem Standard-Tiefpass mit einer Tiefpass-Übertragungsfunktion 1. Ordnung $"H_{TP}^1(s_n)"$ und einer Filterapproximationsunabhängigkeit ist, eine Übertragungsfunktion 1. Ordnung $"H_1^1(s_n)"$ mit der Filterapproximationsunabhängigkeit ist, für die gilt:

$$H_1^1(s_n) = \frac{1}{1+s_n/\omega_{SY1,n}} = \frac{1}{1+s_n \cdot \omega_{SY2,n}}$$

mit

$$s_n = s/\omega_0,\ \ \omega_{SY1,n} = \omega_{SY1}/\omega_0,\ \ \omega_{SY2,n} = \omega_{SY2}/\omega_0,\ \ \omega_{SY1,n} = 1/\omega_{SY2,n},$$

und

- die zweite Übertragungsfunktion p-ter Ordnung $"H_2^p(s)"$, wenn das zweite elektrische System bzw. der AC-Sensor ein Hochpass gemäß dem Standard-Tiefpass mit einer Tiefpass-Übertragungsfunktion 1. Ordnung $"H_{TP}^1(s_n)"$ und einer Filterapproximationsunabhängigkeit ist, eine Übertragungsfunktion 1. Ordnung $"H_2^1(s_n)"$ mit der Filterapproximationsunabhängigkeit ist, für die gilt:

$$H_2^1(s_n) = \frac{s_n/\omega_{SY2,n}}{1 + s_n/\omega_{SY2,n}}$$

Ausgehend von dieser vorteilhaften und zweckmäßigen Wahl der auf die Filter-Grenzkreisfrequenz $\omega_0$ normierten Übertragungsfunktionen $"H_1^1(s_n)"$, $"H_2^1(s_n)"$ der elektrischen Systeme basieren

- gemäß der Weiterbildung der Erfindung in den Ansprüchen 4 und 12 - die dritte Übertragungsfunktion k-ter Ordnung $"H_3^k(s)"$ des ersten Filtersystems und die vierte Übertragungsfunktion k-ter Ordnung $"H_4^k(s)"$ des zweiten Filtersystems für die Ermittlung der Übertragungsfunktionen der Filtersysteme und der Filtersignale sowie für die asymmetrische Erzeugung des Kombinationssignals, bei dem vorzugsweise das zweite Ausgangssignal, das zweite Filtersignal und das erste Filtersignal additiv und/oder subtraktiv mit der Maßgabe $"H_3^k(s) + H_4^k(s) = 1"$ verknüpft werden, auf einem Standard-Tiefpass 1. Ordnung $"H_{TP}^1(s_n)"$, 2. Ordnung $"H_{TP}^2(s_n)"$ oder 3. Ordnung $"H_{TP}^3(s_n)"$.

Alternativ dazu ist es - gemäß dieser Weiterbildung der Erfindung in den Ansprüchen 5 und 13 - aber auch möglich, dass die dritte Übertragungsfunktion k-ter Ordnung $"H_3^k(s)"$ des ersten Filtersystems und die vierte Übertragungsfunktion k-ter Ordnung $"H_4^k(s)"$ des zweiten Filtersystems für die Ermittlung der Übertragungsfunktionen der Filtersysteme und der Filtersignale sowie für die symmetrische Erzeugung des Kombinationssignals, bei dem vorzugsweise das zweite Ausgangssignal, das zweite Filtersignal und das erste Filtersignal additiv und/oder subtraktiv mit der Maßgabe $"H_3^k(s) + H_4^k(s) = 1"$ verknüpft werden, auf einem Symmetrie-Tiefpass 1. Ordnung $"H_{STP}^1(s_n)"$, 3. Ordnung $"H_{STP}^3(s_n)"$ oder 5. Ordnung $"H_{STP}^3(s_n)"$ basieren.

Weiterhin ist es alternativ - gemäß der Weiterbildung der Erfindung in den Ansprüchen 6 und 14 - auch möglich, dass die dritte Übertragungsfunktion k-ter Ordnung $"H_3^k(s)"$ des ersten Filtersystems, die vierte Übertragungsfunktion k-ter Ordnung $"H_4^k(s)"$ des zweiten Filtersystems, das gemäß dieser Weiterbildung aus einem weiteren ersten Filtersystem mit der dritten Übertragungsfunktion k-ter Ordnung $"H_3^k(s)"$ und einem Kompensation-Filtersystem (FSY$_K$) mit einer fünften Übertragungsfunktion $"H_5(s)"$ gebildet wird, und die fünfte Übertragungsfunktion $"H_5(s)"$ für die Ermittlung der Übertragungsfunktionen der Filtersysteme und der Filtersignale sowie für die asymmetrische und kompensatorische Erzeugung des Kombinationssignals, bei dem vorzugsweise das zweite Ausgangssignal, das zweite Filtersignal, das erste Filtersignal und ein Kompensation-Filtersignal additiv und/oder subtraktiv mit der Maßgabe $"H_3^k(s) \times H_1^m(s) + H_4^k(s) \times H_2^p(s) = 1"$ verknüpft werden, auf einem Standard-Tiefpass 1. Ordnung $"H_{TP}^1(s_n)"$, 2. Ordnung $"H_{TP}^2(s_n)"$ oder 3. Ordnung $"H_{TP}^3(s_n)"$ basieren.

Darüber hinaus ist es alternativ - gemäß der Weiterbildung der Erfindung in den Ansprüchen 7 und 15 - auch möglich, dass die dritte Übertragungsfunktion k-ter Ordnung $"H_3^k(s)"$ des ersten Filtersystems, die vierte Übertragungsfunktion k-ter Ordnung $"H_4^k(s)"$ des zweiten Filtersystems, das gemäß dieser Weiterbildung aus dem weiteren ersten Filtersystem mit der dritten Übertragungsfunktion k-ter Ordnung $"H_3^k(s)"$ und dem Kompensation-Filtersystem mit der fünften Übertragungsfunktion $"H_5(s)"$ gebildet wird, und die fünfte Übertragungsfunktion $"H_5(s)"$ für die Ermittlung der Übertragungsfunktionen der Filtersysteme und der Filtersignale sowie für die symmetrische und kompensatorische Erzeugung des Kombinationssignals, bei dem vorzugsweise das zweite Ausgangssignal, das zweite Filtersignal, das erste Filtersignal und ein Kompensation-Filtersignal additiv und/oder subtraktiv mit der Maßgabe

$$"H_3^k(s) \times H_1^m(s) + H_4^k(s) \times H_2^p(s) = 1"$$ verknüpft werden, auf einem Symmetrie-Tiefpass 1. Ordnung $"H_{STP}^1(s_n)"$, 3. Ordnung $"H_{STP}^3(s_n)"$ oder 5. Ordnung $"H_{STP}^5(s_n)"$ basieren.

Abschließend - gemäß einer Weiterbildung der Erfindung in den Ansprüchen 8 und 16 - ist es vorteilhaft, zweckmäßig und hilfreich, wenn

- das erste elektrische System bzw. der "Direct Current <DC>"-Sensor zur Messung eines Stroms als Messgröße und dem Eingangssignal mit einer oberen Grenzfrequenz $f_{o,Gr}$= 200kHz, dies entspricht einem Wert der Grenzkreisfrequenz $\omega_{SY1}$ von "2π x 200kHz", z.B. ein Fluxgate-Wandler in Closed Loop-Ausführung oder einen Hall Effect Sensor in Open Loop/Closed Loop-Ausführung oder ein Pearson-Wandler mit "wide-band current transformer"-Charakteristik ist und
- das zweite elektrische System bzw. der "Alternate Current <AC>"-Sensor zur Messung des Stroms als Messgröße und dem Eingangssignal mit einer unteren Grenzfrequenz $f_{u,Gr}$= 20Hz, dies entspricht einem Wert der Grenzkreisfrequenz $\omega_{SY2}$ von "2π x 20Hz", z.B. ein PEM-Wandler als Rogowski-Spule mit Integrierer oder ein Stromwandler mit Sekundär-Shunt ist.

Weitere Vorteile der Erfindung ergeben sich aus der nachfolgenden Beschreibung eines Ausführungsbeispiels der Erfindung anhand einer FIGUR erläutert, die eine Messanordnung MAO zur Erfassung einer physikalischen Messgröße MG, z.B. einen Strom ST in einem stromdurchflossenen Leiter, zeigt.

Die physikalische Messgröße MG also der Strom ST in dem stromdurchflossenen Leiter wird mit der Messanordnung MAO nicht unmittelbar, durch Messung des Stroms in dem Leiter, sondern mittelbar und berührungslos mittels zweier Mess-/Feldsonden erfasst (vgl. Dissertation von B. Hudoffsky "Berührungslose Messung schnell veränderlicher Ströme"; Uni Stuttgart 2014 <Druckfreigabe 140806>), die jeweils ein zu dem zu messenden Strom korrespondierendes Erfassungssignal erzeugen. Dieses Erfassungssignal bildet nun den Ausgangspunkt für die weitere Vorgehensweise für die Erfassung des Stroms ST mit der Messanordnung MAO.

Die beiden Mess-/Feldsonden sind beispielsweise zum einen ein "Direct Current <DC>"-Sensor (DC-Sensor) zur Messung (Erfassung) des Stroms ST mit dem Erfassungssignal und einer oberen Grenzfrequenz $f_{o,Gr}$= 200kHz und zum anderen ein "Alternate Current <AC>"-Sensor (AC-Sensor) zur Messung (Erfassung) des Stroms ST mit dem Erfassungssignal und einer unteren Grenzfrequenz $f_{u,Gr}$= 20Hz. Während der DC-Sensor z.B. ein Fluxgate-Wandler in Closed Loop-Ausführung FGW (vgl. https://www.elektroniknet.de/messen-testen/closed-loop-wandler-richtig-einsetzen.107453.html) oder einen Hall Effect Sensor in Open Loop/Closed Loop-Ausführung (vgl. https://www.elektroniknet.de/messen-testen/sensorik/hall-sensor-fuer-strommessungen-bis-120-a.167851.html) oder ein Pearson-Wandler mit "wide-band current transformer"-Charakteristik PW (vgl. https://www.pearsonelectronics.com) sein kann, ist der AC-Sensor vorzugs- und beispielsweise ein PEM-Wandler als Rogowski-Spule mit Integrierer PEM-W (vgl. http://www.pemuk.com/products/cwt-current-probe/cwt.aspx) oder ein Stromwandler mit Sekundär-Shunt STW (vgl. https://www.ni.com/de-de/innovations/white-papers/08/how-to-measure-voltage--current--and-power.html)

Werden die beiden Mess-/Feldsonden, also der DC_Sensor und der AC-Sensor, auf der Basis der eingangs skizzierten Systemtheorie, sprich systemtheoretisch, betrachtet, so können z.B. der DC-Sensor als ein erstes elektrisches System SY1 mit einer ersten Grenzkreisfrequenz $\omega_{SY1}$, die das 2π-fache der oberen Grenzfrequenz $f_{o,Gr}$= 200kHz des DC-Sensors ist, und einer ersten Übertragungsfunktion m-ter Ordnung $"H_1^m(s)"$ ÜF1 sowie der AC-Sensor als ein zweites elektrisches System SY2 mit einer zweiten Grenzkreisfrequenz $\omega_{SY2}$, die das 2π-fache der unteren Grenzfrequenz $f_{u,Gr}$= 20Hz des AC-Sensors ist, und einer zweiten Übertragungsfunktion p-ter Ordnung $"H_2^p(s)"$ ÜF2 aufgefasst werden, bei denen die Anregung in Form des Erfassungssignals erfolgt und jeweils ein Eingangssignal ESI ist und die Reaktion jeweils ein Ausgangssignal ist, so im Fall des ersten elektrischen Systems SY1 mit der ersten Übertragungsfunktion m-ter Ordnung $"H_1^m(s)"$ ÜF1 ein erstes Ausgangsignal ASI1 mit einem ersten Frequenzbereich FB1 und im Fall des zweiten elektrischen Systems SY2 mit der zweiten Übertragungsfunktion p-ter Ordnung $"H_2^p(s)"$ ÜF2 ein weites Ausgangsignal ASI2 mit einem zweiten Frequenzbereich FB2.

Diese beiden Ausgangssignale ASI1, ASI2 bilden im Rahmen der Messanordnung MAO die Eingangsgrößen für eine Elektronische Schaltungsanordnung ESA, mit der die Ausgangssignale ASI1, ASI2 der elektrischen Systeme SY1, SY2 mit den verschiedenen Signal-Frequenzbereichen FB1, FB2 zur Rekonstruktion des Eingangssignals ESI gefiltert flt und kombiniert kbn werden.

Zu diesem Zweck enthält die Elektronische Schaltungsanordnung ESA eine Filterschaltung FS zur Erzeugung von Filtersignalen FSI1, FSI2, FSI$_K$ und eine Kombinationsschaltung KS zur Erzeugung eines Kombinationssignals KSI als Ausgangsgröße der Elektronischen Schaltungsanordnung ESA, die schaltungstechnisch derart verbunden und zusammenwirken, dass aus dem zweiten Ausgangssignal ASI2 und den erzeugten Filtersignalen FSI1, FSI2, FSI$_K$, die der Kombinationsschaltung KS durch die Filterschaltung FS zugeführt werden, in der der Kombinationsschaltung KS durch additive und/oder subtraktive Verknüpfung das Kombinationssignal KSI erzeugt wird.

Die Filterschaltung FS enthält für die Erzeugung der Filtersignale FSI1, FSI2, FSI$_K$

- ein erstes Filtersystem FSY1 mit einer dritten Übertragungsfunktion k-ter Ordnung $"H_3^k(s)"$ ÜF3 durch die ein im Verhältnis zu dem ersten Ausgangssignal ASI1 bestimmbares, erstes Filtersignal FSI1 mit einer Filter-Grenzkreisfrequenz $\omega_0$ generiert wird, und

- ein zweites Filtersystem FSY2 mit einer vierten Übertragungsfunktion k-ter Ordnung $"H_4^k(s)"$ ÜF4, das

  (**a**) das zweite Ausgangssignal ASI2 bereitstellt,

  (**b**) ein weiteres erstes Filtersystem FSY1' mit der dritten Übertragungsfunktion k-ter Ordnung $"H_3^k(s)"$ ÜF3 aufweist, durch die ein im Verhältnis zu dem zweiten Ausgangssignal ASI2 bestimmbares, zweites Filtersignal FSI2 mit einer Filter-Grenzkreisfrequenz $\omega_0$ generiert wird, und

  (**c**) ein Kompensation-Filtersystem FSY$_K$ mit einer fünften Übertragungsfunktion $"H_5(s)"$ ÜF5 aufweist, durch die ein im Verhältnis zu dem zweiten Ausgangssignal ASI2 bestimmbares Kompensation-Filtersignal FSI$_K$ generiert wird.

Die Kombinationsschaltung KS ist für die Erzeugung des Kombinationssignals KSI durch entsprechende Kombination der zu geführten Signale ASI2, FSI1, FSI2, FSI$_K$ derart ausgebildet, z.B. mit Addierer und Subtrahierer, dass

im Zuge der Signalkombination in Bezug auf die dritte Übertragungsfunktion k-ter Ordnung $"H_3^k(s)"$ ÜF3) des ersten Filtersystems FSY1 und die vierte Übertragungsfunktion k-ter Ordnung $"H_4^k(s)"$ ÜF4 des zweiten Filtersystems FSY2

  (**1**) das zweite Ausgangssignal ASI2, das zweite Filtersignal FSI2 und das erste Filtersignal FSI1 für eine asymmetrische oder symmetrische Erzeugung des Kombinationssignals KSI additiv und/oder subtraktiv, mit Maßgabe von

$$"H_3^k(s) \; + \; H_4^k(s)) \; = \; 1"$$ verknüpft werden <u>oder</u>

  (**2**) das zweite Ausgangssignal ASI2, das zweite Filtersignal FSI2, das Kompensation-Filtersignal FSI$_K$ und das erste Filtersignal FSI1 für eine asymmetrische und kompensatorische oder symmetrische und kompensatorische Erzeugung des Kombinationssignals KS additiv und/oder subtraktiv, mit Maßgabe von

$$"H_3^k(s) \; \times \; H_1^m(s) \; + \; H_4^k(s) \; \times \; H_2^p(s) \; = \; 1"$$ verknüpft werden.

Die Maßgabe-Beziehung in (**1**) und (**2**) soll dabei angeben, dass bei der Erfassung der physikalischen Messgröße eine fehlerminimale oder fehleroptimale Kombination der Ausgangssignale erzielt und das Eingangssignal ESI durch das Kombinationssignal KSI im Wesentlichen eins-zu-eins rekonstruiert werden kann.

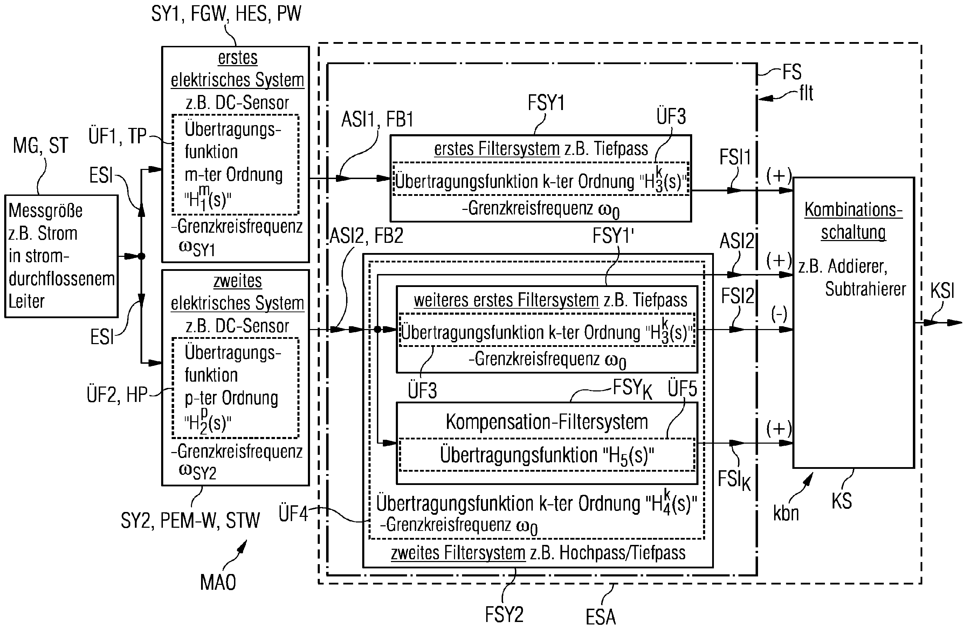

Für die in der FIGUR dargestellte Elektronische Schaltungsanordnung ESA kann durch Simulation gezeigt werden, dass für die Filter-Grenzkreisfrequenz $\omega_0$ jedes Filtersystems k-ter Ordnung FSY1, FSY1' FSY2 in Bezug auf die erste Übertragungsfunktion m-ter Ordnung $"H_1^m(s)"$ ÜF1 mit der ersten Grenzkreisfrequenz $\omega_{SY1}$ des ersten

elektrischen Systems SY1 und in Bezug auf die zweite Übertragungsfunktion p-ter Ordnung $"H_2^p(s)"$ ÜF2 mit der zweiten Grenzkreisfrequenz $\omega_{SY2}$ des ersten elektrischen Systems SY2 und unter der Voraussetzung, dass die m-te Ordnung gleich der p-ten Ordnung, also m=p, ist, folgender funktionaler Zusammenhang zu den Grenzkreisfrequenzen $\omega_{SY1}$, $\omega_{SY2}$ besteht:

$$\omega_0 = \sqrt{\omega_{SY1} \times \omega_{SY2}} \; .$$

Die Funktionsweise der Elektronischen Schaltungsanordnung ESA mit den Filtersystemen FSY1, FSY1', FSY2 der Filterschaltung FS und der Kombinationsschaltung KS im Zusammenhang mit der Kombination der Ausgangssignale ASI1, ASI2 der elektrischen Systeme SY1, SY2 mit den verschiedenen Signal-Frequenzbereichen FB1, FB2 kann z.B. in vorteilhaften <u>Simulationsszenarien</u> simuliert und beschrieben werden, wenn - auf der Basis eines Standard-Tiefpasses mit einer Verstärkung von "1" und einer Standard-Tiefpass-Übertragungsfunktion j-ter Ordnung mit Koeffizienten abhängig von einer Tiefpass-Filterapproximation, z.B. Butterworth oder Bessel,

$$ "H_{TP}^{j}(s_n) = \frac{1}{1 + a_1 s_n + a_2 s_n^2 + \ldots + a_j s_n^j} " $$

mit $s_n = s/\omega_0$; was bedeutet, dass die Standard-Tiefpass-Übertragungsfunktion j-ter Ordnung $"H_{TP}^{j}(s_n)"$ auf die Filter-Grenzkreisfrequenz $\omega_0$ normiert ist -

**a.** das erste elektrische System SY1 mit der ersten Übertragungsfunktion m-ter Ordnung $"H_1^m(s)"$ ÜF1 ein Tiefpass TP gemäß dem Standard-Tiefpass mit einer Tiefpass-Übertragungsfunktion 1. Ordnung $"H_{TP}^1(s_n)"$ und einer Filterapproximationsunabhängigkeit und die erste Übertragungsfunktion m-ter Ordnung $"H_1^m(s)"$ ÜF1 eine Übertragungsfunktion 1. Ordnung $"H_1^1(s_n)"$ mit der Filterapproximationsunabhängigkeit sind:

$$ H_1^1(s_n) = \frac{1}{1 + s_n/\omega_{SY1,n}} = \frac{1}{1 + s_n \cdot \omega_{SY2,n}} $$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, und

**b.** das zweite elektrische System SY2 mit der zweiten Übertragungsfunktion p-ter Ordnung $"H_2^p(s)"$ ÜF2 des zweiten elektrischen Systems (SY2) ein Hochpass HP gemäß dem Standard-Tiefpass mit der Tiefpass-Übertragungsfunktion 1. Ordnung $"H_{TP}^1(s_n)"$ und der Filterapproximationsunabhängigkeit sowie die zweite Übertragungsfunktion p-ter Ordnung $"H_2^p(s)"$ eine Übertragungsfunktion 1. Ordnung $"H_2^1(s_n)"$ mit der Filterapproximationsunabhängigkeit ist:

$$ H_2^1(s_n) = \frac{s_n/\omega_{SY2,n}}{1 + s_n/\omega_{SY2,n}} $$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$.

In einem ersten Simulationsszenario (<u>Asymmetrie-Fall</u>) werden die dritte Übertragungsfunktion k-ter Ordnung $"H_3^k(s)"$ ÜF3 des ersten Filtersystems FSY1 und die vierte Übertragungsfunktion k-ter Ordnung $"H_4^k(s)"$ ÜF4 des zweiten Filtersystems FSY2 auf der Basis des Standard-Tiefpass mit der Verstärkung von "1" und

**A1.** der Standard-Tiefpass-Übertragungsfunktion 1. Ordnung $"H_{TP}^1(s_n)"$ oder

**B1.** einer Standard-Tiefpass-Übertragungsfunktion 2. Ordnung $"H_{TP}^2(s_n)"$ oder

**C1.** einer Standard-Tiefpass-Übertragungsfunktion 3. Ordnung $"H_{TP}^3(s_n)"$ für die <u>asymmetrische Erzeugung</u> des Kombinationssignals KSI, bei dem vorzugsweise das zweite Ausgangssignal ASI2, das zweite Filtersignal FSI2 und das erste Filtersignal FSI1 additiv und/oder subtraktiv mit der Maßgabe $"H_3^k(s) + H_4^k(s) = 1"$ verknüpft werden, ermittelt.

Im Fall **A1.** des ersten Simulationsszenarios sind

die dritte Übertragungsfunktion k-ter Ordnung $"\mathbf{H}_3^k(s)"$ ÜF3 des ersten Filtersystems FSY1, FSY1',

- wenn dieses auf dem Standard-Tiefpass mit der Standard-Tiefpass-Übertragungsfunktion 1. Ordnung $"\mathbf{H}_{TP}^1(s_n)"$

und der Filterapproximationsunabhängigkeit basiert, eine erste Übertragungsfunktion 1. Ordnung $"\mathbf{H}_{3,1}^1(s_n)"$ mit der Filterapproximationsunabhängigkeit:

$$\mathbf{H}_{3,1}^1(s_n) = \mathbf{H}_{TP}^1(s_n) = \frac{1}{1 + s_n}$$

mit $s_n = s/\omega_0$, und

die vierte Übertragungsfunktion k-ter Ordnung $"\mathbf{H}_4^k(s)"$ ÜF4 des zweiten Filtersystems FSY2,
- das aus dem in dem zweiten Filtersystem FSY2 eins-zu-eins übertragenen, zweiten Ausgangssignal ASI2 mit einer Übertragungsfunktion "1" und aus dem ersten Filtersystem FSY1, FSY1' mit der dritten Übertragungsfunktion k-ter Ordnung $"\mathbf{H}_3^k(s)"$ ÜF3 gebildet wird,

- wobei die Übertragungsfunktion "1" und die dritte Übertragungsfunktion k-ter Ordnung $"\mathbf{H}_3^k(s)"$ subtraktiv nach der Maßgabe $"1 - \mathbf{H}_3^k(s)"$ verknüpft werden, und

- wenn das erste Filtersystem FSY1, FSY1' mit der dritten Übertragungsfunktion k-ter Ordnung $"\mathbf{H}_3^k(s)"$ auf dem Standard-Tiefpass mit der Standard-Tiefpass-Übertragungsfunktion 1. Ordnung $"\mathbf{H}_{TP}^1(s_n)"$ und der Filterapproximationsunabhängigkeit basiert,

eine erste Übertragungsfunktion 1. Ordnung $"\mathbf{H}_{4,1}^1(s_n)"$ mit der Filterapproximationsunabhängigkeit:

$$\mathbf{H}_{4,1}^1(s_n) = 1 - \mathbf{H}_3^k(s_n) = 1 - \mathbf{H}_{TP}^1(s_n) = \frac{s_n}{1 + s_n}$$

mit $s_n = s/\omega_0$.

Nachfolgende **Abbildungen A1-SR1, A1-SR2, A1-SR3** zeigen für den Fall **A1.** des ersten Simulationsszenarios mögliche Schaltungsrealisierungen für die Elektronische Schaltungsanordnung ESA mit den Filtersystemen FSY1, FSY1', FSY2 der Filterschaltung FS und der Kombinationsschaltung KS im Zusammenhang mit der Kombination der Ausgangssignale ASI1, ASI2 der elektrischen Systeme SY1, SY2 mit den verschiedenen Signal-Frequenzbereichen FB1, FB2 zur Erzeugung des Kombinationssignales KSI.

**KS**

**FSY2**

**FSY1'**

C2

C

R4

R

U2

R3

R

ASI2

R9

R

R5

R

R7

R

R8

R

U3

KSI

**FSY1**

R1

R

ASI1

C1

C

U1

Abbildung A1-SR1

**KS**

**FSY2**

**FSY1'**

R2

R

ASI2

C2

C

U4

R3

R

R4

R

U2

R9

R

R5

R

R7

R

R8

R

U3

KSI

**FSY1**

R1

R

ASI1

C1

C

U1

Abbildung A1-SR2

KS

FSY2

FSY1'

Abbildung A1-SR3

In den **Abbildungen A1-SR1, A1-SR2, A1-SR3** sind der R-Widerstandswert der einzelnen Widerstände R1, R2, R3, usw. und der C-Kapazitätswert der Kapazitäten C1, C2, C3, usw. in Bezug auf die Ausgangssignale ASI, ASI2 und der anderen Schaltungselemente für eine funktionsfähige, zweckorientierte Schaltung auszulegen und entsprechend zu dimensionieren.

Im Fall **B1.** des ersten Simulationsszenarios sind

die dritte Übertragungsfunktion k-ter Ordnung $"H_3^k(s)"$ ÜF3 des ersten Filtersystems FSY1, FSY1',

- wenn dieses auf dem Standard-Tiefpass mit der Standard-Tiefpass-Übertragungsfunktion 2. Ordnung $"H_{TP}^2(s_n)"$ und einer Butterworth-Filterapproximation basiert,

eine erste Übertragungsfunktion 2. Ordnung $"H_{3,1}^2(s_n)"$ mit der Butterworth-Filterapproximation:

$$H_{3,1}^2(s_n) = H_{TP}^2(s_n) = \frac{1}{1 + a_1 s_n + a_2 s_n^2} = \frac{1}{1 + \sqrt{2} s_n + s_n^2}$$

mit $s_n = s/\omega_0$, und

die vierte Übertragungsfunktion k-ter Ordnung $"H_4^k(s)"$ ÜF4 des zweiten Filtersystems FSY2,
- das aus dem in dem zweiten Filtersystem FSY2 eins-zu-eins übertragenen, zweiten Ausgangssignal ASI2 mit einer Übertragungsfunktion "1" und aus dem ersten Filtersystem FSY1, FSY1' mit der dritten Übertragungsfunktion k-ter Ordnung $"H_3^k(s)"$ ÜF3 gebildet wird,

- wobei die Übertragungsfunktion "1" und die dritte Übertragungsfunktion k-ter Ordnung $"H_3^k(s)"$ subtraktiv nach

der Maßgabe $"1-\mathbf{H}_3^k(s)"$ verknüpft werden, und

- wenn das erste Filtersystem (FSY1, FSY1') mit der dritten Übertragungsfunktion k-ter Ordnung $"\mathbf{H}_3^k(s)"$ auf dem Standard-Tiefpass mit der Standard-Tiefpass-Übertragungsfunktion 2. Ordnung $"\mathbf{H}_{TP}^2(s_n)"$ und der der Butterworth-Filterapproximation basiert,

eine erste Übertragungsfunktion 2. Ordnung $"\mathbf{H}_{4,1}^2(s_n)"$ mit der Butterworth-Filterapproximation:

$$\mathbf{H}_{4,1}^2(s_n) = 1 - \mathbf{H}_3^k(s_n) = 1 - \mathbf{H}_{TP}^2(s_n) = \frac{\sqrt{2}s_n + s_n^2}{1 + \sqrt{2}s_n + s_n^2}$$

mit $s_n = s/\omega_0$.

Im Fall **C1.** des ersten Simulationsszenarios sind die dritte Übertragungsfunktion k-ter Ordnung $"\mathbf{H}_3^k(s)"$ ÜF3 des ersten Filtersystems FSY1, FSY1',

- wenn dieses auf dem Standard-Tiefpass mit der Standard-Tiefpass-Übertragungsfunktion 3. Ordnung $"\mathbf{H}_{TP}^3(s_n)"$ und der Butterworth-Filterapproximation basiert,

eine erste Übertragungsfunktion 3. Ordnung $"\mathbf{H}_{3,1}^3(s_n)"$ mit der Butterworth-Filterapproximation:

$$\mathbf{H}_{3,1}^3(s_n) = \frac{1}{1 + a_1 s_n + a_2 s_n^2 + a_3 s_n^3} = \frac{1}{1 + 2s_n + 2s_n^2 + s_n^3}$$

mit $s_n = s/\omega_0$, und

die vierte Übertragungsfunktion k-ter Ordnung $"\mathbf{H}_4^k(s)"$ ÜF4 des zweiten Filtersystems FSY2,
- das aus dem in dem zweiten Filtersystem FSY2 eins-zu-eins übertragenen, zweiten Ausgangssignal ASI2 mit einer Übertragungsfunktion "1" und aus dem ersten Filtersystem FSY1, FSY1' mit der dritten Übertragungsfunktion k-ter Ordnung $"\mathbf{H}_3^k(s)"$ ÜF3 gebildet wird,

- wobei die Übertragungsfunktion "1" und die dritte Übertragungsfunktion k-ter Ordnung $"\mathbf{H}_3^k(s)"$ subtraktiv nach der Maßgabe $"1-\mathbf{H}_3^k(s)"$ verknüpft werden, und

- wenn das erste Filtersystem FSY1, FSY1' mit der dritten Übertragungsfunktion k-ter Ordnung $"\mathbf{H}_3^k(s)"$ auf dem Standard-Tiefpass mit der Standard-Tiefpass-Übertragungsfunktion 3. Ordnung $"\mathbf{H}_{TP}^3(s_n)"$ und der der Butterworth-Filterapproximation basiert,

eine erste Übertragungsfunktion 3. Ordnung $"\mathbf{H}_{4,1}^3(s_n)"$ mit der Butterworth-Filterapproximation ist:

$$\mathbf{H}_{4,1}^3(s_n) = 1 - \mathbf{H}_3^k(s_n) = 1 - \mathbf{H}_{TP}^3(s_n) = \frac{2s_n + 2s_n^2 + s_n^3}{1 + 2s_n + 2s_n^2 + s_n^3}$$

mit $s_n = s/\omega_0$.

Nachfolgende **Abbildungen C1-SR1, C1-SR2** zeigen für den Fall **C1.** des ersten Simulationsszenarios mögliche Schaltungsrealisierungen für die Elektronische Schaltungsanordnung ESA mit den Filtersystemen FSY1, FSY1', FSY2 der Filterschaltung FS und der Kombinationsschaltung KS im Zusammenhang mit der Kombination der Ausgangssignale ASI1, ASI2 der elektrischen Systeme SY1, SY2 mit den verschiedenen Signal-Frequenzbereichen FB1, FB2 zur Erzeugung des Kombinationssignales KSI.

Abbildung C1-SR1

## Abbildung C1-SR2

In den **Abbildungen C1-SR1, C1-SR2** sind die R-/R'-/R"-/R"'-Widerstandswerte der einzelnen Widerstände R1, R2, R3, usw. und die C-Kapazitätswerte der Kapazitäten C1, C2, C3, usw. in Bezug auf die Ausgangssignale ASI, ASI2 und der anderen Schaltungselemente für eine funktionsfähige, zweckorientierte Schaltung auszulegen und entsprechend zu dimensionieren.

Eine nachfolgende **Abbildung C1-GR** zeigt für den Fall **C1.** des ersten Simulationsszenarios mit den möglichen Schaltungsrealisierungen gemäß den Abbildungen C1-SR1, C1-SR2 für die Elektronische Schaltungsanordnung ESA mit den Filtersystemen FSY1, FSY1', FSY2 der Filterschaltung FS und der Kombinationsschaltung KS eine Graphen-Darstellung mit $\omega_n = \omega_{SY1,n} = \omega_{SY1}/\omega_0$, $\omega_n = \omega_{SY2,n} = \omega_{SY2}/\omega_0$ und $\omega_{SY1}/\omega_{SY2} = 100$

- der erste Übertragungsfunktion 3. Ordnung $"\mathbf{H}_{3,1}^{3}(s_n)"$ als die auf der Standard-Tiefpass-Übertragungsfunktion 3. Ordnung $"\mathbf{H}_{TP}^{3}(s_n)"$ basierende dritte Übertragungsfunktion k-ter Ordnung $"\mathbf{H}_{3}^{k}(s)"$ ÜF3 des ersten Filtersystems FSY1, FSY1',

- der erste Übertragungsfunktion 3. Ordnung $"\mathbf{H}_{4,1}^{3}(s_n)"$ als die auf der Standard-Tiefpass-Übertragungsfunktion 3. Ordnung $"\mathbf{H}_{TP}^{3}(s_n)"$ basierende vierte Übertragungsfunktion k-ter Ordnung $"\mathbf{H}_{4}^{k}(s)"$ ÜF4 des zweiten Filtersystems FSY2 und

- des Verlaufs des Kombinationssignals KSI.

**Asymmetrische Erzeugung von KSI**

Abbildung C1-GR

In einem zweiten Simulationsszenario (Symmetrie-Fall) werden die dritte Übertragungsfunktion k-ter Ordnung $"H_3^k(s)"$ ÜF3 des ersten Filtersystems FSY1 und die vierte Übertragungsfunktion k-ter Ordnung $"H_4^k(s)"$ ÜF4 des zweiten Filtersystems FSY2 auf der Basis auf eines Symmetrie-Tiefpass mit einer Verstärkung von "1" und

   **A2.** einer Symmetrie-Tiefpass-Übertragungsfunktion 1. Ordnung $"H_{STP}^1(s_n)"$ oder

   **B2.** einer Symmetrie-Tiefpass-Übertragungsfunktion 3. Ordnung $"H_{STP}^3(s_n)"$ oder

   **C2.** einer Symmetrie-Tiefpass-Übertragungsfunktion 5. Ordnung $"H_{STP}^5(s_n)"$ für die symmetrische Erzeugung des Kombinationssignals KSI, bei dem vorzugsweise das zweite Ausgangssignal ASI2, das zweite Filtersignal FSI2 und das erste Filtersignal FSI1 additiv und/oder subtraktiv mit der Maßgabe $"H_3^k(s) + H_4^k(s) = 1"$ verknüpft werden, ermittelt.

Im Fall **A2.** des zweiten Simulationsszenarios sind die dritte Übertragungsfunktion k-ter Ordnung $"H_3^k(s)"$ ÜF3 des ersten Filtersystems FSY1, FSY1',

- wenn dieses auf dem Symmetrie-Tiefpass mit der Verstärkung von "1" und der Symmetrie-Tiefpass-Übertragungsfunktion 1. Ordnung $"H_{STP}^1(s_n)"$ mit $H_{STP}^1(s_n) = \frac{1}{1+s_n}$ und einer Filterapproximationsunabhängigkeit basiert,

eine zweite Übertragungsfunktion 1. Ordnung $"H_{3,2}^1(s_n)"$ mit der Filterapproximationsunabhängigkeit:

$$H_{3,2}^1(s_n) = \frac{1}{1 + s_n}$$

mit $s_n = s/\omega_0$, und

die vierte Übertragungsfunktion k-ter Ordnung $"H_4^k(s)"$ ÜF4 des zweiten Filtersystems FSY2,
- das aus dem in dem zweiten Filtersystem FSY2 eins-zu-eins übertragenen, zweiten Ausgangssignal (ASI2) mit einer Übertragungsfunktion "1" und aus dem ersten Filtersystem FSY1, FSY1' mit der dritten Übertragungsfunktion k-ter Ordnung $"H_3^k(s_n)"$ ÜF3 oder aus dem ersten Filtersystem FSY1, FSY1' mit der dritten Übertragungsfunktion k-ter Ordnung $"H_3^k\left(s_n \to \frac{1}{s_n}\right)"$ ÜF3 gebildet wird,

- wobei die Übertragungsfunktion "1" und die dritte Übertragungsfunktion k-ter Ordnung $"H_3^k(s)"$ subtraktiv nach der Maßgabe $"1 - H_3^k(s)"$ verknüpft werden, und

- wenn das erste Filtersystem FSY1, FSY1' mit der dritten Übertragungsfunktion k-ter Ordnung $"H_3^k(s)"$ auf dem Symmetrie-Tiefpass mit der Symmetrie-Tiefpass-Übertragungsfunktion 1. Ordnung $"H_{STP}^1(s_n)"$ mit $H_{STP}^1(s_n) = \frac{1}{1+s_n}$ und der Filterapproximationsunabhängigkeit basiert,

eine zweite Übertragungsfunktion 1. Ordnung $"H_{4,2}^1(s_n)"$ mit der Filterapproximationsunabhängigkeit:

$$H_{4,2}^1(s_n) = 1 - H_3^k(s_n) = H_3^k\left(s_n \to \frac{1}{s_n}\right) = 1 - H_{STP}^1(s_n) = \frac{1}{1 + s_n}$$

mit $s_n = s/\omega_0$.

Im Fall **B2.** des zweiten Simulationsszenarios sind die dritte Übertragungsfunktion k-ter Ordnung $"H_3^k(s)"$ ÜF3 des ersten Filtersystems FSY1, FSY1',

- wenn dieses auf dem Symmetrie-Tiefpass mit der Verstärkung von "1" und der Symmetrie-Tiefpass-Übertragungsfunktion 3. Ordnung $"H_{STP}^3(s_n)"$ mit $H_{STP}^3(s_n) = \frac{1+as_n}{1+as_n+as_n^2+s_n^3}$ und einem Koeffizienten "a=3" als dreifache Polstelle basiert,

eine zweite Übertragungsfunktion 3. Ordnung $"H_{3,2}^3(s_n)"$ mit dem Koeffizienten "a=3" als dreifache Polstelle:

$$H_{3,2}^3(s_n) = \frac{1 + as_n}{1 + as_n + as_n^2 + s_n^3}$$

mit $s_n = s/\omega_0$, und

die vierte Übertragungsfunktion k-ter Ordnung $"H_4^k(s)"$ ÜF4 des zweiten Filtersystems FSY2,

- das aus dem in dem zweiten Filtersystem FSY2 eins-zu-eins übertragenen, zweiten Ausgangssignal (ASI2) mit einer Übertragungsfunktion "1" und aus dem ersten Filtersystem FSY1, FSY1' mit der dritten Übertragungsfunktion k-ter Ordnung $"H_3^k(s_n)"$ ÜF3 oder aus dem ersten Filtersystem FSY1, FSY1' mit einer dritten Übertragungsfunktion k-ter Ordnung $"H_3^k\left(s_n \to \frac{1}{s_n}\right)"$ ÜF3 gebildet wird,

- wobei die Übertragungsfunktion "1" und die dritte Übertragungsfunktion k-ter Ordnung $"H_3^k(s)"$ subtraktiv nach der Maßgabe $"1 - H_3^k(s)"$ verknüpft werden, und

- wenn das erste Filtersystem FSY1, FSY1' mit der dritten Übertragungsfunktion k-ter Ordnung $"H_3^k(s)"$ auf dem Symmetrie-Tiefpass mit einer Symmetrie-Tiefpass-Übertragungsfunktion 3. Ordnung $"H_{STP}^3(s_n)"$ mit $H_{STP}^3(s_n) = \frac{1 + as_n}{1 + as_n + as_n^2 + s_n^3}$ und dem Koeffizienten "a=3" als dreifache Polstelle basiert, eine zweite Übertragungsfunktion 3. Ordnung $"H_4^3(s_n)"$ mit dem Koeffizienten "a=3" als dreifache Polstelle:

$$H_{4,2}^3(s_n) = 1 - H_3^k(s_n) = H_3^k\left(s_n \to \frac{1}{s_n}\right) = 1 - H_{STP}^3(s_n) = \frac{as_n^2 + s_n^3}{1 + as_n + as_n^2 + s_n^3}$$

mit $s_n = s/\omega_0$.

Eine nachfolgende **Abbildung B2-SR** zeigt für den Fall **B2.** des zweiten Simulationsszenarios eine mögliche Schaltungsrealisierung für die Elektronische Schaltungsanordnung ESA mit den Filtersystemen FSY1, FSY1', FSY2 der Filterschaltung FS und der Kombinationsschaltung KS im Zusammenhang mit der Kombination der Ausgangssignale ASI1, ASI2 der elektrischen Systeme SY1, SY2 mit den verschiedenen Signal-Frequenzbereichen FB1, FB2 zur Erzeugung des Kombinationssignales KSI.

## Abbildung B2-SR

In der **Abbildung B2-SR** sind die R-/R'-Widerstandswerte der einzelnen Widerstände R1, R2, R3, usw. und die C-Kapazitätswerte der Kapazitäten C1, C2, C3, usw. in Bezug auf die Ausgangssignale ASI, ASI2 und der anderen Schaltungselemente für eine funktionsfähige, zweckorientierte Schaltung auszulegen und entsprechend zu dimensionieren.

Eine nachfolgende **Abbildung B2-GR** zeigt für den Fall **B2.** des zweiten Simulationsszenarios mit der möglichen Schaltungsrealisierung gemäß der Abbildung B2-SR für die Elektronische Schaltungsanordnung ESA mit den Filtersystemen FSY1, FSY1', FSY2 der Filterschaltung FS und der Kombinationsschaltung KS eine Graphen-Darstellung mit $\omega_n=\omega_{SY1,n}=\omega_{SY1}/\omega_0$, $\omega_n=\omega_{SY2,n}=\omega_{SY2}/\omega_0$ und $\omega_{SY1}/\omega_{SY2}=100$

- der zweiten Übertragungsfunktion 3. Ordnung $"H_{3,2}^3(s_n)"$ als die auf der Symmetrie-Tiefpass-Übertragungsfunktion 3. Ordnung $"H_{STP}^3(s_n)"$ basierende dritte Übertragungsfunktion k-ter Ordnung $"H_3^k(s)"$ ÜF3 des ersten Filtersystems FSY1, FSY1',

- der zweiten Übertragungsfunktion 3. Ordnung $"H_{4,2}^3(s_n)"$ als die auf der Symmetrie-Tiefpass-Übertragungsfunktion 3. Ordnung $"H_{STP}^3(s_n)"$ basierende vierte Übertragungsfunktion k-ter Ordnung $"H_4^k(s)"$ ÜF4 des zweiten Filtersystems FSY2 und

- des Verlaufs des Kombinationssignals KSI.

## 2. Symmetrische Erzeugung von KSI

Abbildung B2-GR

Im Fall **C2.** des zweiten Simulationsszenarios sind die dritte Übertragungsfunktion k-ter Ordnung $"\mathbf{H}_3^k(s)"$ ÜF3 des ersten Filtersystems FSY1, FSY1',

- wenn dieses auf dem Symmetrie-Tiefpass mit der Verstärkung von "1" und der Symmetrie-Tiefpass-Übertragungs-funktion 5. Ordnung $"\mathbf{H}_{STP}^5(s_n)"$ mit $\mathbf{H}_{STP}^5(s_n) = \dfrac{1 + a_1 s_n + a_2 s_n^2}{1 + a_1 s_n + a_2 s_n^2 + a_2 s_n^3 + a_1 s_n^4 + s_n^5}$ und Koeffizienten "$a_1 = 15,19$" und $"a_2 = \dfrac{a_1^2}{4}"$ basiert, 4

eine erste Übertragungsfunktion 5. Ordnung $"H_{3,1}^5(s_n)"$ mit den Koeffizienten $""a_1{=}15{,}19"$ und $"a_2 = \frac{a_1^2}{4}"$ :

$$H_{3,1}^5(s_n) = \frac{1 + a_1 s_n + a_2 s_n^2}{1 + a_1 s_n + a_2 s_n^2 + a_2 s_n^3 + a_1 s_n^4 + s_n^5}$$

mit $s_n{=}s/\omega_0$, und

die vierte Übertragungsfunktion k-ter Ordnung $"H_4^k(s)"$ ÜF4 des zweiten Filtersystems FSY2,

- das aus dem in dem zweiten Filtersystem FSY2 eins-zu-eins übertragenen, zweiten Ausgangssignal ASI2 mit einer Übertragungsfunktion "1" und aus dem ersten Filtersystem FSY1, FSY1' mit der dritten Übertragungsfunktion k-ter Ordnung $"H_3^k(s_n)"$ ÜF3 oder aus dem ersten Filtersystem (FSY1, FSY1') mit einer dritten Übertragungsfunktion k-ter Ordnung $"H_3^k\left(s_n \to \frac{1}{s_n}\right)"$ (ÜF3) gebildet wird,

- wobei die Übertragungsfunktion "1" und die dritte Übertragungsfunktion k-ter Ordnung $"H_3^k(s)"$ subtraktiv nach der Maßgabe $"1 - H_3^k(s)"$ verknüpft werden, und

- wenn das erste Filtersystem (FSY1, FSY1') mit der dritten Übertragungsfunktion k-ter Ordnung $"H_3^k(s)"$ auf dem Symmetrie-Tiefpass mit einer Symmetrie-Tiefpass-Übertragungsfunktion 5. Ordnung $"H_{STP}^5(s_n)"$ mit $H_{STP}^5(s_n) = \frac{1 + a_1 s_n + a_2 s_n^2}{1 + a_1 s_n + a_2 s_n^2 + a_2 s_n^3 + a_1 s_n^4 + s_n^5}$ und den Koeffizienten $"a_1{=}15{,}19"$ und $"a_2 = \frac{a_1^2}{4}"$ basiert,

eine zweite Tiefpass-Übertragungsfunktion 5. Ordnung $"H_{4,2}^5(s_n)"$ mit den Koeffizienten $"a_1{=}15{,}19"$ und $"a_2 = \frac{a_1^2}{4}"$ :

$$H_{4,2}^5(s_n) = 1 - H_3^k(s_n) = H_3^k\left(s_n \to \frac{1}{s_n}\right) = 1 - H_{STP}^5(s_n)$$
$$= \frac{a_2 s_n^3 + a_1 s_n^4 + s_n^5}{1 + a_1 s_n + a_2 s_n^2 + a_2 s_n^3 + a_1 s_n^4 + s_n^5}$$

mit $s_n{=}s/\omega_0$.

In einem dritten Simulationsszenario (Asymmetrie & Kompensation-Fall) werden die dritte Übertragungsfunktion k-ter Ordnung $"H_3^k(s)"$ ÜF3 des ersten Filtersystems FSY1, die vierte Übertragungsfunktion k-ter Ordnung $"H_4^k(s)"$ ÜF4 des zweiten Filtersystems FSY2 und die fünfte Übertragungsfunktion "$H_5(s)$" ÜF5 des zweiten Filtersystems FSY2 auf der Basis des Standard-Tiefpass mit der Verstärkung von "1" und

**A3.** der Standard-Tiefpass-Übertragungsfunktion 1. Ordnung $"H_{TP}^1(s_n)"$ oder

**B3.** einer Standard-Tiefpass-Übertragungsfunktion 2. Ordnung $"H_{TP}^2(s_n)"$ oder

**C3.** einer Standard-Tiefpass-Übertragungsfunktion 3. Ordnung $"H_{TP}^3(s_n)"$ für die asymmetrische und kompensatorische Erzeugung des Kombinationssignals KSI, bei dem vorzugsweise das zweite Ausgangssignal ASI2, das zweite Filtersignal FSI2, das Kompensation-Filtersignal FSI$_K$ und das erste Filtersignal FSI1 additiv und/oder subtraktiv mit der Maßgabe $"H_3^k(s) \times H_1^m(s) + H_4^k(s) \times H_2^p(s) = 1"$ verknüpft werden, ermittelt.

Im Fall **A3.** des dritten Simulationsszenarios sind die dritte Übertragungsfunktion k-ter Ordnung $"H_3^k(s)"$ ÜF3 des ersten Filtersystems FSY1, FSY1',

- wenn dieses auf dem Standard-Tiefpass mit der Standard-Tiefpass-Übertragungsfunktion 1. Ordnung $"H_{TP}^1(s_n)"$ und der Filterapproximationsunabhängigkeit basiert, und

- das aus einem multiplikative Produkt von der Standard-Tiefpass-Übertragungsfunktion 1. Ordnung $"H_{TP}^1(s_n)"$ und aus einer Inversen $"1/H_1^1(s_n)"$ der Übertragungsfunktion 1. Ordnung $"H_1^1(s_n)"$ des Tiefpasses TP als das erste elektrische System SY1 ist,

eine dritte Übertragungsfunktion 1. Ordnung $"H_{3,3}^1(s_n)"$ mit der der Filterapproximationsunabhängigkeit:

$$H_{3,3}^1(s_n) = \frac{H_{TP}^1(s_n)}{H_1^1(s_n)} = \frac{\omega_{SY2,n}s_n + 1}{s_n + 1}$$

mit $s_n = s/\omega_0, \omega_{SY1,n} = \omega_{SY1}/\omega_0, \omega_{SY2,n} = \omega_{SY2}/\omega_0, \omega_{SY1,n} = 1/\omega_{SY2,n}$,

die vierte Übertragungsfunktion k-ter Ordnung $"H_4^k(s)"$ ÜF4 des zweiten Filtersystems FSY2,
- das aus dem in dem zweiten Filtersystem FSY2 eins-zu-eins übertragenen, zweiten Ausgangssignal ASI2 mit einer Übertragungsfunktion "1" und aus dem Standard-Tiefpass mit der Standard-Tiefpass-Übertragungsfunktion 1. Ordnung $"H_{TP}^1(s_n)"$ und der Filterapproximationsunabhängigkeit gebildet wird,

- wobei die Übertragungsfunktion "1" und die Standard-Tiefpass-Übertragungsfunktion 1. Ordnung $"H_{TP}^1(s_n)"$ subtraktiv nach der Maßgabe $"1 - H_{TP}^1(s_n)"$ verknüpft werden, und
- die Verknüpfung aus der Übertragungsfunktion "1" und der Standard-Tiefpass-Übertragungsfunktion 1. Ordnung $"H_{TP}^1(s_n)"$ mit einer Inversen $"1/H_2^1(s_n)"$ der Übertragungsfunktion 1. Ordnung $"H_2^1(s_n)"$ des Hochpasses HP als das zweite elektrische System SY2 multipliziert wird,

eine dritte Übertragungsfunktion 1. Ordnung $"H_{4,3}^1(s_n)"$ mit der Filterapproximationsunabhängigkeit:

$$H_{4,3}^1(s_n) = \frac{1 - H_{TP}^1(s_n)}{H_2^1(s_n)} = \frac{\omega_{SY2,n} + s_n}{s_n + 1}$$

mit $s_n = s/\omega_0, \omega_{SY1,n} = \omega_{SY1}/\omega_0, \omega_{SY2,n} = \omega_{SY2}/\omega_0, \omega_{SY1,n} = 1/\omega_{SY2,n}$, und die fünfte Übertragungsfunktion "$H_5(s)$" ÜF5 des zweiten Filtersystems FSY2,

- das aus dem multiplikativen Produkt von der Standard-Tiefpass-Übertragungsfunktion 1. Ordnung $"H_{TP}^1(s_n)"$ mit der Filterapproximationsunabhängigkeit und der Inversen $"1/H_1^1(s_n)"$ der Übertragungsfunktion 1. Ordnung $"H_1^1(s_n)"$ des Tiefpasses TP als das erste elektrische System SY1 gebildet wird,

- das aus dem in dem zweiten Filtersystem FSY2 eins-zu-eins übertragenen, zweiten Ausgangssignal ASI2 mit der Übertragungsfunktion "1" und aus dem Standard-Tiefpass mit der Standard-Tiefpass-Übertragungsfunktion 1. Ordnung $"H_{TP}^1(s_n)"$ und der Filterapproximationsunabhängigkeit, wobei die Übertragungsfunktion "1" und die Standard-Tiefpass-Übertragungsfunktion 1. Ordnung $"\mathbf{H}^1_{\mathrm{TP}}(s_n)"$ subtraktiv nach der Maßgabe $"1-\mathbf{H}^1_{\mathrm{TP}}(s_n)"$ verknüpft werden und wobei die Verknüpfung aus der Übertragungsfunktion "1" und der Standard-Tiefpass-Über-tragungsfunktion 1. Ordnung $"\mathbf{H}^1_{\mathrm{TP}}(s_n)"$ mit der Inversen $"1/\mathbf{H}^1_2(s_n)"$ der Übertragungsfunktion 1. Ordnung $"\mathbf{H}^1_2(s_n)"$ des Hochpasses HP als das zweite elektrische System SY2 multipliziert wird, gebildet wird,

- wobei das multiplikative Produkt und das Multiplikationsprodukt aus der Verknüpfung und der Inversen $"1/\mathbf{H}^1_2(s_n)"$ der Übertragungsfunktion 1. Ordnung $"\mathbf{H}^1_2(s_n)"$ addiert werden, und
- wobei von einer durch die Addition gebildeten Summe das in dem zweiten Filtersystem FSY2 eins-zu-eins übertragene, zweite Ausgangssignal ASI2 mit der Übertragungsfunktion "1" subtrahiert wird,
eine erste Übertragungsfunktion "$H_{5,1u}(S_n)$" mit der Filterapproximationsunabhängigkeit ist:

$$H_{5,1u}(s_n) = \frac{\mathbf{H}^1_{\mathrm{TP}}(s_n)}{\mathbf{H}^1_1(s_n)} + \frac{1 - \mathbf{H}^1_{\mathrm{TP}}(s_n)}{\mathbf{H}^1_2(s_n)} - 1 = \omega_{\mathrm{SY2,n}}$$

mit $s_n = s/\omega_0$, $\omega_{\mathrm{SY1,n}} = \omega_{\mathrm{SY1}}/\omega_0$, $\omega_{\mathrm{SY2,n}} = \omega_{\mathrm{SY2}}/\omega_0$, $\omega_{\mathrm{SY1,n}} = 1/\omega_{\mathrm{SY2,n}}$, u=: $H_5$ ist 1. Ordnung-basiert.

Im Fall **B3.** des dritten Simulationsszenarios sind die dritte Übertragungsfunktion k-ter Ordnung $"\mathbf{H}^k_3(s)"$ ÜF3 des ersten Filtersystems FSY1, FSY1',

- wenn dieses auf dem Standard-Tiefpass mit der Standard-Tiefpass-Übertragungsfunktion 2. Ordnung $"\mathbf{H}^2_{\mathrm{TP}}(s_n)"$ und einer Butterworth-Filterapproximation und einem Koeffizienten $"a = \sqrt{2}"$ basiert, und
- das aus einem multiplikative Produkt von der Standard-Tiefpass-Übertragungsfunktion 2. Ordnung $"\mathbf{H}^2_{\mathrm{TP}}(s_n)"$ und einer Inversen $"1/\mathbf{H}^1_1(s_n)"$ der Übertragungsfunktion 1. Ordnung $"\mathbf{H}^1_1(s_n)"$ des Tiefpasses TP als das erste elektrische System SY1 ist,
eine zweite Übertragungsfunktion 2. Ordnung $"\mathbf{H}^2_{3,2}(s_n)"$ mit der Butterworth-Filterapproximation und dem Koeffizienten $"a = \sqrt{2}"$ ist:

$$\mathbf{H}^2_{3,2}(s_n) = \frac{\mathbf{H}^2_{\mathrm{TP}}(s_n)}{\mathbf{H}^1_1(s_n)} = \frac{\omega_{\mathrm{SY2,n}} s_n + 1}{1 + a s_n + s_n^2}$$

mit $s_n = s/\omega_0$, $\omega_{\mathrm{SY1,n}} = \omega_{\mathrm{SY1}}/\omega_0$, $\omega_{\mathrm{SY2,n}} = \omega_{\mathrm{SY2}}/\omega_0$, $\omega_{\mathrm{SY1,n}} = 1/\omega_{\mathrm{SY2,n}}$,

die vierte Übertragungsfunktion k-ter Ordnung $"\mathbf{H}^k_4(s)"$ ÜF4 des zweiten Filtersystems FSY2,
- das aus dem in dem zweiten Filtersystem FSY2 eins-zu-eins übertragenen, zweiten Ausgangssignal ASI2 mit einer Übertragungsfunktion "1" und aus dem Standard-Tiefpass mit der Standard-Tiefpass-Übertragungsfunktion 2. Ord-nung $"\mathbf{H}^2_{\mathrm{TP}}(s_n)"$, der Butterworth-Filterapproximation und dem Koeffizienten $"a = \sqrt{2}"$ gebildet wird,
- wobei die Übertragungsfunktion "1" und die Standard-Tiefpass-Übertragungsfunktion 2. Ordnung $"\mathbf{H}^2_{\mathrm{TP}}(s_n)"$ subtraktiv nach der Maßgabe $"1-\mathbf{H}^2_{\mathrm{TP}}(s_n)"$ verknüpft werden, und
- die Verknüpfung aus der Übertragungsfunktion "1" und der Standard-Tiefpass-Übertragungsfunktion 2. Ordnung

$"H_{TP}^2(s_n)"$ mit einer Inversen $"1/H_2^1(s_n)"$ der Übertragungsfunktion 1. Ordnung $"H_2^1(s_n)"$ des Hochpasses HP als das zweite elektrische System SY2 multipliziert wird,

eine zweite Übertragungsfunktion 2. Ordnung $"H_{4,2}^2(s_n)"$ mit der Butterworth-Filterapproximation und dem Koeffizienten $"a = \sqrt{2}"$:

$$H_{4,2}^2(s_n) = \frac{1 - H_{TP}^2(s_n)}{H_2^1(s_n)} = \frac{s_n^2 + (a + \omega_{SY2,n})s_n + a\omega_{SY2,n}}{1 + as_n + s_n^2}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, und die fünfte Übertragungsfunktion $"H_5(s)"$ ÜF5 des zweiten Filtersystems FSY2,

- das aus dem multiplikativen Produkt von der Standard-Tiefpass-Übertragungsfunktion 2. Ordnung $"H_{TP}^2(s_n)"$ mit der der Butterworth-Filterapproximation und dem Koeffizienten $"a = \sqrt{2}"$ und der Inversen $"1/H_1^1(s_n)"$ der Übertragungsfunktion 1. Ordnung $"H_1^1(s_n)"$ des Tiefpasses TP als das erste elektrische System SY1 gebildet wird,
- das aus dem in dem zweiten Filtersystem FSY2 eins-zu-eins übertragenen, zweiten Ausgangssignal ASI2 mit der Übertragungsfunktion "1" und aus dem Standard-Tiefpass mit der Standard-Tiefpass-Übertragungsfunktion 2. Ordnung $"H_{TP}^2(s_n)"$, der Butterworth-Filterapproximation und dem Koeffizienten $"a = \sqrt{2}"$, wobei die Übertragungsfunktion "1" und die Standard-Tiefpass-Übertragungsfunktion 2. Ordnung $"H_{TP}^2(s_n)"$ subtraktiv nach der Maßgabe "1- $H_{TP}^2(s_n)"$ verknüpft werden und wobei die Verknüpfung aus der Übertragungsfunktion "1" und der Standard-Tiefpass-Übertragungsfunktion 2. Ordnung $"H_{TP}^2(s_n)"$ mit der Inversen $"1/H_2^1(s_n)"$ der Übertragungsfunktion 1. Ordnung $"H_2^1(s_n)"$ des Hochpasses (HP) als das zweite elektrische System SY2 multipliziert wird, gebildet wird,
- wobei das multiplikative Produkt und das Multiplikationsprodukt aus der Verknüpfung und der Inversen $"1/H_2^1(s_n)"$ der Übertragungsfunktion 1. Ordnung $"H_2^1(s_n)"$ addiert werden, und
- wobei von einer durch die Addition gebildeten Summe das in dem zweiten Filtersystem FSY2 eins-zu-eins übertragene, zweite Ausgangssignal ASI2 mit der Übertragungsfunktion "1" subtrahiert wird,
eine zweite Übertragungsfunktion $"H_{5,2v}(s_n)"$ mit der Butterworth-Filterapproximation und dem Koeffizienten $"a = \sqrt{2}"$:

$$H_{5,2v}(s_n) = \frac{H_{TP}^2(s_n)}{H_1^1(s_n)} + \frac{1 - H_{TP}^2(s_n)}{H_2^1(s_n)} - 1 = \frac{2\omega_{SY2,n}s_n + \omega_{SY2,n}a}{1 + as_n + s_n^2}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, v=: $H_5$ ist 2. Ordnung-basiert.

Eine nachfolgende **Abbildung B3-SR** zeigt für den Fall **B3.** des dritten Simulationsszenarios eine mögliche Schaltungsrealisierung für die Elektronische Schaltungsanordnung ESA mit den Filtersystemen FSY1, FSY1', FSY2 der Filterschaltung FS und der Kombinationsschaltung KS im Zusammenhang mit der Kombination der Ausgangssignale ASI1, ASI2 der elektrischen Systeme SY1, SY2 mit den verschiedenen Signal-Frequenzbereichen FB1, FB2 zur Erzeugung des Kombinationssignales KSI.

## Abbildung B3-SR

In der **Abbildung B3-SR** sind die einzelnen Widerstände R1, R2, R3, usw. und die Kapazitäten C1, C2, C3, usw. in Bezug auf die Ausgangssignale ASI, ASI2 und der anderen Schaltungselemente für eine funktionsfähige, zweckorientierte Schaltung mit den angegebenen Widerstand-Zahlenwerten in [Ω] bzw. den Kapazität-Zahlenwerten in [F] dimensioniert.

Im Fall **C3.** des dritten Simulationsszenarios sind

die dritte Übertragungsfunktion k-ter Ordnung $"H_3^k(s)"$ ÜF3 des ersten Filtersystems FSY1, FSY1',

- wenn dieses auf dem Standard-Tiefpass mit der Standard-Tiefpass-Übertragungsfunktion 3. Ordnung $"H_{TP}^3(s_n)"$ und einer Butterworth-Filterapproximation und einem Koeffizienten "$a = 2$" basiert, und

- das aus einem multiplikative Produkt von der Standard-Tiefpass-Übertragungsfunktion 3. Ordnung $"H_{TP}^3(s_n)"$ und einer Inversen $"1/H_1^1(s_n)"$ der Übertragungsfunktion 1. Ordnung $"H_1^1(s_n)"$ des Tiefpasses TP als das erste elektrische System SY1 ist,

eine dritte Übertragungsfunktion 3. Ordnung $"H_{3,3}^3(s_n)"$ mit der Butterworth-Filterapproximation und dem Koeffizienten "$a = 2$" ist:

$$H_{3,3}^3(s_n) = \frac{H_{TP}^2(s_n)}{H_1^1(s_n)} = \frac{\omega_{SY2,n}s_n + 1}{1 + as_n + as_n^2 + s_n^3}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$,

die vierte Übertragungsfunktion k-ter Ordnung $"\mathbf{H}_4^k(s)"$ ÜF4 des zweiten Filtersystems FSY2,

- das aus dem in dem zweiten Filtersystem FSY2 eins-zu-eins übertragenen, zweiten Ausgangssignal ASI2 mit einer Übertragungsfunktion "1" und aus dem Standard-Tiefpass mit der Standard-Tiefpass-Übertragungsfunktion 3. Ordnung $"\mathbf{H}_{TP}^3(s_n)"$, der Butterworth-Filterapproximation und dem Koeffizienten "$a = 2$" gebildet wird,

- wobei die Übertragungsfunktion "1" und die Standard-Tiefpass-Übertragungsfunktion 3. Ordnung $"\mathbf{H}_{TP}^3(s_n)"$ subtraktiv nach der Maßgabe $"1 - \mathbf{H}_{TP}^3(s_n)"$ verknüpft werden, und

- die Verknüpfung aus der Übertragungsfunktion "1" und der Standard-Tiefpass-Übertragungsfunktion 3. Ordnung $"\mathbf{H}_{TP}^3(s_n)"$ mit einer Inversen $"1/\mathbf{H}_2^1(s_n)"$ der Übertragungsfunktion 1. Ordnung $"\mathbf{H}_2^1(s_n)"$ des Hochpasses HP als das zweite elektrische System SY2 multipliziert wird,

eine dritte Übertragungsfunktion 3. Ordnung $"\mathbf{H}_{4,3}^3(s_n)"$ mit der Butterworth-Filterapproximation und dem Koeffizienten "$a = 2$":

$$\mathbf{H}_{4,3}^3(s_n) = \frac{1 - \mathbf{H}_{TP}^3(s_n)}{\mathbf{H}_2^1(s_n)} = \frac{s_n^3 + (a + \omega_{SY2,n})s_n^2 + (\omega_{SY2,n} + 1)as_n + \omega_{SY2,n}a}{1 + as_n + as_n^2 + s_n^3}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, und die fünfte Übertragungsfunktion "$\mathbf{H}_5(s)$" ÜF5 des zweiten Filtersystems FSY2,

- das aus dem multiplikativen Produkt von der Standard-Tiefpass-Übertragungsfunktion 3. Ordnung $"\mathbf{H}_{TP}^3(s_n)"$ mit der der Butterworth-Filterapproximation und dem Koeffizienten "$a = 2$" und der Inversen $"1/\mathbf{H}_1^1(s_n)"$ der Übertragungsfunktion 1. Ordnung $"\mathbf{H}_1^1(s_n)"$ des Tiefpasses TP als das erste elektrische System SY1 gebildet wird,

- das aus dem in dem zweiten Filtersystem FSY2 eins-zu-eins übertragenen, zweiten Ausgangssignal ASI2 mit der Übertragungsfunktion "1" und aus dem Standard-Tiefpass mit der Standard-Tiefpass-Übertragungsfunktion 3. Ordnung $"\mathbf{H}_{TP}^3(s_n)"$, der Butterworth-Filterapproximation und dem Koeffizienten "$a = 2$", wobei die Übertragungsfunktion "1" und die Standard-Tiefpass-Übertragungsfunktion 3. Ordnung $"\mathbf{H}_{TP}^3(s_n)"$ subtraktiv nach der Maßgabe $"1 - \mathbf{H}_{TP}^3(s_n)"$ verknüpft werden und wobei die Verknüpfung aus der Übertragungsfunktion "1" und der Standard-Tiefpass-Übertragungsfunktion 3. Ordnung $"\mathbf{H}_{TP}^3(s_n)"$ mit der Inversen $"1/\mathbf{H}_2^1(s_n)"$ der Übertragungsfunktion 1. Ordnung $"\mathbf{H}_2^1(s_n)"$ des Hochpasses HP als das zweite elektrische System SY2 multipliziert wird, gebildet wird,

- wobei das multiplikative Produkt und das Multiplikationsprodukt aus der Verknüpfung und der Inversen $"1/\mathbf{H}_2^1(s_n)"$ der Übertragungsfunktion 1. Ordnung $"\mathbf{H}_2^1(s_n)"$ addiert werden, und

- wobei von einer durch die Addition gebildeten Summe das in dem zweiten Filtersystem FSY2 eins-zu-eins übertragene, zweite Ausgangssignal ASI2 mit der Übertragungsfunktion "1" subtrahiert wird,

eine dritte Übertragungsfunktion "$\mathbf{H}_{5,3w}(s_n)$" mit der Butterworth-Filterapproximation und dem Koeffizienten "$a = 2$":

$$\mathbf{H}_{5,3w}(s_n) = \frac{\mathbf{H}_{TP}^3(s_n)}{\mathbf{H}_1^1(s_n)} + \frac{1 - \mathbf{H}_{TP}^3(s_n)}{\mathbf{H}_2^1(s_n)} - 1 = \frac{\omega_{SY2,n}s_n + \omega_{SY2,n}a}{1 + (a-1)s_n + s_n^2}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, w=: $H_5$ ist 3. Ordnung-basiert.

Eine nachfolgende **Abbildung C3-SR** zeigt für den Fall **C3.** des dritten Simulationsszenarios eine mögliche Schaltungsrealisierung für die Elektronische Schaltungsanordnung ESA mit den Filtersystemen FSY1, FSY1', FSY2 der Filterschaltung FS und der Kombinationsschaltung KS im Zusammenhang mit der Kombination der Ausgangssignale ASI1, ASI2 der elektrischen Systeme SY1, SY2 mit den verschiedenen Signal-Frequenzbereichen FB1, FB2 zur Erzeugung des Kombinationssignales KSI.

Abbildung C3-SR

In der **Abbildung C3-SR** sind die einzelnen Widerstände R1, R2, R3, usw. und die Kapazitäten C1, C2, C3, usw. in Bezug auf die Ausgangssignale ASI, ASI2 und der anderen Schaltungselemente für eine funktionsfähige, zweckorientierte Schaltung mit den angegebenen Widerstand-Zahlenwerten in [$\Omega$] bzw. den Kapazität-Zahlenwerten in [F] dimensioniert.

Eine nachfolgende **Abbildung C3-GR** zeigt für den Fall **C3.** des dritten Simulationsszenarios mit der möglichen Schaltungsrealisierung gemäß der Abbildung C3-SR für die Elektronische Schaltungsanordnung ESA mit den Filtersystemen FSY1, FSY1', FSY2 der Filterschaltung FS und der Kombinationsschaltung KS eine Graphen-Darstellung mit $\omega_n = \omega_{SY1,n} = \omega_{SY1}/\omega_0$, $\omega_n = \omega_{SY2,n} = \omega_{SY2}/\omega_0$ und $\omega_{SY1}/\omega_{SY2} = 100$

- der dritten Übertragungsfunktion 3. Ordnung $"\mathbf{H}_{3,3}^{3}(s_n)"$ als die auf der Standard-Tiefpass-Übertragungsfunktion

3. Ordnung $"\mathbf{H}_{\mathrm{TP}}^{3}(s_n)"$ basierende dritte Übertragungsfunktion k-ter Ordnung $"\mathbf{H}_{3}^{k}(s)"$ ÜF3 des ersten Filtersystems FSY1, FSY1',

- der dritten Übertragungsfunktion 3. Ordnung $"\mathbf{H}_{4,3}^{3}(s_n)"$ als die auf der Standard-Tiefpass-Übertragungsfunktion

3. Ordnung $"\mathbf{H}_{\mathrm{TP}}^{3}(s_n)"$ basierende vierte Übertragungsfunktion k-ter Ordnung $"\mathbf{H}_{4}^{k}(s)"$ ÜF4 des zweiten Filtersystems FSY2 und

- des Verlaufs des Kombinationssignals KSI.

## 3. Asymmetrische und kompensatorische Erzeugung von KSI

Abbildung B2-GR

In einem vierten Simulationsszenario (Symmetrie & Kompensation-Fall) werden die dritte Übertragungsfunktion k-ter Ordnung $"\mathbf{H}_3^k(s)"$ ÜF3 des ersten Filtersystems FSY1, die vierte Übertragungsfunktion k-ter Ordnung $"\mathbf{H}_4^k(s)"$ ÜF4 des zweiten Filtersystems FSY2 und die fünfte Übertragungsfunktion $"\mathbf{H}_5(s)"$ ÜF5 des zweiten Filtersystems FSY2 auf der Basis eines Symmetrie-Tiefpass mit einer Verstärkung von "1" und **A4.** einer Symmetrie-Tiefpass-

Übertragungsfunktion 1. Ordnung $"\mathbf{H}^1_{STP}(s_n)"$ oder

**B4.** einer Symmetrie-Tiefpass-Übertragungsfunktion 3. Ordnung $"\mathbf{H}^3_{STP}(s_n)"$ oder

**C4.** einer Symmetrie-Tiefpass-Übertragungsfunktion 5. Ordnung $"\mathbf{H}^5_{STP}(s_n)"$ für die <u>symmetrische und kompensatorische Erzeugung</u> des Kombinationssignals KSI, bei dem vorzugsweise das zweite Ausgangssignal ASI2, das zweite Filtersignal FSI2, das Kompensation-Filtersignal FSI$_K$ und das erste Filtersignal FSI1 additiv und/oder subtraktiv mit der

Maßgabe $"\mathbf{H}^k_3(s) \ \times \ \mathbf{H}^m_1(s) \ + \ \mathbf{H}^k_4(s) \ \times \ \mathbf{H}^p_2(s) \ = \ 1"$ verknüpft werden, ermittelt.

Im Fall **A4.** des vierten Simulationsszenarios sind

die dritte Übertragungsfunktion k-ter Ordnung $"\mathbf{H}^k_3(s)"$ ÜF3 des ersten Filtersystems FSY1, FSY1',

- wenn dieses auf dem Symmetrie-Tiefpass mit der Verstärkung von "1" und der Symmetrie-Tiefpass-Übertragungsfunktion 1. Ordnung $"\mathbf{H}^1_{STP}(s_n)"$ mit $\mathbf{H}^1_{STP}(s_n) = \frac{1}{1+s_n}$ und einer Filterapproximationsunabhängigkeit basiert, und

- das aus einem multiplikative Produkt von der Symmetrie-Tiefpass-Übertragungsfunktion 1. Ordnung $"\mathbf{H}^1_{STP}(s_n)"$

und einer Inversen $"1/\mathbf{H}^1_1(s_n)"$ der Übertragungsfunktion 1. Ordnung $"\mathbf{H}^1_1(s_n)"$ des Tiefpasses TP als das erste elektrische System SY1 gebildet wird,

eine vierte Übertragungsfunktion 1. Ordnung $"\mathbf{H}^1_{3,4}(s_n)"$ mit der Filterapproximationsunabhängigkeit:

$$\mathbf{H}^1_{3,4}(s_n) = \frac{\mathbf{H}^1_{STP}(s_n)}{\mathbf{H}^1_1(s_n)} = \frac{\omega_{SY2,n}s_n + 1}{s_n + 1}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$,

die vierte Übertragungsfunktion k-ter Ordnung $"\mathbf{H}^k_4(s)"$ (ÜF4) des zweiten Filtersystems FSY2,
- das aus dem in dem zweiten Filtersystem FSY2 eins-zu-eins übertragenen, zweiten Ausgangssignal ASI2 mit einer Übertragungsfunktion "1" und aus dem Symmetrie-Tiefpass mit der Symmetrie-Tiefpass-Übertragungsfunktion 1.

Ordnung $"\mathbf{H}^1_{STP}(s_n)"$ mit $\mathbf{H}^1_{STP}(s_n) = \frac{1}{1+s_n}$ und der Filterapproximationsunabhängigkeit oder aus dem Symmetrie-Tiefpass mit der Symmetrie-Tiefpass-Übertragungsfunktion 1. Ordnung $"\mathbf{H}^1_{STP}\left(s_n \to \frac{1}{s_n}\right)"$ mit

$\mathbf{H}^1_{STP}\left(s_n \to \frac{1}{s_n}\right) = \frac{s_n}{s_n+1}$ und der Filterapproximationsunabhängigkeit gebildet wird,

- wobei die Übertragungsfunktion "1" und die Symmetrie-Tiefpass-Übertragungsfunktion 1. Ordnung $"\mathbf{H}^1_{STP}(s_n)"$

subtraktiv nach der Maßgabe $"1 - \mathbf{H}^1_{STP}(s_n)"$ verknüpft werden, und
- die Verknüpfung aus der Übertragungsfunktion "1" und der Symmetrie-Tiefpass-Übertragungsfunktion 1. Ordnung

$"\mathbf{H}^1_{STP}(s_n)"$ mit einer Inversen $"1/\mathbf{H}^1_2(s_n)"$ der Übertragungsfunktion 1. Ordnung $"\mathbf{H}^1_2(s_n)"$ des Hochpasses HP als das zweite elektrische System SY2 multipliziert wird,

eine vierte Übertragungsfunktion 1. Ordnung $"\mathbf{H}^1_{4,4}(s_n)"$ mit der Filterapproximationsunabhängigkeit:

$$H_{4,4}^1(s_n) = \frac{1 - H_{STP}^1(s_n)}{H_2^1(s_n)} = \frac{H_{STP}^1\left(s_n \to \frac{1}{s_n}\right)}{H_2^1(s_n)} = \frac{\omega_{SY2,n} + s_n}{s_n + 1}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, und die fünfte Übertragungsfunktion "$H_5(s)$" ÜF5 des zweiten Filtersystems FSY2,

- das aus dem multiplikativen Produkt von der Symmetrie-Tiefpass-Übertragungsfunktion 1. Ordnung "$H_{STP}^1(s_n)$" mit der Filterapproximationsunabhängigkeit und der Inversen "$1/H_1^1(s_n)$" der Übertragungsfunktion 1. Ordnung "$H_1^1(s_n)$" des Tiefpasses TP als das erste elektrische System SY1 gebildet wird,

- das aus dem in dem zweiten Filtersystem FSY2 eins-zu-eins übertragenen, zweiten Ausgangssignal ASI2 mit der Übertragungsfunktion "1" und aus dem Symmetrie-Tiefpass mit der Symmetrie-Tiefpass-Übertragungsfunktion 1. Ordnung "$H_{STP}^1(s_n)$" und der Filterapproximationsunabhängigkeit, wobei die Übertragungsfunktion "1" und die Symmetrie-Tiefpass-Übertragungsfunktion 1. Ordnung "$H_{STP}^1(s_n)$" subtraktiv nach der Maßgabe "$1 - H_{STP}^1(s_n)$" verknüpft werden und wobei die Verknüpfung aus der Übertragungsfunktion "1" und der Symmetrie-Tiefpass-Übertragungsfunktion 1. Ordnung "$H_{STP}^1(s_n)$" mit der Inversen "$1/H_2^1(s_n)$" der Übertragungsfunktion 1. Ordnung "$H_2^1(s_n)$" des Hochpasses HP als das zweite elektrische System SY2 multipliziert wird, gebildet wird,

- wobei das multiplikative Produkt und das Multiplikationsprodukt aus der Verknüpfung und der Inversen "$1/H_2^1(s_n)$" der Übertragungsfunktion 1. Ordnung "$H_2^1(s_n)$" addiert werden, und

- wobei von einer durch die Addition gebildeten Summe das in dem zweiten Filtersystem FSY2 eins-zu-eins übertragene, zweite Ausgangssignal ASI2 mit der Übertragungsfunktion "1" subtrahiert wird,
eine vierte Übertragungsfunktion "$H_{5,4u}(s_n)$" mit der Filterapproximationsunabhängigkeit:

$$H_{5,4u}(s_n) = \frac{H_{STP}^1(s_n)}{H_1^1(s_n)} + \frac{1 - H_{STP}^1(s_n)}{H_2^1(s_n)} - 1 = \omega_{SY2,n}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, u=: $H_5$ ist 1. Ordnung-basiert.

Eine nachfolgende **Abbildung A4-SR** zeigt für den Fall **A4.** des vierten Simulationsszenarios eine mögliche Schaltungsrealisierung für die Elektronische Schaltungsanordnung ESA mit den Filtersystemen FSY1, FSY1', FSY2 der Filterschaltung FS und der Kombinationsschaltung KS im Zusammenhang mit der Kombination der Ausgangssignale ASI1, ASI2 der elektrischen Systeme SY1, SY2 mit den verschiedenen Signal-Frequenzbereichen FB1, FB2 zur Erzeugung des Kombinationssignales KSI.

Abbildung A4-SR

In der **Abbildung A4-SR** sind die R-/Rm-/Rp-Widerstandswerte der einzelnen Widerstände R1, R2, R3, usw. und die C-Kapazitätswerte der Kapazitäten C1, C2, C3, usw. in Bezug auf die Ausgangssignale ASI, ASI2 und der anderen Schaltungselemente für eine funktionsfähige, zweckorientierte Schaltung auszulegen und entsprechend zu dimensionieren. Anmerkung: Wenn es heißt "FSYK Teil von KS", dann bedeutet dies, dass der gepunktet-umrandete Schaltungsteil zum Kompensation-Filtersystem $\text{FSY}_K$ gehört, aber auch Teil der Kombinationsschaltung KS ist.

Im Fall **B4.** des vierten Simulationsszenarios sind

die dritte Übertragungsfunktion k-ter Ordnung $"\mathbf{H}_3^k(s)"$ ÜF3 des ersten Filtersystems FSY1, FSY1',

- wenn dieses auf dem Symmetrie-Tiefpass mit der Verstärkung von "1" und einer Symmetrie-Tiefpass-Übertragungsfunktion 3. Ordnung $"\mathbf{H}_{STP}^3(s_n)"$ mit $\mathbf{H}_{STP}^3(s_n) = \dfrac{1+as_n}{1+as_n+as_n^2+s_n^3}$ und einem Koeffizienten "a=3" als dreifache Polstelle basiert, und

- das aus einem multiplikative Produkt von der Symmetrie-Tiefpass-Übertragungsfunktion 3. Ordnung $"\mathbf{H}_{STP}^3(s_n)"$ und einer Inversen $"1/\mathbf{H}_1^1(s_n)"$ der Übertragungsfunktion 1. Ordnung $"\mathbf{H}_1^1(s_n)"$ des Tiefpasses TP als das erste elektrische System SY1 gebildet wird,

eine vierte Übertragungsfunktion 3. Ordnung $"\mathbf{H}_{3,4}^3(s_n)"$ mit dem Koeffizienten "a=3" als dreifache Polstelle:

$$\mathbf{H}_{3,4}^3(s_n) = \frac{\mathbf{H}_{STP}^3(s_n)}{\mathbf{H}_1^1(s_n)} = \frac{1 + \left(a + \omega_{SY2,n}\right)s_n + a\omega_{SY2,n}s_n^2}{1 + as_n + as_n^2 + s_n^3}$$

mit $s_n=s/\omega_0$, $\omega_{SY1,n}=\omega_{SY1}/\omega_0$, $\omega_{SY2,n}=\omega_{SY2}/\omega_0$, $\omega_{SY1,n}=1/\omega_{SY2,n}$,

die vierte Übertragungsfunktion k-ter Ordnung $"H_4^k(s)"$ ÜF4 des zweiten Filtersystems FSY2,

- das aus dem in dem zweiten Filtersystem FSY2 eins-zu-eins übertragenen, zweiten Ausgangssignal ASI2 mit einer Übertragungsfunktion "1" und aus dem Symmetrie-Tiefpass mit der Symmetrie-Tiefpass-Übertragungsfunktion 3.

Ordnung $"H_{STP}^3(s_n)"$ mit $H_{STP}^3(s_n) = \dfrac{1+as_n}{1+as_n+as_n^2+s_n^3}$ und dem Koeffizienten "a=3" als dreifache Polstelle oder aus dem Symmetrie-Tiefpass mit der Symmetrie-Tiefpass-Übertragungsfunktion 3. Ordnung

$"H_{STP}^3\left(s_n \to \dfrac{1}{s_n}\right)"$ mit $H_{STP}^3\left(s_n \to \dfrac{1}{s_n}\right) = \dfrac{1+a\frac{1}{s_n}}{1+a\frac{1}{s_n}+a\frac{1}{s_n^2}+\frac{1}{s_n^3}}$ und dem Koeffizienten "a=3" als dreifache Polstelle gebildet wird,

- wobei die Übertragungsfunktion "1" und die Symmetrie-Tiefpass-Übertragungsfunktion 3. Ordnung $"H_{STP}^3(s_n)"$ subtraktiv nach der Maßgabe $"1-H_{STP}^3(s_n)"$ verknüpft werden, und
- die Verknüpfung aus der Übertragungsfunktion "1" und der Symmetrie-Tiefpass-Übertragungsfunktion 3. Ordnung

$"H_{STP}^3(s_n)"$ oder die Symmetrie-Tiefpass-Übertragungsfunktion 3. Ordnung $"H_{STP}^3\left(s_n \to \dfrac{1}{s_n}\right)"$ mit einer Inversen $"1/H_2^1(s_n)"$ der Übertragungsfunktion 1. Ordnung $"H_2^1(s_n)"$ des Hochpasses (HP) als das zweite elektrische System SY2 multipliziert wird,

eine vierte Übertragungsfunktion 3. Ordnung $"H_{4,4}^3(s_n)"$ mit dem Koeffizienten "a=3" als dreifache Polstelle:

$$H_{4,4}^3(s_n) = \frac{1 - H_{STP}^3(s_n)}{H_2^1(s_n)} = \frac{H_{STP}^3\left(s_n \to \dfrac{1}{s_n}\right)}{H_2^1(s_n)} = \frac{a\omega_{SY2,n}s_n + \left(a + \omega_{SY2,n}\right)s_n^2 + s_n^3}{1 + as_n + as_n^2 + s_n^3}$$

mit $s_n=s/\omega_0$, $\omega_{SY1,n}=\omega_{SY1}/\omega_0$, $\omega_{SY2,n}=\omega_{SY2}/\omega_0$, $\omega_{SY1,n}=1/\omega_{SY2,n}$, und die fünfte Übertragungsfunktion "$H_5(s)$" ÜF5 des zweiten Filtersystems FSY2,

- das aus dem multiplikativen Produkt von der Symmetrie-Tiefpass-Übertragungsfunktion 3. Ordnung $"H_{STP}^3(s_n)"$ mit dem Koeffizienten "a=3" als dreifache Polstelle und der Inversen $"1/H_1^1(s_n)"$ der Übertragungsfunktion 1. Ordnung $"H_1^1(s_n)"$ des Tiefpasses TP als das erste elektrische System SY1 gebildet wird,
- das aus dem in dem zweiten Filtersystem FSY2 eins-zu-eins übertragenen, zweiten Ausgangssignal ASI2 mit der Übertragungsfunktion "1" und aus dem Symmetrie-Tiefpass mit der Symmetrie-Tiefpass-Übertragungsfunktion 3.

Ordnung $"H_{STP}^3(s_n)"$ und dem Koeffizienten "a=3" als dreifache Polstelle, wobei die Übertragungsfunktion "1" und die Symmetrie-Tiefpass-Übertragungsfunktion 3. Ordnung $"H_{STP}^3(s_n)"$ subtraktiv nach der Maßgabe $"1-H_{STP}^3(s_n)"$ verknüpft werden und wobei die Verknüpfung aus der Übertragungsfunktion "1" und der Symmetrie-Tiefpass-Übertragungsfunktion 3. Ordnung $"H_{STP}^3(s_n)"$ mit der Inversen $"1/H_2^1(s_n)"$ der Übertragungsfunktion 1. Ordnung $"H_2^1(s_n)"$ des Hochpasses HP als das zweite elektrische System SY2 multipliziert wird, gebildet wird,

- wobei das multiplikative Produkt und das Multiplikationsprodukt aus der Verknüpfung und der Inversen $"1/H_2^1(s_n)"$ der Übertragungsfunktion 1. Ordnung $"H_2^1(s_n)"$ addiert werden, und

- wobei von einer durch die Addition gebildeten Summe das in dem zweiten Filtersystem FSY2 eins-zu-eins übertragene, zweite Ausgangssignal ASI2 mit der Übertragungsfunktion "1" subtrahiert wird,
eine fünfte Übertragungsfunktion "$H_{5,sw}(s_n)$" mit dem Koeffizienten "a=3" als dreifache Polstelle:

$$\mathbf{H}_{5,5w}(s_n) = \frac{\mathbf{H}_{STP}^3(s_n)}{\mathbf{H}_1^1(s_n)} + \frac{1 - \mathbf{H}_{STP}^3(s_n)}{\mathbf{H}_2^1(s_n)} - 1 = \frac{\omega_{SY2,n}s_n + a\omega_{SY2,n}s_n}{s_n^2 + (a-1)s_n + 1}$$

mit $s_n=s/\omega_0$, $\omega_{SY1,n}=\omega_{SY1}/\omega_0$, $\omega_{SY2,n}=\omega_{SY2}/\omega_0$, $\omega_{SY1,n}=1/\omega_{SY2,n}$, w=: $H_5$ ist 3. Ordnung-basiert.

Die nachfolgende **Abbildung B4-SR** zeigt für den Fall **B4.** des vierten Simulationsszenarios eine mögliche Schaltungsrealisierung für die Elektronische Schaltungsanordnung ESA mit den Filtersystemen FSY1, FSY1', FSY2 der Filterschaltung FS und der Kombinationsschaltung KS im Zusammenhang mit der Kombination der Ausgangssignale ASI1, ASI2 der elektrischen Systeme SY1, SY2 mit den verschiedenen Signal-Frequenzbereichen FB1, FB2 zur Erzeugung des Kombinationssignales KSI.

Abbildung B4-SR

In der **Abbildung B4-SR** sind die R-/R'-Widerstandswerte der einzelnen Widerstände R1, R2, R3, usw. und die C-Kapazitätswerte der Kapazitäten C1, C2, C3, usw. in Bezug auf die Ausgangssignale ASI, ASI2 und der anderen Schaltungselemente für eine funktionsfähige, zweckorientierte Schaltung auszulegen und entsprechend zu dimensionieren.

Eine nachfolgende **Abbildung B4-GR** zeigt für den Fall **B4.** des vierten Simulationsszenarios mit der möglichen Schaltungsrealisierung gemäß der <u>Abbildung B4-SR</u> für die Elektronische Schaltungsanordnung ESA mit den Filtersystemen FSY1, FSY1', FSY2 der Filterschaltung FS und der Kombinationsschaltung KS eine Graphen-Darstellung mit $\omega_n=\omega_{SY1,n}=\omega_{SY1}/\omega_0$, $\omega_n=\omega_{SY2},n=\omega_{SY2}/\omega_0$ und $\omega_{SY1}/\omega_{SY2}=100$

- der vierten Übertragungsfunktion 3. Ordnung $"H_{3,4}^3(s_n)"$ als die auf der Symmetrie-Tiefpass-Übertragungsfunktion 3. Ordnung $"H_{STP}^3(s_n)"$ basierende dritte Übertragungsfunktion k-ter Ordnung $"H_3^k(s)"$ ÜF3 des ersten Filtersystems FSY1, FSY1',

- der vierten Übertragungsfunktion 3. Ordnung $"H_{4,4}^3(s_n)"$ als die auf der Symmetrie-Tiefpass-Übertragungsfunktion 3. Ordnung $"H_{STP}^3(s_n)"$ basierende vierte Übertragungsfunktion k-ter Ordnung $"H_4^k(s)"$ ÜF4 des zweiten Filtersystems FSY2 und

- des Verlaufs des Kombinationssignals KSI.

## 4. Symmetrische und kompensatorische Erzeugung von KSI

Abbildung B4-GR

Im Fall **C4.** des vierten Simulationsszenarios sind die dritte Übertragungsfunktion k-ter Ordnung $"\mathbf{H}_3^k(s)"$ ÜF3 des ersten Filtersystems FSY1, FSY1',

- wenn dieses auf einem Symmetrie-Tiefpass mit der Verstärkung von "1" und der Symmetrie-Tiefpass-Übertragungs-funktion 5. Ordnung $"\mathbf{H}_{STP}^5(s_n)"$ mit $\mathbf{H}_{STP}^5(s_n) = \dfrac{1+a_1 s_n+a_2 s_n^2}{1+a_1 s_n+a_2 s_n^2+a_2 s_n^3+a_1 s_n^4+s_n^5}$ und Koeffizienten "$a_1$=15,19" und $"a_2 = \dfrac{a_1^2}{4}"$ basiert, und

- das aus einem multiplikative Produkt von der Symmetrie-Tiefpass-Übertragungsfunktion 5. Ordnung $"\mathbf{H}_{STP}^5(s_n)"$

und einer Inversen $"1/H_1^1(s_n)"$ der Übertragungsfunktion 1. Ordnung $"H_1^1(s_n)"$ des Tiefpasses TP als das erste elektrische System SY1 gebildet wird,

eine zweite Übertragungsfunktion 5. Ordnung $"H_{3,2}^5(s_n)"$ mit den Koeffizienten "a$_1$=15,19" und $"a_2 = \frac{a_1^2}{4}"$ ist:

$$H_{3,2}^5(s_n) = \frac{H_{STP}^5(s_n)}{H_1^1(s_n)} = \frac{(a_2 s_n^2 + a_1 s_n + 1)(1 + s_n \omega_{SY2,n})}{(s_n^5 + a_1 s_n^4 + a_2 s_n^3 + a_2 s_n^2 + a_1 s_n + 1)}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$,

die vierte Übertragungsfunktion k-ter Ordnung $"H_4^k(s)"$ ÜF4 des zweiten Filtersystems FSY2,

- das aus dem in dem zweiten Filtersystem FSY2 eins-zu-eins übertragenen, zweiten Ausgangsignal ASI2 mit einer Übertragungsfunktion "1" und aus dem Symmetrie-Tiefpass mit der Symmetrie-Tiefpass-Übertragungsfunktion 5. Ordnung $"H_{STP}^5(s_n)"$ mit $H_{STP}^5(s_n) = \frac{1 + a_1 s_n + a_2 s_n^2}{1 + a_1 s_n + a_2 s_n^2 + a_2 s_n^3 + a_1 s_n^4 + s_n^5}$ und den Koeffizienten "a$_1$ = 15,19"

und $"a_2 = \frac{a_1^2}{4}"$ oder aus dem Symmetrie-Tiefpass mit der Symmetrie-Tiefpass-Übertragungsfunktion 5. Ordnung

$"H_{STP}^5\left(s_n \to \frac{1}{s_n}\right)"$ mit $H_{STP}^5\left(s_n \to \frac{1}{s_n}\right) = \frac{1 + a_1 \frac{1}{s_n} + a_2 \frac{1}{s_n^2}}{1 + a_1 \frac{1}{s_n} + a_2 \frac{1}{s_n^2} + a_2 \frac{1}{s_n^3} + a_1 \frac{1}{s_n^4} + \frac{1}{s_n^5}}$ und den Koeffizienten "a$_1$ =

15,19" und $"a_2 = \frac{a_1^2}{4}"$ gebildet wird,

- wobei die Übertragungsfunktion "1" und die Symmetrie-Tiefpass-Übertragungsfunktion 5. Ordnung $"H_{STP}^5(s_n)"$

subtraktiv nach der Maßgabe $"1 - H_{STP}^5(s_n)"$ verknüpft werden, und
- die Verknüpfung aus der Übertragungsfunktion "1" und der Symmetrie-Tiefpass-Übertragungsfunktion 5. Ordnung

$"H_{STP}^5(s_n)"$ oder die Symmetrie-Tiefpass-Übertragungsfunktion 5. Ordnung $"H_{STP}^5\left(s_n \to \frac{1}{s_n}\right)"$ mit einer Inversen $"1/H_2^1(s_n)"$ der Übertragungsfunktion 1. Ordnung $"H_2^1(s_n)"$ des Hochpasses (HP) als das zweite elektrische System SY2 multipliziert wird,

eine zweite Übertragungsfunktion 5. Ordnung $"H_{4,2}^5(s_n)"$ mit den Koeffizienten "a$_1$ = 15,19" und $"a_2 = \frac{a_1^2}{4}"$ ist:

$$H_{4,2}^5(s_n) = \frac{1 - H_{STP}^5(s_n)}{H_2^1(s_n)} = \frac{H_{STP}^5\left(s_n \to \frac{1}{s_n}\right)}{H_2^1(s_n)}$$
$$= \frac{(s_n^4 + a_1 s_n^3 + a_2 s_n^2)(\omega_{SY2,n} + s_n)}{(s_n^5 + a_1 s_n^4 + a_2 s_n^3 + a_2 s_n^2 + a_1 s_n + 1)}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, und die fünfte Übertragungsfunktion "H$_5$(s)" ÜF5 des zweiten Filtersystems FSY2,

- das aus dem multiplikativen Produkt von der Symmetrie-Tiefpass-Übertragungsfunktion 5. Ordnung $"H_{STP}^5(s_n)"$

mit mit den Koeffizienten "$a_1$ = 15,19" und $"a_2 = \frac{a_1^2}{4}"$ und der Inversen $"1/H_1^1(s_n)"$ der Übertragungsfunktion 1. Ordnung $"H_1^1(s_n)"$ des Tiefpasses TP als das erste elektrische System SY1 gebildet wird,

- das aus dem in dem zweiten Filtersystem FSY2 eins-zu-eins übertragenen, zweiten Ausgangssignal ASI2 mit der Übertragungsfunktion "1" und aus dem Symmetrie-Tiefpass mit der Symmetrie-Tiefpass-Übertragungsfunktion 5.

Ordnung $"H_{STP}^5(s_n)"$ und den Koeffizienten "$a_1$ = 15,19" und "$a_2 = \frac{a_1^2}{4}"$, wobei die Übertragungsfunktion "1" und die Symmetrie-Tiefpass-Übertragungsfunktion 5. Ordnung $"H_{STP}^5(s_n)"$ subtraktiv nach der Maßgabe

$"1-H_{STP}^5(s_n)"$ verknüpft werden und wobei die Verknüpfung aus der Übertragungsfunktion "1" und der Symmetrie-Tiefpass-Übertragungsfunktion 5. Ordnung $"H_{STP}^5(s_n)"$ mit der Inversen $"1/H_2^1(s_n)"$ der Übertragungsfunktion 1. Ordnung $"H_2^1(s_n)"$ des Hochpasses HP als das zweite elektrische System SY2 multipliziert wird, gebildet wird,

- wobei das multiplikative Produkt und das Multiplikationsprodukt aus der Verknüpfung und der Inversen

$"1/H_2^1(s_n)"$ der Übertragungsfunktion 1. Ordnung $"H_2^1(s_n)"$ addiert werden, und

- wobei von einer durch die Addition gebildeten Summe das in dem zweiten Filtersystem FSY2 eins-zu-eins übertragene, zweite Ausgangssignal ASI2 mit der Übertragungsfunktion "1" subtrahiert wird,

eine sechste Übertragungsfunktion "$H_{5,6x}(s_n)$" mit den Koeffizienten "$a_1$ = 15,19" und $"a_2 = \frac{a_1^2}{4}"$:

$$H_{5,6x}(s_n) = \frac{H_{STP}^5(s_n)}{H_1^1(s_n)} + \frac{1 - H_{STP}^5(s_n)}{H_2^1(s_n)} - 1$$

$$= \frac{\omega_{SY2,n}s_n^3 + (a_2 + a_1 - 1)\omega_{SY2,n}s_n^2 + s_n\omega_{SY2,n}}{(s_n^4 + (a_1 - 1)s_n^3 + (a_2 - a_1 + 1)s_n^2 + (a_1 - 1)s_n + 1)}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, x=: $H_5$ ist 5. Ordnung-basiert.

**Patentansprüche**

1. Verfahren zur Kombination von Ausgangssignalen (ASI1, ASI2) elektrischer Systeme (SY1, SY2) mit verschiedenen Signal-Frequenzbereichen (FB1, FB2), bei dem ein durch eine erste Übertragungsfunktion m-ter Ordnung

$"H_1^m(s)"$ (ÜF1) eines ersten elektrischen Systems (SY1) im Verhältnis zu einem Eingangssignal (ESI) bestimmbares, erstes Ausgangssignal (ASI1) mit einem ersten Frequenzbereich (FB1) und einer durch das erste System (SY1) bedingten, ersten Grenzkreisfrequenz $\omega_{SY1}$ sowie ein durch eine zweite Übertragungsfunktion p-ter Ordnung

$"H_2^p(s)"$ (ÜF2) eines zweiten elektrischen Systems (SY2) im Verhältnis zu dem Eingangssignal (ESI) bestimmbares, zweites Ausgangssignal (ASI2) mit einem zweiten Frequenzbereich (FB2) und einer durch das zweite System (SY2) bedingten, zweiten Grenzkreisfrequenz $\omega_{SY2}$ gefiltert (flt) und nach der Filterung zur Erzeugung eines Kombinationssignals (KSI) kombiniert (kbn) werden,
**dadurch gekennzeichnet, dass**
zur Erzeugung des Kombinationssignals (KSI)

a) im Zuge der Filterung (flt) ein durch eine dritte Übertragungsfunktion k-ter Ordnung $"H_3^k(s)"$ (ÜF3) eines ersten Filtersystems (FSY1) im Verhältnis zu dem ersten Ausgangssignal (ASI1) bestimmbares, erstes Filtersignal (FSI1) mit einer Filter-Grenzkreisfrequenz $\omega_0$ generiert wird,

b) im Zuge der Filterung (flt) in Bezug auf eine vierte Übertragungsfunktion k-ter Ordnung $"H_4^k(s)"$ (ÜF4) eines zweiten Filtersystems (FSY1)

b1) ein durch die dritte Übertragungsfunktion k-ter Ordnung $"H_3^k(s)"$ (ÜF3) eines weiteren ersten Filtersystems (FSY1') des zweiten Filtersystems (FSY2) im Verhältnis zu dem zweiten Ausgangssignal (ASI2) bestimmbares, zweites Filtersignal (FSI2) mit der Filter-Grenzkreisfrequenz $\omega_0$ generiert wird oder

b2) ein durch die dritte Übertragungsfunktion k-ter Ordnung $"H_3^k(s)"$ (ÜF3) eines weiteren ersten Filtersystems (FSY1') im Verhältnis zu dem zweiten Ausgangssignal (ASI2) bestimmbares, zweites Filtersignal (FSI2) mit der Filter-Grenzkreisfrequenz $\omega_0$ und ein durch eine fünfte Übertragungsfunktion $"H_5(s)"$ (ÜF5) eines Kompensation-Filtersystems (FSY$_K$) im Verhältnis zu dem zweiten Ausgangssignal (ASI2) bestimmbares Kompensation-Filtersignal (FSI$_K$) generiert werden,

c) im Zuge der Kombination in Bezug auf die dritte Übertragungsfunktion k-ter Ordnung $"H_3^k(s)"$ (ÜF3) des ersten Filtersystems (FSY1) und die vierte Übertragungsfunktion k-ter Ordnung $"H_4^k(s)"$ (ÜF4) des zweiten Filtersystems (FSY2)

c1) das zweite Ausgangssignal (ASI2), das zweite Filtersignal (FSI2) und das erste Filtersignal (FSI1) für eine asymmetrische oder symmetrische Erzeugung des Kombinationssignals (KSI) zumindest eines von beiden, additiv und subtraktiv, mit Maßgabe von $"H_3^k(s) + H_4^k(s)) = 1"$ verknüpft werden oder

c2) das zweite Ausgangssignal (ASI2), das zweite Filtersignal (FSI2), das Kompensation-Filtersignal (FSI$_K$) und das erste Filtersignal (FSI1) für eine asymmetrische und kompensatorische oder symmetrische und kompensatorische Erzeugung des Kombinationssignals (KS) zumindest eines von beiden, additiv und subtraktiv, mit Maßgabe von $"H_3^k(s) \times H_1^m(s) + H_4^k(s) \times H_2^p(s) = 1"$ verknüpft werden.

2. Verfahren nach Anspruch 1, **dadurch gekennzeichnet, dass**
für die Filter-Grenzkreisfrequenz $\omega_0$ jedes Filtersystems k-ter Ordnung (FSY1, FSY1' FSY2) in Bezug auf die erste Übertragungsfunktion m-ter Ordnung $"H_1^m(s)"$ (ÜF1) mit der ersten Grenzkreisfrequenz $\omega_{SY1}$ und die zweite Übertragungsfunktion p-ter Ordnung $"H_2^p(s)"$ (ÜF2) mit der zweiten Grenzkreisfrequenz $\omega_{SY2}$ der elektrischen Systeme (SY1, SY2) und unter der Voraussetzung, dass die m-te Ordnung gleich der p-ten Ordnung, also m=p, ist, folgender funktionaler Zusammenhang zu den Grenzkreisfrequenzen $\omega_{SY1}$, $\omega_{SY2}$ besteht:

$$\omega_0 = \sqrt{\omega_{SY1} \times \omega_{SY2}}$$

3. Verfahren nach Anspruch 2, **dadurch gekennzeichnet, dass**
auf der Basis eines Standard-Tiefpasses mit einer Verstärkung von "1" und einer Standard-Tiefpass-Übertragungsfunktion j-ter Ordnung mit Koeffizienten abhängig von einer Tiefpass-Filterapproximation, z.B. Butterworth oder Bessel,

$$"H_{TP}^j(s_n) = \frac{1}{1 + a_1 s_n + a_2 s_n^2 + \ldots + a_j s_n^j}"$$

mit $s_n = s/\omega_0$

(i) die erste Übertragungsfunktion m-ter Ordnung $"\mathbf{H}_1^m(\mathbf{s})"$ (ÜF1) des ersten elektrischen Systems (SY1),

- wenn dieses ein Tiefpass (TP) gemäß dem Standard-Tiefpass mit einer Tiefpass-Übertragungsfunktion 1. Ordnung $"\mathbf{H}_{TP}^1(\mathbf{s}_n)"$ und einer Filterapproximationsunabhängigkeit ist,

eine Übertragungsfunktion 1. Ordnung $"\mathbf{H}_1^1(\mathbf{s}_n)"$ mit der Filterapproximationsunabhängigkeit ist:

$$H_1^1(s_n) = \frac{1}{1 + s_n/\omega_{SY1,n}} = \frac{1}{1 + s_n \cdot \omega_{SY2,n}}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$,

(ii) die zweite Übertragungsfunktion p-ter Ordnung $"\mathbf{H}_2^p(\mathbf{s})"$ (ÜF2) des zweiten elektrischen Systems (SY2),

- wenn dieses ein Hochpass (HP) gemäß dem Standard-Tiefpass mit der Tiefpass-Übertragungsfunktion 1. Ordnung $"\mathbf{H}_{TP}^1(\mathbf{s}_n)"$ und der Filterapproximationsunabhängigkeit ist,

eine Übertragungsfunktion 1. Ordnung $"\mathbf{H}_2^1(\mathbf{s}_n)"$ mit der Filterapproximationsunabhängigkeit ist:

$$H_2^1(s_n) = \frac{s_n/\omega_{SY2,n}}{1 + s_n/\omega_{SY2,n}}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$.

4. Verfahren nach Anspruch 3, **dadurch gekennzeichnet, dass**
für die mit der Filterung (flt) asymmetrische Erzeugung des Kombinationssignals (KS)

a1) die dritte Übertragungsfunktion k-ter Ordnung $"\mathbf{H}_3^k(\mathbf{s})"$ (ÜF3) des ersten Filtersystems (FSY1, FSY1'),

- wenn dieses auf dem Standard-Tiefpass mit der Standard-Tiefpass-Übertragungsfunktion 1. Ordnung $"\mathbf{H}_{TP}^1(\mathbf{s}_n)"$ und der Filterapproximationsunabhängigkeit basiert,

eine erste Übertragungsfunktion 1. Ordnung $"\mathbf{H}_{3,1}^1(\mathbf{s}_n)"$ mit der Filterapproximationsunabhängigkeit ist:

$$H_{3,1}^1(s_n) = H_{TP}^1(s_n) = \frac{1}{1 + s_n}$$

mit $s_n = s/\omega_0$,

a2) die vierte Übertragungsfunktion k-ter Ordnung $"\mathbf{H}_4^k(\mathbf{s})"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem ersten Filtersystem (FSY1, FSY1') mit der dritten Übertragungsfunktion k-ter Ordnung $"\mathbf{H}_3^k(\mathbf{s})"$ (ÜF3) gebildet wird,

- wobei die Übertragungsfunktion "1" und die dritte Übertragungsfunktion k-ter Ordnung $"\mathbf{H}_3^k(s)"$ subtraktiv nach der Maßgabe $"1-\mathbf{H}_3^k(s)"$ verknüpft werden, und
- wenn das erste Filtersystem (FSY1, FSY1') mit der dritten Übertragungsfunktion k-ter Ordnung $"\mathbf{H}_3^k(s)"$ auf dem Standard-Tiefpass mit der Standard-Tiefpass-Übertragungsfunktion 1. Ordnung $"\mathbf{H}_{TP}^1(s_n)"$ und der Filterapproximationsunabhängigkeit basiert,

eine erste Übertragungsfunktion 1. Ordnung $"\mathbf{H}_{4,1}^1(s_n)"$ mit der Filterapproximationsunabhängigkeit ist:

$$\mathbf{H}_{4,1}^1(s_n) = 1 - \mathbf{H}_3^k(s_n) = 1 - \mathbf{H}_{TP}^1(s_n) = \frac{s_n}{1 + s_n}$$

mit $s_n = s/\omega_0$,
<u>oder</u>

b1) die dritte Übertragungsfunktion k-ter Ordnung $"\mathbf{H}_3^k(s)"$ (ÜF3) des ersten Filtersystems (FSY1, FSY1'),

- wenn dieses auf dem Standard-Tiefpass mit der Standard-Tiefpass-Übertragungsfunktion 2. Ordnung $"\mathbf{H}_{TP}^2(s_n)"$ und einer Butterworth-Filterapproximation basiert,

eine erste Übertragungsfunktion 2. Ordnung $"\mathbf{H}_{3,1}^2(s_n)"$ mit der Butterworth-Filterapproximation ist:

$$\mathbf{H}_{3,1}^2(s_n) = \mathbf{H}_{TP}^2(s_n) = \frac{1}{1 + a_1 s_n + a_2 s_n^2} = \frac{1}{1 + \sqrt{2}s_n + s_n^2}$$

mit $s_n = s/\omega_0$,

b2) die vierte Übertragungsfunktion k-ter Ordnung $"\mathbf{H}_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem ersten Filtersystem (FSY1, FSY1') mit der dritten Übertragungsfunktion k-ter Ordnung $"\mathbf{H}_3^k(s)"$ (ÜF3) gebildet wird,

- wobei die Übertragungsfunktion "1" und die dritte Übertragungsfunktion k-ter Ordnung $"\mathbf{H}_3^k(s)"$ subtraktiv nach der Maßgabe $"1-\mathbf{H}_3^k(s)"$ verknüpft werden, und
- wenn das erste Filtersystem (FSY1, FSY1') mit der dritten Übertragungsfunktion k-ter Ordnung $"\mathbf{H}_3^k(s)"$ auf dem Standard-Tiefpass mit der Standard-Tiefpass-Übertragungsfunktion 2. Ordnung $"\mathbf{H}_{TP}^2(s_n)"$ und der der Butterworth-Filterapproximation basiert,

eine erste Übertragungsfunktion 2. Ordnung $"\mathbf{H}_{4,1}^2(s_n)"$ mit der Butterworth-Filterapproximation ist:

$$H_{4,1}^2(s_n) = 1 - H_3^k(s_n) = 1 - H_{TP}^2(s_n) = \frac{\sqrt{2}s_n + s_n^2}{1 + \sqrt{2}s_n + s_n^2}$$

mit $s_n = s/\omega_0$,
<u>oder</u>

c1) die dritte Übertragungsfunktion k-ter Ordnung $"H_3^k(s)"$ (ÜF3) des ersten Filtersystems (FSY1, FSY1'),

- wenn dieses auf dem Standard-Tiefpass mit der Standard-Tiefpass-Übertragungsfunktion 3. Ordnung

$"H_{TP}^3(s_n)"$ und der Butterworth-Filterapproximation basiert,

eine erste Übertragungsfunktion 3. Ordnung $"H_{3,1}^3(s_n)"$ mit der Butterworth-Filterapproximation ist:

$$H_{3,1}^3(s_n) = \frac{1}{1 + a_1 s_n + a_2 s_n^2 + a_3 s_n^3} = \frac{1}{1 + 2s_n + 2s_n^2 + s_n^3}$$

mit $s_n = s/\omega_0$,

c2) die vierte Übertragungsfunktion k-ter Ordnung $"H_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem ersten Filtersystem (FSY1, FSY1') mit der dritten Übertragungsfunktion k-ter Ordnung $"H_3^k(s)"$ (ÜF3) gebildet wird,

- wobei die Übertragungsfunktion "1" und die dritte Übertragungsfunktion k-ter Ordnung $"H_3^k(s)"$ subtraktiv nach der Maßgabe $"1 - H_3^k(s)"$ verknüpft werden, und
- wenn das erste Filtersystem (FSY1, FSY1') mit der dritten Übertragungsfunktion k-ter Ordnung

$"H_3^k(s)"$ auf dem Standard-Tiefpass mit der Standard-Tiefpass-Übertragungsfunktion 3. Ordnung

$"H_{TP}^3(s_n)"$ und der der Butterworth-Filterapproximation basiert,

eine erste Übertragungsfunktion 3. Ordnung $"H_{4,1}^3(s_n)"$ mit der Butterworth-Filterapproximation ist:

$$H_{4,1}^3(s_n) = 1 - H_3^k(s_n) = 1 - H_{TP}^3(s_n) = \frac{2s_n + 2s_n^2 + s_n^3}{1 + 2s_n + 2s_n^2 + s_n^3}$$

mit $s_n = s/\omega_0$.

5. Verfahren nach Anspruch 3, **dadurch gekennzeichnet, dass**
für die mit der Filterung (flt) symmetrische Erzeugung des Kombinationssignals (KS)

a1) die dritte Übertragungsfunktion k-ter Ordnung $"H_3^k(s)"$ (ÜF3) des ersten Filtersystems (FSY1, FSY1'),

- wenn dieses auf einem Symmetrie-Tiefpass mit einer Verstärkung von "1" und einer Symmetrie-Tiefpass-Übertragungsfunktion 1. Ordnung $"H^1_{STP}(s_n)"$ mit $H^1_{STP}(s_n) = \frac{1}{1+s_n}$ und einer Filterapproximationsunabhängigkeit basiert,

eine zweite Übertragungsfunktion 1. Ordnung $"H^1_{3,2}(s_n)"$ mit der Filterapproximationsunabhängigkeit ist:

$$H^1_{3,2}(s_n) = \frac{1}{1 + s_n}$$

mit $s_n = s/(\omega_0$,

a2) die vierte Übertragungsfunktion k-ter Ordnung $"H^k_4(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem ersten Filtersystem (FSY1, FSY1') mit der dritten Übertragungsfunktion k-ter Ordnung $"H^k_3(s_n)"$ (ÜF3) oder aus dem ersten Filtersystem (FSY1, FSY1') mit der dritten Übertragungsfunktion k-ter Ordnung $"H^k_3\left(s_n \to \frac{1}{s_n}\right)"$ (ÜF3) gebildet wird,

- wobei die Übertragungsfunktion "1" und die dritte Übertragungsfunktion k-ter Ordnung $"H^k_3(s)"$ subtraktiv nach der Maßgabe $"1 - H^k_3(s)"$ verknüpft werden, und

- wenn das erste Filtersystem (FSY1, FSY1') mit der dritten Übertragungsfunktion k-ter Ordnung $"H^k_3(s)"$ auf dem Symmetrie-Tiefpass mit der Symmetrie-Tiefpass-Übertragungsfunktion 1. Ordnung $"H^1_{STP}(s_n)"$ mit $H^1_{STP}(s_n) = \frac{1}{1+s_n}$ und der Filterapproximationsunabhängigkeit basiert,

eine zweite Übertragungsfunktion 1. Ordnung $"H^1_{4,2}(s_n)"$ mit der Filterapproximationsunabhängigkeit ist:

$$H^1_{4,2}(s_n) = 1 - H^k_3(s_n) = H^k_3\left(s_n \to \frac{1}{s_n}\right) = 1 - H^1_{STP}(s_n) = \frac{1}{1 + s_n}$$

mit $s_n = s/(\omega_0$,
<u>oder</u>

b1) die dritte Übertragungsfunktion k-ter Ordnung $"H^k_3(s)"$ (ÜF3) des ersten Filtersystems (FSY1, FSY1'),

- wenn dieses auf einem Symmetrie-Tiefpass mit einer Verstärkung von "1" und einer Symmetrie-Tiefpass-Übertragungsfunktion 3. Ordnung $"H^3_{STP}(s_n)"$ mit $H^3_{STP}(s_n) = \frac{1 + as_n}{1 + as_n + as_n^2 + s_n^3}$ und einem Koeffizienten "a=3" als dreifache Polstelle basiert,

eine zweite Übertragungsfunktion 3. Ordnung $"H^3_{3,2}(s_n)"$ mit dem Koeffizienten "a=3" als dreifache Polstelle ist:

$$H_{3,2}^3(s_n) = \frac{1 + as_n}{1 + as_n + as_n^2 + s_n^3}$$

mit $s_n = s/(\omega_0$,

b2) die vierte Übertragungsfunktion k-ter Ordnung $"H_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem ersten Filtersystem (FSY1, FSY1') mit der dritten Übertragungsfunktion k-ter Ordnung $"H_3^k(s_n)"$ (ÜF3) oder aus dem ersten Filtersystem (FSY1, FSY1')

mit einer dritten Übertragungsfunktion k-ter Ordnung $"H_3^k\left(s_n \to \frac{1}{s_n}\right)"$ (ÜF3) gebildet wird,

- wobei die Übertragungsfunktion "1" und die dritte Übertragungsfunktion k-ter Ordnung $"H_3^k(s)"$ subtraktiv nach der Maßgabe $"1 - H_3^k(s)"$ verknüpft werden, und
- wenn das erste Filtersystem (FSY1, FSY1') mit der dritten Übertragungsfunktion k-ter Ordnung $"H_3^k(s)"$ auf dem Symmetrie-Tiefpass mit einer Symmetrie-Tiefpass-Übertragungsfunktion 3. Ordnung

$"H_{STP}^3(s_n)"$ mit $H_{STP}^3(s_n) = \frac{1 + as_n}{1 + as_n + as_n^2 + s_n^3}$ und dem Koeffizienten "a=3" als dreifache Polstelle basiert,

eine zweite Übertragungsfunktion 3. Ordnung $"H_4^3(s_n)"$ mit dem Koeffizienten "a=3" als dreifache Polstelle ist:

$$H_{4,2}^3(s_n) = 1 - H_3^k(s_n) = H_3^k\left(s_n \to \frac{1}{s_n}\right) = 1 - H_{STP}^3(s_n) = \frac{as_n^2 + s_n^3}{1 + as_n + as_n^2 + s_n^3}$$

mit $s_n = s/(\omega_0$,

c1) die dritte Übertragungsfunktion k-ter Ordnung $"H_3^k(s)"$ (ÜF3) des ersten Filtersystems (FSY1, FSY1'),

- wenn dieses auf einem Symmetrie-Tiefpass mit einer Verstärkung von "1" und einer Symmetrie-Tiefpass-Übertragungsfunktion 5. Ordnung $"H_{STP}^5(s_n)"$ mit $H_{STP}^5(s_n) = \frac{1 + a_1 s_n + a_2 s_n^2}{1 + a_1 s_n + a_2 s_n^2 + a_2 s_n^3 + a_1 s_n^4 + s_n^5}$

und Koeffizienten "$a_1 = 15,19$" und $"a_2 = \frac{a_1^2}{4}"$ basiert,

eine erste Übertragungsfunktion 5. Ordnung $"H_{3,1}^5(s_n)"$ mit den Koeffizienten ""$a_1 = 15,19$" und $"a_2 = \frac{a_1^2}{4}"$ ist:

$$H_{3,1}^5(s_n) = \frac{1 + a_1 s_n + a_2 s_n^2}{1 + a_1 s_n + a_2 s_n^2 + a_2 s_n^3 + a_1 s_n^4 + s_n^5}$$

mit $s_n = s/(\omega_0$,

c2) die vierte Übertragungsfunktion k-ter Ordnung $"H_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem ersten Filtersystem (FSY1, FSY1') mit der dritten Übertragungsfunktion k-ter Ordnung $"H_3^k(s_n)"$ (ÜF3) oder aus dem ersten Filtersystem (FSY1, FSY1')

mit einer dritten Übertragungsfunktion k-ter Ordnung $"H_3^k\left(s_n \to \dfrac{1}{s_n}\right)"$ (ÜF3) gebildet wird,

- wobei die Übertragungsfunktion "1" und die dritte Übertragungsfunktion k-ter Ordnung $"H_3^k(s)"$ subtraktiv nach der Maßgabe $"1-H_3^k(s)"$ verknüpft werden, und
- wenn das erste Filtersystem (FSY1, FSY1') mit der dritten Übertragungsfunktion k-ter Ordnung $"H_3^k(s)"$ auf dem Symmetrie-Tiefpass mit einer Symmetrie-Tiefpass-Übertragungsfunktion 5. Ordnung

$"H_{STP}^5(s_n)"$ mit $H_{STP}^5(s_n) = \dfrac{1+a_1 s_n + a_2 s_n^2}{1+a_1 s_n + a_2 s_n^2 + a_2 s_n^3 + a_1 s_n^4 + s_n^5}$ und den Koeffizienten "$a_1$=15,19" und

$"a_2 = \dfrac{a_1^2}{4}"$ basiert,

eine zweite Übertragungsfunktion 5. Ordnung $"H_{4,2}^5(s_n)"$ mit den Koeffizienten "$a_1$=15,19" und

$"a_2 = \dfrac{a_1^2}{4}"$ ist:

$$H_{4,2}^5(s_n) = 1 - H_3^k(s_n) = H_3^k\left(s_n \to \frac{1}{s_n}\right) = 1 - H_{STP}^5(s_n)$$

$$= \frac{a_2 s_n^3 + a_1 s_n^4 + s_n^5}{1 + a_1 s_n + a_2 s_n^2 + a_2 s_n^3 + a_1 s_n^4 + s_n^5}$$

mit $s_n = s/\omega_0$.

6. Verfahren nach Anspruch 3, **dadurch gekennzeichnet, dass**
für die mit der Filterung (flt) asymmetrische und kompensatorische Erzeugung des Kombinationssignals (KS)

a1) die dritte Übertragungsfunktion k-ter Ordnung $"H_3^k(s)"$ (ÜF3) des ersten Filtersystems (FSY1, FSY1'),

- wenn dieses auf dem Standard-Tiefpass mit der Standard-Tiefpass-Übertragungsfunktion 1. Ordnung $"H_{TP}^1(s_n)"$ und der Filterapproximationsunabhängigkeit basiert, und
- das aus einem multiplikative Produkt von der Standard-Tiefpass-Übertragungsfunktion 1. Ordnung $"H_{TP}^1(s_n)"$ und aus einer Inversen $"1/H_1^1(s_n)"$ der Übertragungsfunktion 1. Ordnung $"H_1^1(s_n)"$ des Tiefpasses (TP) als das erste elektrische System (SY1) ist,

eine dritte Übertragungsfunktion 1. Ordnung $"H_{3,3}^1(s_n)"$ mit der der Filterapproximationsunabhängigkeit ist:

$$H_{3,3}^1(s_n) = \frac{H_{TP}^1(s_n)}{H_1^1(s_n)} = \frac{\omega_{SY2,n}s_n + 1}{s_n + 1}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$,

a2) die vierte Übertragungsfunktion k-ter Ordnung $"H_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem Standard-Tiefpass mit der Standard-Tiefpass-Übertragungsfunktion 1. Ordnung $"H_{TP}^1(s_n)"$ und der Filterapproximationsunabhängigkeit gebildet wird,
- wobei die Übertragungsfunktion "1" und die Standard-Tiefpass-Übertragungsfunktion 1. Ordnung $"H_{TP}^1(s_n)"$ subtraktiv nach der Maßgabe $"1-H_{TP}^1(s_n)"$ verknüpft werden, und
- die Verknüpfung aus der Übertragungsfunktion "1" und der Standard-Tiefpass-Übertragungsfunktion 1. Ordnung $"H_{TP}^1(s_n)"$ mit einer Inversen $"1/H_2^1(s_n)"$ der Übertragungsfunktion 1. Ordnung $"H_2^1(s_n)"$ des Hochpasses (HP) als das zweite elektrische System (SY2) multipliziert wird,

eine dritte Übertragungsfunktion 1. Ordnung $"H_{4,3}^1(s_n)"$ mit der Filterapproximationsunabhängigkeit ist:

$$H_{4,3}^1(s_n) = \frac{1 - H_{TP}^1(s_n)}{H_2^1(s_n)} = \frac{\omega_{SY2,n} + s_n}{s_n + 1}$$

mit $s_n = s/\omega_0$, $\omega_{SY1,n} = \omega_{SY1}/\omega_0$, $\omega_{SY1,n} = \omega_{SY2}/\omega_0$, $\omega_{SY1,n} = 1/\omega_{SY2,n}$,

a3) die fünfte Übertragungsfunktion $"H_5(s)"$ (ÜF5) des zweiten Filtersystems (FSY2),

- das aus dem multiplikativen Produkt von der Standard-Tiefpass-Übertragungsfunktion 1. Ordnung $"H_{TP}^1(s_n)"$ mit der Filterapproximationsunabhängigkeit und der Inversen $"1/H_1^1(s_n)"$ der Übertragungsfunktion 1. Ordnung $"H_1^1(s_n)"$ des Tiefpasses (TP) als das erste elektrische System (SY1) gebildet wird,
- das aus dem in dem zweiten Filtersystem (FSY2) eins-zu-eins übertragenen, zweiten Ausgangssignal (ASI2) mit der Übertragungsfunktion "1" und aus dem Standard-Tiefpass mit der Standard-Tiefpass-Übertragungsfunktion 1. Ordnung $"H_{TP}^1(s_n)"$ und der Filterapproximationsunabhängigkeit, wobei die Übertragungsfunktion "1" und die Standard-Tiefpass-Übertragungsfunktion 1. Ordnung $"H_{TP}^1(s_n)"$ subtraktiv nach der Maßgabe $"1-H_{TP}^1(s_n)"$ verknüpft werden und wobei die Verknüpfung aus der Übertragungsfunktion "1" und der Standard-Tiefpass-Übertragungsfunktion 1. Ordnung $"H_{TP}^1(s_n)"$ mit der Inversen $"1/H_2^1(s_n)"$ der Übertragungsfunktion 1. Ordnung $"H_2^1(s_n)"$ des Hochpasses (HP) als das zweite elektrische System (SY2) multipliziert wird, gebildet wird,
- wobei das multiplikative Produkt und das Multiplikationsprodukt aus der Verknüpfung und der Inversen

$"1/H_2^1(s_n)"$ der Übertragungsfunktion 1. Ordnung $"H_2^1(s_n)"$ addiert werden, und

- wobei von einer durch die Addition gebildeten Summe das in dem zweiten Filtersystem (FSY2) eins-zu-eins übertragene, zweite Ausgangssignal (ASI2) mit der Übertragungsfunktion "1" subtrahiert wird,

eine erste Übertragungsfunktion $"H_{5,1u}(s_n)"$ mit der Filterapproximationsunabhängigkeit ist:

$$H_{5,1u}(s_n) = \frac{H_{TP}^1(s_n)}{H_1^1(s_n)} + \frac{1 - H_{TP}^1(s_n)}{H_2^1(s_n)} - 1 = \omega_{SY2,n}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, u=: $H_5$ ist 1. Ordnung-basiert, oder

b1) die dritte Übertragungsfunktion k-ter Ordnung $"H_3^k(s)"$ (ÜF3) des ersten Filtersystems (FSY1, FSY1'),

- wenn dieses auf dem Standard-Tiefpass mit der Standard-Tiefpass-Übertragungsfunktion 2. Ordnung $"H_{TP}^2(s_n)"$ und einer Butterworth-Filterapproximation und einem Koeffizienten $"a = \sqrt{2}"$ basiert, und
- das aus einem multiplikative Produkt von der Standard-Tiefpass-Übertragungsfunktion 2. Ordnung $"H_{TP}^2(s_n)"$ und einer Inversen $"1/H_1^1(s_n)"$ der Übertragungsfunktion 1. Ordnung $"H_1^1(s_n)"$ des Tiefpasses (TP) als das erste elektrische System (SY1) ist,

eine zweite Übertragungsfunktion 2. Ordnung $"H_{3,2}^2(s_n)"$ mit der Butterworth-Filterapproximation und dem Koeffizienten $"a = \sqrt{2}"$ ist:

$$H_{3,2}^2(s_n) = \frac{H_{TP}^2(s_n)}{H_1^1(s_n)} = \frac{\omega_{SY2,n}s_n + 1}{1 + as_n + s_n^2}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$,

b2) die vierte Übertragungsfunktion k-ter Ordnung $"H_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem Standard-Tiefpass mit der Standard-Tiefpass-Übertragungsfunktion 2. Ordnung $"H_{TP}^2(s_n)"$, der Butterworth-Filterapproximation und dem Koeffizienten $"a = \sqrt{2}"$ gebildet wird,
- wobei die Übertragungsfunktion "1" und die Standard-Tiefpass-Übertragungsfunktion 2. Ordnung $"H_{TP}^2(s_n)"$ subtraktiv nach der Maßgabe $"1 - H_{TP}^2(s_n)"$ verknüpft werden, und
- die Verknüpfung aus der Übertragungsfunktion "1" und der Standard-Tiefpass-Übertragungsfunktion 2. Ordnung $"H_{TP}^2(s_n)"$ mit einer Inversen $"1/H_2^1(s_n)"$ der Übertragungsfunktion 1. Ordnung $"H_2^1(s_n)"$ des Hochpasses (HP) als das zweite elektrische System (SY2) multipliziert wird,

eine zweite Übertragungsfunktion 2. Ordnung $"H_{4,2}^2(s_n)"$ mit der Butterworth-Filterapproximation und dem Koeffizienten $"a = \sqrt{2}"$ ist:

$$H_{4,2}^2(s_n) = \frac{1 - H_{TP}^2(s_n)}{H_2^1(s_n)} = \frac{s_n^2 + (a + \omega_{SY2,n})s_n + a\omega_{SY2,n}}{1 + as_n + s_n^2}$$

mit $s_n = s/\omega_0$, $\omega_{SY1,n} = \omega_{SY1}/\omega_0$, $\omega_{SY1,n} = \omega_{SY2}/\omega_0$, $\omega_{SY1,n} = 1/\omega_{SY2,n}$,

b3) die fünfte Übertragungsfunktion $"H_5(s)"$ (ÜF5) des zweiten Filtersystems (FSY2),

- das aus dem multiplikativen Produkt von der Standard-Tiefpass-Übertragungsfunktion 2. Ordnung $"H_{TP}^2(s_n)"$ mit der der Butterworth-Filterapproximation und dem Koeffizienten $"a = \sqrt{2}"$ und der Inversen $"1/H_1^1(s_n)"$ der Übertragungsfunktion 1. Ordnung $"H_1^1(s_n)"$ des Tiefpasses (TP) als das erste elektrische System (SY1) gebildet wird,
- das aus dem in dem zweiten Filtersystem (FSY2) eins-zu-eins übertragenen, zweiten Ausgangssignal (ASI2) mit der Übertragungsfunktion "1" und aus dem Standard-Tiefpass mit der Standard-Tiefpass-Übertragungsfunktion 2. Ordnung $"H_{TP}^2(s_n)"$, der Butterworth-Filterapproximation und dem Koeffizienten $"a = \sqrt{2}"$, wobei die Übertragungsfunktion "1" und die Standard-Tiefpass-Übertragungsfunktion 2. Ordnung $"H_{TP}^2(s_n)"$ subtraktiv nach der Maßgabe "1- $"H_{TP}^2(s_n)"$ verknüpft werden und wobei die Verknüpfung aus der Übertragungsfunktion "1" und der Standard-Tiefpass-Übertragungsfunktion 2. Ord-nung $"H_{TP}^2(s_n)"$ mit der Inversen $"1/H_2^1(s_n)"$ der Übertragungsfunktion 1. Ordnung $"H_2^1(s_n)"$ des Hochpasses (HP) als das zweite elektrische System (SY2) multipliziert wird, gebildet wird,
- wobei das multiplikative Produkt und das Multiplikationsprodukt aus der Verknüpfung und der Inversen $"1/H_2^1(s_n)"$ der Übertragungsfunktion 1. Ordnung $"H_2^1(s_n)"$ addiert werden, und
- wobei von einer durch die Addition gebildeten Summe das in dem zweiten Filtersystem (FSY2) eins-zu-eins übertragene, zweite Ausgangssignal (ASI2) mit der Übertragungsfunktion "1" subtrahiert wird, eine zweite Übertragungsfunktion $"H_{5,2v}(s_n)"$ mit der Butterworth-Filterapproximation und dem Koeffizienten $"a = \sqrt{2}"$ ist:

$$H_{5,2v}(s_n) = \frac{H_{TP}^2(s_n)}{H_1^1(s_n)} + \frac{1 - H_{TP}^2(s_n)}{H_2^1(s_n)} - 1 = \frac{2\omega_{SY2,n}s_n + \omega_{SY2,n}a}{1 + as_n + s_n^2}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, v=: $H_5$ ist 2. Ordnung-basiert, oder

c1) die dritte Übertragungsfunktion k-ter Ordnung $"H_3^k(s)"$ (ÜF3) des ersten Filtersystems (FSY1, FSY1'),

- wenn dieses auf dem Standard-Tiefpass mit der Standard-Tiefpass-Übertragungsfunktion 3. Ordnung

$"H_{TP}^3(s_n)"$ und einer Butterworth-Filterapproximation und einem Koeffizienten = 2" basiert, und

- das aus einem multiplikative Produkt von der Standard-Tiefpass-Übertragungsfunktion 3. Ordnung $"H_{TP}^3(s_n)"$ und einer Inversen $"1/H_1^1(s_n)"$ der Übertragungsfunktion 1. Ordnung $"H_1^1(s_n)"$ des Tiefpasses (TP) als das erste elektrische System (SY1) ist,

eine dritte Übertragungsfunktion 3. Ordnung $"H_{3,2}^2(s_n)"$ mit der Butterworth-Filterapproximation und dem Koeffizienten = 2" ist:

$$H_{3,3}^3(s_n) = \frac{H_{TP}^2(s_n)}{H_1^1(s_n)} = \frac{\omega_{SY2,n}s_n + 1}{1 + as_n + as_n^2 + s_n^3}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$,

c2) die vierte Übertragungsfunktion k-ter Ordnung $"H_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem Standard-Tiefpass mit der Standard-Tiefpass-Übertragungsfunktion 3. Ordnung $"H_{TP}^3(s_n)"$, der Butterworth-Filterapproximation und dem Koeffizienten = 2" gebildet wird,
- wobei die Übertragungsfunktion "1" und die Standard-Tiefpass-Übertragungsfunktion 3. Ordnung $"H_{TP}^3(s_n)"$ subtraktiv nach der Maßgabe $"1-H_{TP}^3(s_n)"$ verknüpft werden, und
- die Verknüpfung aus der Übertragungsfunktion "1" und der Standard-Tiefpass-Übertragungsfunktion 3. Ordnung $"H_{TP}^3(s_n)"$ mit einer Inversen $"1/H_2^1(s_n)"$ der Übertragungsfunktion 1. Ordnung $"H_2^1(s_n)"$ des Hochpasses (HP) als das zweite elektrische System (SY2) multipliziert wird,

eine dritte Übertragungsfunktion 3. Ordnung $"H_{4,3}^3(s_n)"$ mit der Butterworth-Filterapproximation und dem Koeffizienten = 2" ist:

$$H_{4,3}^3(s_n) = \frac{1 - H_{TP}^3(s_n)}{H_2^1(s_n)} = \frac{s_n^3 + (a + \omega_{SY2,n})s_n^2 + (\omega_{SY2,n} + 1)as_n + \omega_{SY2,n}a}{1 + as_n + as_n^2 + s_n^3}$$

mit $s_n = s/\omega_0$, $\omega_{SY1,n} = \omega_{SY1}/\omega_0$, $\omega_{SY1,n} = \omega_{SY2}/\omega_0$, $\omega_{SY1,n} = 1/\omega_{SY2,n}$,

c3) die fünfte Übertragungsfunktion "$H_5(s)$" (ÜF5) des zweiten Filtersystems (FSY2),

- das aus dem multiplikativen Produkt von der Standard-Tiefpass-Übertragungsfunktion 3. Ordnung $"H_{TP}^3(s_n)"$ mit der der Butterworth-Filterapproximation und dem Koeffizienten = 2" und der Inversen $"1/H_1^1(s_n)"$ der Übertragungsfunktion 1. Ordnung $"H_1^1(s_n)"$ des Tiefpasses (TP) als das erste elektrische System (SY1) gebildet wird,

- das aus dem in dem zweiten Filtersystem (FSY2) eins-zu-eins übertragenen, zweiten Ausgangssignal (ASI2) mit der Übertragungsfunktion "1" und aus dem Standard-Tiefpass mit der Standard-Tiefpass-Über-

tragungsfunktion 3. Ordnung $"\mathbf{H}_{TP}^3(s_n)"$, der Butterworth-Filterapproximation und dem Koeffizienten = 2", wobei die Übertragungsfunktion "1" und die Standard-Tiefpass-Übertragungsfunktion 3. Ordnung $"\mathbf{H}_{TP}^3(s_n)"$ subtraktiv nach der Maßgabe $"1-\mathbf{H}_{TP}^3(s_n)"$ verknüpft werden und wobei die Verknüpfung aus der Übertragungsfunktion "1" und der Standard-Tiefpass-Übertragungsfunktion 3. Ordnung $"\mathbf{H}_{TP}^3(s_n)"$ mit der Inversen $"1/\mathbf{H}_2^1(s_n)"$ der Übertragungsfunktion 1. Ordnung $"\mathbf{H}_2^1(s_n)"$ des Hochpasses (HP) als das zweite elektrische System (SY2) multipliziert wird, gebildet wird,
- wobei das multiplikative Produkt und das Multiplikationsprodukt aus der Verknüpfung und der Inversen $"1/\mathbf{H}_2^1(s_n)"$ der Übertragungsfunktion 1. Ordnung $"\mathbf{H}_2^1(s_n)"$ addiert werden, und
- wobei von einer durch die Addition gebildeten Summe das in dem zweiten Filtersystem (FSY2) eins-zu-eins übertragene, zweite Ausgangssignal (ASI2) mit der Übertragungsfunktion "1" subtrahiert wird,

eine dritte Übertragungsfunktion $"\mathbf{H}_{5,3w}(s_n)"$ mit der Butterworth-Filterapproximation und dem Koeffizienten = 2" ist:

$$H_{5,3w}(s_n) = \frac{H_{TP}^3(s_n)}{H_1^1(s_n)} + \frac{1 - H_{TP}^3(s_n)}{H_2^1(s_n)} - 1 = \frac{\omega_{SY2,n}s_n + \omega_{SY2,n}a}{1 + (a-1)s_n + s_n^2}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, w=: $H_5$ ist 3. Ordnung-basiert.

7. Verfahren nach Anspruch 3, **dadurch gekennzeichnet, dass**
für die mit der Filterung (flt) symmetrische und kompensatorische Erzeugung des Kombinationssignals (KS)

a1) die dritte Übertragungsfunktion k-ter Ordnung $"\mathbf{H}_3^k(s)"$ (ÜF3) des ersten Filtersystems (FSY1, FSY1'),

- wenn dieses auf einem Symmetrie-Tiefpass mit einer Verstärkung von "1" und einer Symmetrie-Tiefpass-Übertragungsfunktion 1. Ordnung $"\mathbf{H}_{STP}^1(s_n)"$ mit $H_{STP}^1(s_n) = \frac{1}{1+s_n}$ und einer Filterapproximationsunabhängigkeit basiert, und
- das aus einem multiplikative Produkt von der Symmetrie-Tiefpass-Übertragungsfunktion 1. Ordnung $"\mathbf{H}_{STP}^1(s_n)"$ und einer Inversen $"1/\mathbf{H}_1^1(s_n)"$ der Übertragungsfunktion 1. Ordnung $"\mathbf{H}_1^1(s_n)"$ des Tiefpasses (TP) als das erste elektrische System (SY1) gebildet wird,

eine vierte Übertragungsfunktion 1. Ordnung $"\mathbf{H}_{3,4}^1(s_n)"$ mit der Filterapproximationsunabhängigkeit ist:

$$H_{3,4}^1(s_n) = \frac{H_{STP}^1(s_n)}{H_1^1(s_n)} = \frac{\omega_{SY2,n}s_n + 1}{s_n + 1}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$,

a2) die vierte Übertragungsfunktion k-ter Ordnung $"\mathbf{H}_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem Symmetrie-Tiefpass mit der Symmetrie-Tiefpass-Übertragungsfunktion 1. Ordnung $"H_{STP}^1(s_n)"$ mit $H_{STP}^1(s_n) = \dfrac{1}{1+s_n}$ und der Filterapproximationsunabhängigkeit oder aus dem Symmetrie-Tiefpass mit der Symmetrie-Tiefpass-Übertragungsfunktion 1. Ordnung $"H_{STP}^1\left(s_n \to \dfrac{1}{s_n}\right)"$ mit $H_{STP}^1\left(s_n \to \dfrac{1}{s_n}\right) = \dfrac{s_n}{s_n+1}$ und der Filterapproximationsunabhängigkeit gebildet wird,

- wobei die Übertragungsfunktion "1" und die Symmetrie-Tiefpass-Übertragungsfunktion 1. Ordnung $"H_{STP}^1(s_n)"$ subtraktiv nach der Maßgabe $"1-H_{STP}^1(s_n)"$ verknüpft werden, und

- die Verknüpfung aus der Übertragungsfunktion "1" und der Symmetrie-Tiefpass-Übertragungsfunktion 1. Ordnung $"H_{STP}^1(s_n)"$ mit einer Inversen $"1/H_2^1(s_n)"$ der Übertragungsfunktion 1. Ordnung $"H_2^1(s_n)"$ des Hochpasses (HP) als das zweite elektrische System (SY2) multipliziert wird,

eine vierte Übertragungsfunktion 1. Ordnung $"H_{4,4}^1(s_n)"$ mit der Filterapproximationsunabhängigkeit ist:

$$H_{4,4}^1(s_n) = \frac{1 - H_{STP}^1(s_n)}{H_2^1(s_n)} = \frac{H_{STP}^1\left(s_n \to \dfrac{1}{s_n}\right)}{H_2^1(s_n)} = \frac{\omega_{SY2,n} + s_n}{s_n + 1}$$

mit $s_n = s/\omega_0$, $\omega_{SY1,n} = \omega_{SY1}/\omega_0$, $\omega_{SY1,n} = \omega_{SY2}/\omega_0$, $\omega_{SY1,n} = 1/\omega_{SY2,n}$,

a3) die fünfte Übertragungsfunktion "$H_5(s)$" (ÜF5) des zweiten Filtersystems (FSY2),

- das aus dem multiplikativen Produkt von der Symmetrie-Tiefpass-Übertragungsfunktion 1. Ordnung $"H_{STP}^1(s_n)"$ mit der Filterapproximationsunabhängigkeit und der Inversen $"1/H_1^1(s_n)"$ der Übertragungsfunktion 1. Ordnung $"H_1^1(s_n)"$ des Tiefpasses (TP) als das erste elektrische System (SY1) gebildet wird,

- das aus dem in dem zweiten Filtersystem (FSY2) eins-zu-eins übertragenen, zweiten Ausgangssignal (ASI2) mit der Übertragungsfunktion "1" und aus dem Symmetrie-Tiefpass mit der Symmetrie-Tiefpass-Übertragungsfunktion 1. Ordnung $"H_{STP}^1(s_n)"$ und der Filterapproximationsunabhängigkeit, wobei die Übertragungsfunktion "1" und die Symmetrie-Tiefpass-Übertragungsfunktion 1. Ordnung $"H_{STP}^1(s_n)"$ subtraktiv nach der Maßgabe $"1-H_{STP}^1(s_n)"$ verknüpft werden und wobei die Verknüpfung aus der Übertragungsfunktion "1" und der Symmetrie-Tiefpass-Übertragungsfunktion 1. Ordnung $"H_{STP}^1(s_n)"$ mit der Inversen $"1/H_2^1(s_n)"$ der Übertragungsfunktion 1. Ordnung $"H_2^1(s_n)"$ des Hochpasses (HP) als das zweite elektrische System (SY2) multipliziert wird, gebildet wird,

- wobei das multiplikative Produkt und das Multiplikationsprodukt aus der Verknüpfung und der Inversen $"1/H_2^1(s_n)"$ der Übertragungsfunktion 1. Ordnung $"H_2^1(s_n)"$ addiert werden, und

- wobei von einer durch die Addition gebildeten Summe das in dem zweiten Filtersystem (FSY2) eins-zu-eins übertragene, zweite Ausgangssignal (ASI2) mit der Übertragungsfunktion "1" subtrahiert wird,

eine vierte Übertragungsfunktion $"H_{5,4u}(s_n)"$ mit der Filterapproximationsunabhängigkeit ist:

$$H_{5,4u}(s_n) = \frac{H_{STP}^1(s_n)}{H_1^1(s_n)} + \frac{1 - H_{STP}^1(s_n)}{H_2^1(s_n)} - 1 = \omega_{SY2,n}$$

mit $s_n = s/\omega_0$, $\omega_{SY1,n} = \omega_{SY1}/\omega_0$, $\omega_{SY1,n} = \omega_{SY2}/\omega_0$, $\omega_{SY1,n} = 1/\omega_{SY2,n}$, u=: $H_5$ ist 1. Ordnung-basiert,
<u>oder</u>

b1) die dritte Übertragungsfunktion k-ter Ordnung $"H_3^k(s)"$ (ÜF3) des ersten Filtersystems (FSY1, FSY1'),

- wenn dieses auf einem Symmetrie-Tiefpass mit einer Verstärkung von "1" und einer Symmetrie-Tiefpass-Übertragungsfunktion 3. Ordnung $"H_{STP}^3(s_n)"$ mit $H_{STP}^3(s_n) = \frac{1+as_n}{1+as_n+as_n^2+s_n^3}$ und einem Koeffizienten "a=3" als dreifache Polstelle basiert, und
- das aus einem multiplikative Produkt von der Symmetrie-Tiefpass-Übertragungsfunktion 3. Ordnung $"H_{STP}^3(s_n)"$ und einer Inversen $"1/H_1^1(s_n)"$ der Übertragungsfunktion 1. Ordnung $"H_1^1(s_n)"$ des Tiefpasses (TP) als das erste elektrische System (SY1) gebildet wird,

eine vierte Übertragungsfunktion 3. Ordnung $"H_{3,4}^3(s_n)"$ mit dem Koeffizienten "a=3" als dreifache Polstelle ist:

$$H_{3,4}^3(s_n) = \frac{H_{STP}^3(s_n)}{H_1^1(s_n)} = \frac{1 + (a + \omega_{SY2,n})s_n + a\omega_{SY2,n}s_n^2}{1 + as_n + as_n^2 + s_n^3}$$

mit $s_n = s/\omega_0$, $\omega_{SY1,n} = \omega_{SY1}/\omega_0$, $\omega_{SY1,n} = \omega_{SY2}/\omega_0$, $\omega_{SY1,n} = 1/\omega_{SY2,n}$,

b2) die vierte Übertragungsfunktion k-ter Ordnung $"H_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem Symmetrie-Tiefpass mit der Symmetrie-Tiefpass-Übertragungsfunktion 3. Ordnung $"H_{STP}^3(s_n)"$ mit $H_{STP}^3(s_n) = \frac{1+as_n}{1+as_n+as_n^2+s_n^3}$ und dem Koeffizienten "a=3" als dreifache Polstelle oder aus dem Symmetrie-Tiefpass mit der Symmetrie-Tiefpass-Übertragungsfunktion 3. Ordnung $"H_{STP}^3\left(s_n \rightarrow \frac{1}{s_n}\right)"$ mit $H_{STP}^3\left(s_n \rightarrow \frac{1}{s_n}\right) = \frac{1+a\frac{1}{s_n}}{1+a\frac{1}{s_n}+a\frac{1}{s_n^2}+\frac{1}{s_n^3}}$ und dem Koeffizienten "a=3" als dreifache Polstellegebildet wird,

- wobei die Übertragungsfunktion "1" und die Symmetrie-Tiefpass-Übertragungsfunktion 3. Ordnung $"H_{STP}^3(s_n)"$ subtraktiv nach der Maßgabe $"1-H_{STP}^3(s_n)"$ verknüpft werden, und
- die Verknüpfung aus der Übertragungsfunktion "1" und der Symmetrie-Tiefpass-Übertragungsfunktion 3. Ordnung $"H_{STP}^3(s_n)"$ oder die Symmetrie-Tiefpass-Übertragungsfunktion 3. Ordnung $"H_{STP}^3\left(s_n \rightarrow \frac{1}{s_n}\right)"$ mit einer Inversen $"1/H_2^1(s_n)"$ der Übertragungsfunktion 1. Ordnung $"H_2^1(s_n)"$ des Hochpasses (HP) als das zweite elektrische System (SY2) multipliziert wird,

eine vierte Übertragungsfunktion 3. Ordnung $"H_{4,4}^3(s_n)"$ mit dem Koeffizienten "a=3" als dreifache Polstelle ist:

$$H_{4,4}^3(s_n) = \frac{1 - H_{STP}^3(s_n)}{H_2^1(s_n)} = \frac{H_{STP}^3\left(s_n \to \frac{1}{s_n}\right)}{H_2^1(s_n)} = \frac{a\omega_{SY2,n}s_n + \left(a + \omega_{SY2,n}\right)s_n^2 + s_n^3}{1 + as_n + as_n^2 + s_n^3}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$,

b3) die fünfte Übertragungsfunktion "$H_5(s)$" (ÜF5) des zweiten Filtersystems (FSY2),

- das aus dem multiplikativen Produkt von der Symmetrie-Tiefpass-Übertragungsfunktion 3. Ordnung $"H_{STP}^3(s_n)"$ mit dem Koeffizienten "a=3" als dreifache Polstelle und der Inversen $"1/H_1^1(s_n)"$ der Übertragungsfunktion 1. Ordnung $"H_1^1(s_n)"$ des Tiefpasses (TP) als das erste elektrische System (SY1) gebildet wird,
- das aus dem in dem zweiten Filtersystem (FSY2) eins-zu-eins übertragenen, zweiten Ausgangssignal (ASI2) mit der Übertragungsfunktion "1" und aus dem Symmetrie-Tiefpass mit der Symmetrie-Tiefpass-Übertragungsfunktion 3. Ordnung $"H_{STP}^3(s_n)"$ und dem Koeffizienten "a=3" als dreifache Polstelle, wobei die Übertragungsfunktion "1" und die Symmetrie-Tiefpass-Übertragungsfunktion 3. Ordnung $"H_{STP}^3(s_n)"$ subtraktiv nach der Maßgabe $"1-H_{STP}^3(s_n)"$ verknüpft werden und wobei die Verknüpfung aus der Übertragungsfunktion "1" und der Symmetrie-Tiefpass-Übertragungsfunktion 3. Ordnung $"H_{STP}^3(s_n)"$ mit der Inversen $"1/H_2^1(s_n)"$ der Übertragungsfunktion 1. Ordnung $"H_2^1(s_n)"$ des Hochpasses (HP) als das zweite elektrische System (SY2) multipliziert wird, gebildet wird,
- wobei das multiplikative Produkt und das Multiplikationsprodukt aus der Verknüpfung und der Inversen $"1/H_2^1(s_n)"$ der Übertragungsfunktion 1. Ordnung $"H_2^1(s_n)"$ addiert werden, und
- wobei von einer durch die Addition gebildeten Summe das in dem zweiten Filtersystem (FSY2) eins-zu-eins übertragene, zweite Ausgangssignal (ASI2) mit der Übertragungsfunktion "1" subtrahiert wird, eine fünfte Übertragungsfunktion "$H_{5,5w}(s_n)$" mit dem Koeffizienten "a=3" als dreifache Polstelle ist:

$$H_{5,5w}(s_n) = \frac{H_{STP}^3(s_n)}{H_1^1(s_n)} + \frac{1 - H_{STP}^3(s_n)}{H_2^1(s_n)} - 1 = \frac{\omega_{SY2,n}s_n + a\omega_{SY2,n}s_n}{s_n^2 + (a-1)s_n + 1}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, w=: $H_5$ ist 3. Ordnung-basiert, <u>oder</u>

c1) die dritte Übertragungsfunktion k-ter Ordnung $"H_3^k(s)"$ (ÜF3) des ersten Filtersystems (FSY1, FSY1'),

- wenn dieses auf einem Symmetrie-Tiefpass mit einer Verstärkung von "1" und einer Symmetrie-Tiefpass-Übertragungsfunktion 5. Ordnung $"H_{STP}^5(s_n)"$ mit $H_{STP}^5(s_n) = \frac{1 + a_1 s_n + a_2 s_n^2}{1 + a_1 s_n + a_2 s_n^2 + a_2 s_n^3 + a_1 s_n^4 + s_n^5}$ Übertragungsfunktion 5. Ordnung und Koeffizienten "$a_1 = 15,19$" und $"a_2 = \frac{a_1^2}{4}"$ basiert, und

- das aus einem multiplikative Produkt von der Symmetrie-Tiefpass-Übertragungsfunktion 5. Ordnung $"H_{STP}^5(s_n)"$ und einer Inversen $"1/H_1^1(s_n)"$ der Übertragungsfunktion 1. Ordnung $"H_1^1(s_n)"$ des Tiefpasses (TP) als das erste elektrische System (SY1) gebildet wird,

eine zweite Übertragungsfunktion 3. Ordnung $"H_{3,2}^5(s_n)"$ mit den Koeffizienten "$a_1$=15,19" und $"a_2 = \frac{a_1^2}{4}"$ ist:

$$H_{3,2}^5(s_n) = \frac{H_{STP}^5(s_n)}{H_1^1(s_n)} = \frac{(a_2 s_n^2 + a_1 s_n + 1)(1 + s_n \omega_{SY2,n})}{(s_n^5 + a_1 s_n^4 + a_2 s_n^3 + a_2 s_n^2 + a_1 s_n + 1)}$$

mit $s_n = s/\omega_0$, $\omega_{SY1,n} = \omega_{SY1}/\omega_0$, $\omega_{SY1,n} = \omega_{SY2}/\omega_0$, $\omega_{SY1,n} = 1/\omega_{SY2,n}$,

c2) die vierte Übertragungsfunktion k-ter Ordnung $"H_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem Symmetrie-Tiefpass mit der Symmetrie-Tiefpass-Übertragungsfunktion 5. Ordnung $"H_{STP}^5(s_n)"$ mit $H_{STP}^5(s_n) = \frac{1 + a_1 s_n + a_2 s_n^2}{1 + a_1 s_n + a_2 s_n^2 + a_2 s_n^3 + a_1 s_n^4 + s_n^5}$ und den Koeffizienten "$a_1 = 15,19$" und $"a_2 = \frac{a_1^2}{4}"$ oder aus dem Symmetrie-Tiefpass mit der Symmetrie-Tiefpass-Übertragungsfunktion 5. Ordnung $"H_{STP}^5\left(s_n \to \frac{1}{s_n}\right)"$ mit $H_{STP}^5\left(s_n \to \frac{1}{s_n}\right) =$ $\frac{1 + a_1 \frac{1}{s_n} + a_2 \frac{1}{s_n^2}}{1 + a_1 \frac{1}{s_n} + a_2 \frac{1}{s_n^2} + a_2 \frac{1}{s_n^3} + a_1 \frac{1}{s_n^4} + \frac{1}{s_n^5}}$ und den Koeffizienten "$a_1 = 15,19$" und $"a_2 = \frac{a_1^2}{4}"$ gebildet wird,

- wobei die Übertragungsfunktion "1" und die Symmetrie-Tiefpass-Übertragungsfunktion 5. Ordnung $"H_{STP}^5(s_n)"$ subtraktiv nach der Maßgabe $"1 - H_{STP}^5(s_n)"$ verknüpft werden, und

- die Verknüpfung aus der Übertragungsfunktion "1" und der Symmetrie-Tiefpass-Übertragungsfunktion 5. Ordnung $"H_{STP}^5(s_n)"$ oder die Symmetrie-Tiefpass-Übertragungsfunktion 5. Ordnung $"H_{STP}^5\left(s_n \to \frac{1}{s_n}\right)"$ mit einer Inversen $"1/H_2^1(s_n)"$ der Übertragungsfunktion 1. Ordnung $"H_2^1(s_n)"$ des Hochpasses (HP) als das zweite elektrische System (SY2) multipliziert wird,

eine zweite Übertragungsfunktion 5. Ordnung $"H_{4,2}^5(s_n)"$ mit den Koeffizienten "$a_1 = 15,19$" und $"a_2 = \frac{a_1^2}{4}"$ ist:

$$H_{4,2}^5(s_n) = \frac{1 - H_{STP}^5(s_n)}{H_2^1(s_n)} = \frac{H_{STP}^5\left(s_n \to \frac{1}{s_n}\right)}{H_2^1(s_n)}$$

$$= \frac{(s_n^4 + a_1 s_n^3 + a_2 s_n^2)(\omega_{SY2,n} + s_n)}{(s_n^5 + a_1 s_n^4 + a_2 s_n^3 + a_2 s_n^2 + a_1 s_n + 1)}$$

mit $s_n = s/\omega_0$, $\omega_{SY1,n} = \omega_{SY1}/\omega_0$, $\omega_{SY1,n} = \omega_{SY2}/\omega_0$, $\omega_{SY1,n} = 1/\omega_{SY2,n}$,

c3) die fünfte Übertragungsfunktion "$H_5(s)$" (ÜF5) des zweiten Filtersystems (FSY2),

- das aus dem multiplikativen Produkt von der Symmetrie-Tiefpass-Übertragungsfunktion 5. Ordnung

"$H_{STP}^5(s_n)$" mit mit den Koeffizienten "$a_1$ = **15,19**" und "$a_2 = \frac{a_1^2}{4}$" und der Inversen

"$1/H_1^1(s_n)$" der Übertragungsfunktion 1. Ordnung "$H_1^1(s_n)$" des Tiefpasses (TP) als das erste elektrische System (SY1) gebildet wird,
- das aus dem in dem zweiten Filtersystem (FSY2) eins-zu-eins übertragenen, zweiten Ausgangssignal (ASI2) mit der Übertragungsfunktion "1" und aus dem Symmetrie-Tiefpass mit der Symmetrie-Tiefpass-Übertragungsfunktion 5. Ordnung "$H_{STP}^5(s_n)$" und den Koeffizienten "$a_1$ = 15,19" und "$a_2 = \frac{a_1^2}{4}$", wobei die Übertragungsfunktion "1" und die Symmetrie-Tiefpass-Übertragungsfunktion 5. Ordnung

"$H_{STP}^5(s_n)$" subtraktiv nach der Maßgabe "$1 - H_{STP}^5(s_n)$" verknüpft werden und wobei die Verknüpfung aus der Übertragungsfunktion "1" und der Symmetrie-Tiefpass-Übertragungsfunktion 5. Ordnung

"$H_{STP}^5(s_n)$" mit der Inversen "$1/H_2^1(s_n)$" der Übertragungsfunktion 1. Ordnung "$H_2^1(s_n)$" des Hochpasses (HP) als das zweite elektrische System (SY2) multipliziert wird, gebildet wird,
- wobei das multiplikative Produkt und das Multiplikationsprodukt aus der Verknüpfung und der Inversen

"$1/H_2^1(s_n)$" der Übertragungsfunktion 1. Ordnung "$H_2^1(s_n)$" addiert werden, und
- wobei von einer durch die Addition gebildeten Summe das in dem zweiten Filtersystem (FSY2) eins-zu-eins übertragene, zweite Ausgangssignal (ASI2) mit der Übertragungsfunktion "1" subtrahiert wird,

eine sechste Übertragungsfunktion "$H_{5,6x}(s_n)$" mit den Koeffizienten "$a_1$ = 15,19" und "$a_2 = \frac{a_1^2}{4}$" ist:

$$H_{5,6x}(s_n) = \frac{H_{STP}^5(s_n)}{H_1^1(s_n)} + \frac{1 - H_{STP}^5(s_n)}{H_2^1(s_n)} - 1$$

$$= \frac{\omega_{SY2,n} s_n^3 + (a_2 + a_1 - 1)\omega_{SY2,n} s_n^2 + s_n \omega_{SY2,n}}{(s_n^4 + (a_1 - 1)s_n^3 + (a_2 - a_1 + 1)s_n^2 + (a_1 - 1)s_n + 1)}$$

mit $s_n = s/\omega_0$, $\omega_{SY1,n} = \omega_{SY1}/\omega_0$, $\omega_{SY2n} = \omega_{SY2}\omega_0$, $\omega_{SY1,n} = 1/\omega_{SY2,n}$, x =: $H_5$ ist 5. Ordnung-basiert.

8. Verfahren nach einem der Ansprüche 1 bis 7, **gekennzeichnet durch**

- einen "Direct Current <DC>"-Sensor, z.B. einen Fluxgate-Wandler (FGW) in Closed Loop-Ausführung oder einen Hall Effect Sensor (HES) in Open Loop/Closed Loop-Ausführung oder einen Pearson-Wandler mit "wideband current transformer"-Charakteristik (PW), zur Messung eines Stroms als Messgröße MG und dem Eingangssignal ESI mit einer oberen Grenzfrequenz $f_{o,Gr}$ = 200kHz, dies entspricht einem Wert der Grenzkreisfre-

quenz $\omega_{SY1}$ von "$2\pi$ x 200kHz", als das erste elektrische System (SY1) und
- einen "Alternate Current <AC>"-Sensor, z.B. einen PEM-Wandler (PEM-W) als Rogowski-Spule mit Integrierer oder einen Stromwandler (STW) mit Sekundär-Shunt, zur Messung des Stroms als Messgröße MG und dem Eingangssignal ESI mit einer unteren Grenzfrequenz $f_{u,Gr}$= 20Hz, dies entspricht einem Wert der Grenzkreisfrequenz $\omega_{SY2}$ von "$2\pi$ x 20Hz", als das zweite elektrische System (SY2).

9. Elektronische Schaltungsanordnung (ESA) zur Kombination von Ausgangssignalen (ASI1, ASI2) elektrischer Systeme (SY1, SY2) mit verschiedenen Signal-Frequenzbereichen (FB1, FB2), die folgendes enthält

- eine Filterschaltung (FS) zur Filtersignalerzeugung (FSI1, FSI2, FSI$_K$), die ein durch eine erste Übertragungsfunktion m-ter Ordnung $"\mathbf{H}_1^m(s)"$ (ÜF1) eines ersten elektrischen Systems (SY1) im Verhältnis zu einem Eingangssignal (ESI) bestimmbares, erstes Ausgangssignal (ASI1) mit einem ersten Frequenzbereich (FB1) und einer durch das erste System (SY1) bedingten, ersten Grenzkreisfrequenz $\omega_{SY1}$ sowie ein durch eine zweite Übertragungsfunktion p-ter Ordnung $"\mathbf{H}_2^p(s)"$ (ÜF2) eines zweiten elektrischen Systems (SY2) im Verhältnis zu dem Eingangssignal (ESI) bestimmbares, zweites Ausgangssignal (ASI2) mit einem zweiten Frequenzbereich (FB2) und einer durch das zweite System (SY2) bedingten, zweiten Grenzkreisfrequenz $\omega_{SY2}$ filtert (flt), und

- eine Kombinationsschaltung (KS) zur Erzeugung eines Kombinationssignals (KSI), die mit der Filterschaltung (FS) schaltungstechnisch verbunden ist und die nach der Filtersignalerzeugung (FSI1, FSI2, FSI$_K$) die erzeugten Signalen zu dem Kombinationssignal (KSI) kombiniert (kbn),
**dadurch gekennzeichnet, dass**
die Filterschaltung (FS) zur Filtersignalerzeugung (FSI1), FSI2, FSI$_K$) und die Kombinationsschaltung (KS) zur Erzeugung des Kombinationssignals (KSI) derart ausgebildet sind, dass

a) im Zuge der Filterung (flt) mit einem ersten Filtersystem (FSY1) der Filterschaltung (FS) ein durch eine dritte Übertragungsfunktion k-ter Ordnung $"\mathbf{H}_3^k(s)"$ (ÜF3) des ersten Filtersystems (FSY1) im Verhältnis zu dem ersten Ausgangssignal (ASI1) bestimmbares, erstes Filtersignal (FSI1) mit einer Filter-Grenzkreisfrequenz $\omega_0$ generiert wird,

b) im Zuge der Filterung (flt) mit einem zweiten Filtersystem (FSY2) der Filterschaltung (FS) in Bezug auf eine vierte Übertragungsfunktion k-ter Ordnung $"\mathbf{H}_4^k(s)"$ (ÜF4) des zweiten Filtersystems (FSY2)

**b1)** von einem weiteren ersten Filtersystem (FSY1') des zweiten Filtersystems (FSY2) ein durch die dritte Übertragungsfunktion k-ter Ordnung $"\mathbf{H}_3^k(s)"$ (ÜF3) des weiteren ersten Filtersystems (FSY1') im Verhältnis zu dem zweiten Ausgangssignal (ASI2) bestimmbares, zweites Filtersignal (FSI2) mit der Filter-Grenzkreisfrequenz $\omega_0$ generiert wird oder

b2) von einem weiteren ersten Filtersystem (FSY1') des zweiten Filtersystems (FSY2) ein durch die dritte Übertragungsfunktion k-ter Ordnung $"\mathbf{H}_3^k(s)"$ (ÜF3) des weiteren ersten Filtersystems (FSY1') im Verhältnis zu dem zweiten Ausgangssignal (ASI2) bestimmbares, zweites Filtersignal (FSI2) mit der Filter-Grenzkreisfrequenz $\omega_0$ und von einem Kompensation-Filtersystem (FSY$_K$) des zweiten Filtersystems (FSY2) ein durch eine fünfte Übertragungsfunktion "$\mathbf{H}_5(s)$" (ÜF5) des Kompensation-Filtersystems (FSY$_K$) im Verhältnis zu dem zweiten Ausgangssignal (ASI2) bestimmbares Kompensation-Filtersignal (FSI$_K$) generiert werden,

c) im Zuge der Signalkombination mit der Kombinationsschaltung (KS) sowie in Bezug auf die dritte Übertragungsfunktion k-ter Ordnung $"\mathbf{H}_3^k(s)"$ (ÜF3) des ersten Filtersystems (FSY1) und die vierte Übertragungsfunktion k-ter Ordnung $"\mathbf{H}_4^k(s)"$ (ÜF4) des zweiten Filtersystems (FSY2)

c1) das zweite Ausgangssignal (ASI2), das zweite Filtersignal (FSI2) und das erste Filtersignal (FSI1) für eine asymmetrische oder symmetrische Erzeugung des Kombinationssignals (KSI) zumindest eines von beiden, additiv und subtraktiv, mit Maßgabe von $"H_3^k(s) + H_4^k(s)) = 1"$ verknüpft werden oder

c2) das zweite Ausgangssignal (ASI2), das zweite Filtersignal (FSI2), das Kompensation-Filtersignal (FSI$_K$) und das erste Filtersignal (FSI1) für eine asymmetrische und kompensatorische oder symmetrische und kompensatorische Erzeugung des Kombinationssignals (KS) zumindest eines von beiden, additiv und subtraktiv, mit Maßgabe von $"H_3^k(s) \times H_1^m(s) + H_4^k(s) \times H_2^p(s) = 1"$ verknüpft werden.

10. Elektronische Schaltungsanordnung (ESA) nach Anspruch 9, **dadurch gekennzeichnet, dass** für die Filter-Grenzkreisfrequenz $\omega_0$ jedes Filtersystems k-ter Ordnung (FSY1, FSY1' FSY2) in Bezug auf die erste Übertragungsfunktion m-ter Ordnung $"H_1^m(s)"$ (ÜF1) mit der ersten Grenzkreisfrequenz $\omega_{SY1}$ und die zweite Übertragungsfunktion p-ter Ordnung $"H_2^p(s)"$ (ÜF2) mit der zweiten Grenzkreisfrequenz $\omega_{SY2}$ der elektrischen Systeme (SY1, SY2) und unter der Voraussetzung, dass die m-te Ordnung gleich der p-ten Ordnung, also m=p, ist, folgender funktionaler Zusammenhang zu den Grenzkreisfrequenzen $\omega_{SY1}$, $\omega_{SY2}$ besteht:

$$\omega_0 = \sqrt{\omega_{SY1} \times \omega_{SY2}}$$

11. Elektronische Schaltungsanordnung (ESA) nach Anspruch 10, **dadurch gekennzeichnet, dass** auf der Basis eines Standard-Tiefpasses mit einer Verstärkung von "1" und einer Standard-Tiefpass-Übertragungsfunktion j-ter Ordnung mit Koeffizienten abhängig von einer Tiefpass-Filterapproximation, z.B. Butterworth oder Bessel,

$$"H_{TP}^j(s_n) = \frac{1}{1+a_1 s_n + a_2 s_n^2 + \dots + a_j s_n^j}"$$

mit $s_n = s/\omega_0$

(i) die erste Übertragungsfunktion m-ter Ordnung $"H_1^m(s)"$ (ÜF1) des ersten elektrischen Systems (SY1),

- wenn dieses ein Tiefpass (TP) gemäß dem Standard-Tiefpass mit einer Tiefpass-Übertragungsfunktion 1. Ordnung $"H_{TP}^1(s_n)"$ und einer Filterapproximationsunabhängigkeit ist,

eine Übertragungsfunktion 1. Ordnung $"H_1^1(s_n)"$ mit der Filterapproximationsunabhängigkeit ist:

$$H_1^1(s_n) = \frac{1}{1 + s_n/\omega_{SY1,n}} = \frac{1}{1 + s_n \cdot \omega_{SY2,n}}$$

mit $s_n = s/\omega_0$, $\omega_{SY1,n} = \omega_{SY1}/\omega_0$, $\omega_{SY1,n} = \omega_{SY2}/\omega_0$, $\omega_{SY1,n} = \omega_{SY2,n}$,

(ii) die zweite Übertragungsfunktion p-ter Ordnung $"H_2^p(s)"$ (ÜF2) des zweiten elektrischen Systems (SY2),

- wenn dieses ein Hochpass (HP) gemäß dem Standard-Tiefpass mit der Tiefpass-Übertragungsfunktion 1. Ordnung $"H_{TP}^1(s_n)"$ und der Filterapproximationsunabhängigkeit ist, eine Übertragungsfunktion 1. Ordnung $"H_2^1(s_n)"$ mit der Filterapproximationsunabhängigkeit ist:

$$H_2^1(s_n) = \frac{s_n/\omega_{SY2,n}}{1 + s_n/\omega_{SY2,n}}$$

mit $s_n = s/\omega_0$, $\omega_{SY1,n} = \omega_{SY1}/\omega_0$, $\omega_{SY1,n} = \omega_{SY2}/\omega_0$, $\omega_{SY1,n} = \omega_{SY2,n}$.

12. Elektronische Schaltungsanordnung (ESA) nach Anspruch 11, **dadurch gekennzeichnet, dass** die Filterschaltung (FS) zur Filtersignalerzeugung (FSI1), FSI2, $FSI_K$) und die Kombinationsschaltung (KS) zur Erzeugung des Kombinationssignals (KSI) derart ausgebildet sind, dass für die mit der Filterung (flt) asymmetrische Erzeugung des Kombinationssignals (KS)

a1) die dritte Übertragungsfunktion k-ter Ordnung $"H_3^k(s)"$ (ÜF3) des ersten Filtersystems (FSY1, FSY1'),

- wenn dieses auf dem Standard-Tiefpass mit der Standard-Tiefpass-Übertragungsfunktion 1. Ordnung $"H_{TP}^1(s_n)"$ und der Filterapproximationsunabhängigkeit basiert,

eine erste Übertragungsfunktion 1. Ordnung $"H_{3,1}^1(s_n)"$ mit der Filterapproximationsunabhängigkeit ist:

$$H_{3,1}^1(s_n) = H_{TP}^1(s_n) = \frac{1}{1 + s_n}$$

mit $s_n = s/\omega_0$,

a2) die vierte Übertragungsfunktion k-ter Ordnung $"H_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem ersten Filtersystem (FSY1, FSY1') mit der dritten Übertragungsfunktion k-ter Ordnung $"H_3^k(s)"$ (ÜF3) gebildet wird,

- wobei die Übertragungsfunktion "1" und die dritte Übertragungsfunktion k-ter Ordnung $"H_3^k(s)"$ subtraktiv nach der Maßgabe $"1 - H_3^k(s)"$ verknüpft werden, und

- wenn das erste Filtersystem (FSY1, FSY1') mit der dritten Übertragungsfunktion k-ter Ordnung $"H_3^k(s)"$ auf dem Standard-Tiefpass mit der Standard-Tiefpass-Übertragungsfunktion 1. Ordnung $"H_{TP}^1(s_n)"$ und der Filterapproximationsunabhängigkeit basiert,

eine erste Übertragungsfunktion 1. Ordnung $"H_{4,1}^1(s_n)"$ mit der Filterapproximationsunabhängigkeit ist:

$$H_{4,1}^1(s_n) = 1 - H_3^k(s_n) = 1 - H_{TP}^1(s_n) = \frac{s_n}{1 + s_n}$$

mit $s_n = s/(\omega_0$,
<u>oder</u>

b1) die dritte Übertragungsfunktion k-ter Ordnung $"H_3^k(s)"$ (ÜF3) des ersten Filtersystems (FSY1, FSY1'),

- wenn dieses auf dem Standard-Tiefpass mit der Standard-Tiefpass-Übertragungsfunktion 2. Ordnung $"H_{TP}^2(s_n)"$ und einer Butterworth-Filterapproximation basiert,

eine erste Übertragungsfunktion 2. Ordnung $"H_{3,1}^2(s_n)"$ mit der Butterworth-Filterapproximation ist:

$$H_{3,1}^2(s_n) = H_{TP}^2(s_n) = \frac{1}{1 + a_1 s_n + a_2 s_n^2} = \frac{1}{1 + \sqrt{2} s_n + s_n^2}$$

mit $s_n = s/(\omega_0$,

b2) die vierte Übertragungsfunktion k-ter Ordnung $"H_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem ersten Filtersystem (FSY1, FSY1') mit der dritten Übertragungsfunktion k-ter Ordnung $"H_3^k(s)"$ (ÜF3) gebildet wird,

- wobei die Übertragungsfunktion "1" und die dritte Übertragungsfunktion k-ter Ordnung $"H_3^k(s)"$ subtraktiv nach der Maßgabe $"1 - H_3^k(s)"$ verknüpft werden, und

- wenn das erste Filtersystem (FSY1, FSY1') mit der dritten Übertragungsfunktion k-ter Ordnung $"H_3^k(s)"$ auf dem Standard-Tiefpass mit der Standard-Tiefpass-Übertragungsfunktion 2. Ordnung $"H_{TP}^2(s_n)"$ und der der Butterworth-Filterapproximation basiert,

eine erste Übertragungsfunktion 2. Ordnung $"H_{4,1}^2(s_n)"$ mit der Butterworth-Filterapproximation ist:

$$H_{4,1}^2(s_n) = 1 - H_3^k(s_n) = 1 - H_{TP}^2(s_n) = \frac{\sqrt{2} s_n + s_n^2}{1 + \sqrt{2} s_n + s_n^2}$$

mit $s_n = s/(\omega_0$,
_oder_

c1) die dritte Übertragungsfunktion k-ter Ordnung $"H_3^k(s)"$ (ÜF3) des ersten Filtersystems (FSY1, FSY1'),

- wenn dieses auf dem Standard-Tiefpass mit der Standard-Tiefpass-Übertragungsfunktion 3. Ordnung $"H_{TP}^3(s_n)"$ und der Butterworth-Filterapproximation basiert,

eine erste Übertragungsfunktion 3. Ordnung $"H_{3,1}^3(s_n)"$ mit der Butterworth-Filterapproximation ist:

$$H_{3,1}^3(s_n) = \frac{1}{1 + a_1 s_n + a_2 s_n^2 + a_3 s_n^3} = \frac{1}{1 + 2 s_n + 2 s_n^2 + s_n^3}$$

mit $s_n = s/\omega_0$,

c2) die vierte Übertragungsfunktion k-ter Ordnung $"H_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem ersten Filtersystem (FSY1, FSY1') mit der dritten Übertragungsfunktion k-ter Ordnung $"H_3^k(s)"$ (ÜF3) gebildet wird,

- wobei die Übertragungsfunktion "1" und die dritte Übertragungsfunktion k-ter Ordnung $"H_3^k(s)"$ subtraktiv nach der Maßgabe $"1 - H_3^k(s)"$ verknüpft werden, und

- wenn das erste Filtersystem (FSY1, FSY1') mit der dritten Übertragungsfunktion k-ter Ordnung $"H_3^k(s)"$ auf dem Standard-Tiefpass mit der Standard-Tiefpass-Übertragungsfunktion 3. Ordnung $"H_{TP}^3(s_n)"$ und der der Butterworth-Filterapproximation basiert,

eine erste Übertragungsfunktion 3. Ordnung $"H_{4,1}^3(s_n)"$ mit der Butterworth-Filterapproximation ist:

$$H_{4,1}^3(s_n) = 1 - H_3^k(s_n) = 1 - H_{TP}^3(s_n) = \frac{2s_n + 2s_n^2 + s_n^3}{1 + 2s_n + 2s_n^2 + s_n^3}$$

mit $s_n = s/\omega_0$.

**13.** Elektronische Schaltungsanordnung (ESA) nach Anspruch 11, **dadurch gekennzeichnet, dass** die Filterschaltung (FS) zur Filtersignalerzeugung (FSI1), FSI2, $FSI_K$) und die Kombinationsschaltung (KS) zur Erzeugung des Kombinationssignals (KSI) derart ausgebildet sind, dass für die mit der Filterung (flt) symmetrische Erzeugung des Kombinationssignals (KS)

a1) die dritte Übertragungsfunktion k-ter Ordnung $"H_3^k(s)"$ (ÜF3) des ersten Filtersystems (FSY1, FSY1'),

- wenn dieses auf einem Symmetrie-Tiefpass mit einer Verstärkung von "1" und einer Symmetrie-Tiefpass-Übertragungsfunktion 1. Ordnung $"H_{STP}^1(s_n)"$ mit $H_{STP}^1(s_n) = \frac{1}{1+s_n}$ und einer Filterapproximationsunabhängigkeit basiert,

eine zweite Übertragungsfunktion 1. Ordnung $"H_{3,2}^1(s_n)"$ mit der Filterapproximationsunabhängigkeit ist:

$$H_{3,2}^1(s_n) = \frac{1}{1 + s_n}$$

mit $s_n = s/(\omega_0$,

a2) die vierte Übertragungsfunktion k-ter Ordnung $"H_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem ersten Filtersystem (FSY1, FSY1') mit der dritten Übertragungsfunktion k-ter Ordnung $"\mathbf{H}_3^k(s_n)"$ (ÜF3) oder aus dem ersten Filtersystem (FSY1, FSY1')

mit der dritten Übertragungsfunktion k-ter Ordnung $"\mathbf{H}_3^k\left(s_n \to \frac{1}{s_n}\right)"$ (ÜF3) gebildet wird,

- wobei die Übertragungsfunktion "1" und die dritte Übertragungsfunktion k-ter Ordnung $"\mathbf{H}_3^k(s)"$ subtraktiv nach der Maßgabe $"1 - \mathbf{H}_3^k(s)"$ verknüpft werden, und

- wenn das erste Filtersystem (FSY1, FSY1') mit der dritten Übertragungsfunktion k-ter Ordnung $"\mathbf{H}_3^k(s)"$ auf dem Symmetrie-Tiefpass mit der Symmetrie-Tiefpass-Übertragungsfunktion 1. Ordnung

$"\mathbf{H}_{STP}^1(s_n)"$ mit $\mathbf{H}_{STP}^1(s_n) = \frac{1}{1+s_n}$ und der Filterapproximationsunabhängigkeit basiert,

eine zweite Übertragungsfunktion 1. Ordnung $"\mathbf{H}_{4,2}^1(s_n)"$ mit der Filterapproximationsunabhängigkeit ist:

$$\mathbf{H}_{4,2}^1(s_n) = 1 - \mathbf{H}_3^k(s_n) = \mathbf{H}_3^k\left(s_n \to \frac{1}{s_n}\right) = 1 - \mathbf{H}_{STP}^1(s_n) = \frac{1}{1+s_n}$$

mit $s_n = s/\omega_0$.
<u>oder</u>

b1) die dritte Übertragungsfunktion k-ter Ordnung $"\mathbf{H}_3^k(s)"$ (ÜF3) des ersten Filtersystems (FSY1, FSY1'),

- wenn dieses auf einem Symmetrie-Tiefpass mit einer Verstärkung von "1" und einer Symmetrie-Tiefpass-Übertragungsfunktion 3. Ordnung $"\mathbf{H}_{STP}^3(s_n)"$ mit $\mathbf{H}_{STP}^3(s_n) = \frac{1+as_n}{1+as_n+as_n^2+s_n^3}$ und einem Koeffizienten "a=3" als dreifache Polstelle basiert,

eine zweite Übertragungsfunktion 3. Ordnung $"\mathbf{H}_{3,2}^3(s_n)"$ mit dem Koeffizienten "a=3" als dreifache Polstelle ist:

$$\mathbf{H}_{3,2}^3(s_n) = \frac{1+as_n}{1+as_n+as_n^2+s_n^3}$$

mit $s_n = s/(\omega_0,$

b2) die vierte Übertragungsfunktion k-ter Ordnung $"\mathbf{H}_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem ersten Filtersystem (FSY1, FSY1') mit der dritten Übertragungsfunktion k-ter Ordnung $"\mathbf{H}_3^k(s_n)"$ (ÜF3) oder aus dem ersten Filtersystem (FSY1, FSY1')

mit einer dritten Übertragungsfunktion k-ter Ordnung $"\mathbf{H}_3^k\left(s_n \to \frac{1}{s_n}\right)"$ (ÜF3) gebildet wird,

- wobei die Übertragungsfunktion "1" und die dritte Übertragungsfunktion k-ter Ordnung $"\mathbf{H}_3^k(s)"$ sub-

traktiv nach der Maßgabe $"1-\mathbf{H}_3^k(s)"$ verknüpft werden, und

- wenn das erste Filtersystem (FSY1, FSY1') mit der dritten Übertragungsfunktion k-ter Ordnung

$"\mathbf{H}_3^k(s)"$ auf dem Symmetrie-Tiefpass mit einer Symmetrie-Tiefpass-Übertragungsfunktion 3. Ordnung

$"\mathbf{H}_{STP}^3(s_n)"$ mit $\mathbf{H}_{STP}^3(s_n) = \frac{1+as_n}{1+as_n+as_n^2+s_n^3}$ und dem Koeffizienten "a=3" als dreifache Polstelle basiert,

eine zweite Übertragungsfunktion 3. Ordnung $"\mathbf{H}_4^3(s_n)"$ mit dem Koeffizienten "a=3" als dreifache Polstelle ist:

$$H_{4,2}^3(s_n) = 1 - H_3^k(s_n) = H_3^k\left(s_n \to \frac{1}{s_n}\right) = 1 - H_{STP}^3(s_n) = \frac{as_n^2 + s_n^3}{1 + as_n + as_n^2 + s_n^3}$$

mit $s_n = s/\omega_0$,

c1) die dritte Übertragungsfunktion k-ter Ordnung $"\mathbf{H}_3^k(s)"$ (ÜF3) des ersten Filtersystems (FSY1, FSY1'),

- wenn dieses auf einem Symmetrie-Tiefpass mit einer Verstärkung von "1" und einer Symmetrie-Tiefpass-Übertragungsfunktion 5. Ordnung $"\mathbf{H}_{STP}^5(s_n)"$ mit $\mathbf{H}_{STP}^5(s_n) = \frac{1+a_1s_n+a_2s_n^2}{1+a_1s_n+a_2s_n^2+a_2s_n^3+a_1s_n^4+s_n^5}$ und Koeffizienten "$a_1$=15,19" und $"a_2 = \frac{a_1^2}{4}"$ basiert,

eine erste Übertragungsfunktion 5. Ordnung $"\mathbf{H}_{3,1}^5(s_n)"$ mit den Koeffizienten ""$a_1$=15,19" und $"a_2 = \frac{a_1^2}{4}"$ ist:

$$H_{3,1}^5(s_n) = \frac{1 + a_1s_n + a_2s_n^2}{1 + a_1s_n + a_2s_n^2 + a_2s_n^3 + a_1s_n^4 + s_n^5}$$

mit $s_n = s/\omega_0$,

c2) die vierte Übertragungsfunktion k-ter Ordnung $"\mathbf{H}_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem ersten Filtersystem (FSY1, FSY1') mit der dritten Übertragungsfunktion k-ter Ordnung $"\mathbf{H}_3^k(s_n)"$ (ÜF3) oder aus dem ersten Filtersystem (FSY1, FSY1') mit einer dritten Übertragungsfunktion k-ter Ordnung $"\mathbf{H}_3^k\left(s_n \to \frac{1}{s_n}\right)"$ (ÜF3) gebildet wird,

- wobei die Übertragungsfunktion "1" und die dritte Übertragungsfunktion k-ter Ordnung $"\mathbf{H}_3^k(s)"$ subtraktiv nach der Maßgabe $"1-\mathbf{H}_3^k(s)"$ verknüpft werden, und

- wenn das erste Filtersystem (FSY1, FSY1') mit der dritten Übertragungsfunktion k-ter Ordnung

$"H_3^k(s)"$ auf dem Symmetrie-Tiefpass mit einer Symmetrie-Tiefpass-Übertragungsfunktion 5. Ordnung

$"H_{STP}^5(s_n)"$ mit $H_{STP}^5(s_n) = \dfrac{1 + a_1 s_n + a_2 s_n^2}{1 + a_1 s_n + a_2 s_n^2 + a_2 s_n^3 + a_1 s_n^4 + s_n^5}$ und den Koeffizienten "$a_1$=15,19" und

$"a_2 = \dfrac{a_1^2}{4}"$ basiert,

eine zweite Übertragungsfunktion 5. Ordnung $"H_{4,2}^5(s_n)"$ mit den Koeffizienten "$a_1$=15,19" und

$"a_2 = \dfrac{a_1^2}{4}"$ ist:

$$H_{4,2}^5(s_n) = 1 - H_3^k(s_n) = H_3^k\left(s_n \to \frac{1}{s_n}\right) = 1 - H_{STP}^5(s_n)$$

$$= \frac{a_2 s_n^3 + a_1 s_n^4 + s_n^5}{1 + a_1 s_n + a_2 s_n^2 + a_2 s_n^3 + a_1 s_n^4 + s_n^5}$$

mit $s_n = s/\omega_0$.

14. Elektronische Schaltungsanordnung (ESA) nach Anspruch 11, **dadurch gekennzeichnet, dass**
die Filterschaltung (FS) zur Filtersignalerzeugung (FSI1), FSI2, FSI$_K$) und die Kombinationsschaltung (KS) zur Erzeugung des Kombinationssignals (KSI) derart ausgebildet sind, dass für die mit der Filterung (flt) asymmetrische und kompensatorische Erzeugung des Kombinationssignals (KS)

**a1**) die dritte Übertragungsfunktion k-ter Ordnung $"H_3^k(s)"$ (ÜF3) des ersten Filtersystems (FSY1, FSY1'),

- wenn dieses auf dem Standard-Tiefpass mit der Standard-Tiefpass-Übertragungsfunktion 1. Ordnung $"H_{TP}^1(s_n)"$ und der Filterapproximationsunabhängigkeit basiert, und
- das aus einem multiplikative Produkt von der Standard-Tiefpass-Übertragungsfunktion 1. Ordnung $"H_{TP}^1(s_n)"$ und aus einer Inversen $"1/H_1^1(s_n)"$ der Übertragungsfunktion 1. Ordnung $"H_1^1(s_n)"$ des Tiefpasses (TP) als das erste elektrische System (SY1) ist,

eine dritte Übertragungsfunktion 1. Ordnung $"H_{3,3}^1(s_n)"$ mit der der Filterapproximationsunabhängigkeit ist:

$$H_{3,3}^1(s_n) = \frac{H_{TP}^1(s_n)}{H_1^1(s_n)} = \frac{\omega_{SY2,n} s_n + 1}{s_n + 1}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$,

a2) die vierte Übertragungsfunktion k-ter Ordnung $"H_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem Standard-Tiefpass mit der Standard-Tiefpass-Übertragungsfunktion 1. Ordnung $"H_{TP}^1(s_n)"$ und der Filterapproximationsunabhängigkeit gebildet wird,
- wobei die Übertragungsfunktion "1" und die Standard-Tiefpass-Übertragungsfunktion 1. Ordnung

$"H_{TP}^1(s_n)"$ subtraktiv nach der Maßgabe $"1-H_{TP}^1(s_n)"$ verknüpft werden, und
- die Verknüpfung aus der Übertragungsfunktion "1" und der Standard-Tiefpass-Übertragungsfunktion 1. Ordnung $"H_{TP}^1(s_n)"$ mit einer Inversen $"1/H_2^1(s_n)"$ der Übertragungsfunktion 1. Ordnung $"H_2^1(s_n)"$ des Hochpasses (HP) als das zweite elektrische System (SY2) multipliziert wird,

eine dritte Übertragungsfunktion 1. Ordnung $"H_{4,3}^1(s_n)"$ mit der Filterapproximationsunabhängigkeit ist:

$$H_{4,3}^1(s_n) = \frac{1 - H_{TP}^1(s_n)}{H_2^1(s_n)} = \frac{\omega_{SY2,n} + s_n}{s_n + 1}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$,

a3) die fünfte Übertragungsfunktion $"H_5(s)"$ (ÜF5) des zweiten Filtersystems (FSY2),

- das aus dem multiplikativen Produkt von der Standard-Tiefpass-Übertragungsfunktion 1. Ordnung $"H_{TP}^1(s_n)"$ mit der Filterapproximationsunabhängigkeit und der Inversen $"1/H_1^1(s_n)"$ der Übertragungsfunktion 1. Ordnung $"H_1^1(s_n)"$ des Tiefpasses (TP) als das erste elektrische System (SY1) gebildet wird,
- das aus dem in dem zweiten Filtersystem (FSY2) eins-zu-eins übertragenen, zweiten Ausgangssignal (ASI2) mit der Übertragungsfunktion "1" und aus dem Standard-Tiefpass mit der Standard-Tiefpass-Übertragungsfunktion 1. Ordnung $"H_{TP}^1(s_n)"$ und der Filterapproximationsunabhängigkeit, wobei die Übertragungsfunktion "1" und die Standard-Tiefpass-Übertragungsfunktion 1. Ordnung $"H_{TP}^1(s_n)"$ subtraktiv nach der Maßgabe $"1-H_{TP}^1(s_n)"$ verknüpft werden und wobei die Verknüpfung aus der Übertragungsfunktion "1" und der Standard-Tiefpass-Übertragungsfunktion 1. Ordnung $"H_{TP}^1(s_n)"$ mit der Inversen $"1/H_2^1(s_n)"$ der Übertragungsfunktion 1. Ordnung $"H_2^1(s_n)"$ des Hochpasses (HP) als das zweite elektrische System (SY2) multipliziert wird, gebildet wird,
- wobei das multiplikative Produkt und das Multiplikationsprodukt aus der Verknüpfung und der Inversen $"1/H_2^1(s_n)"$ der Übertragungsfunktion 1. Ordnung $"H_2^1(s_n)"$ addiert werden, und
- wobei von einer durch die Addition gebildeten Summe das in dem zweiten Filtersystem (FSY2) eins-zu-eins übertragene, zweite Ausgangssignal (ASI2) mit der Übertragungsfunktion "1" subtrahiert wird,

eine erste Übertragungsfunktion $"H_{5,1u}(s_n)"$ mit der Filterapproximationsunabhängigkeit ist:

$$H_{5,1u}(s_n) = \frac{H_{TP}^1(s_n)}{H_1^1(s_n)} + \frac{1 - H_{TP}^1(s_n)}{H_2^1(s_n)} - 1 = \omega_{SY2,n}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, u=: $H_5$ ist 1. Ordnung-basiert, <u>oder</u>

**b1)** die dritte Übertragungsfunktion k-ter Ordnung $"H_3^k(s)"$ (ÜF3) des ersten Filtersystems (FSY1, FSY1'),

- wenn dieses auf dem Standard-Tiefpass mit der Standard-Tiefpass-Übertragungsfunktion 2. Ordnung

$"H_{TP}^2(s_n)"$ und einer Butterworth-Filterapproximation und einem Koeffizienten $"a = \sqrt{2}"$ basiert, und

- das aus einem multiplikative Produkt von der Standard-Tiefpass-Übertragungsfunktion 2. Ordnung $"H_{TP}^2(s_n)"$ und einer Inversen $"1/H_1^1(s_n)"$ der Übertragungsfunktion 1. Ordnung $"H_1^1(s_n)"$ des Tiefpasses (TP) als das erste elektrische System (SY1) ist,

eine zweite Übertragungsfunktion 2. Ordnung $"H_{3,2}^2(s_n)"$ mit der Butterworth-Filterapproximation und dem Koeffizienten $"a = \sqrt{2}"$ ist:

$$H_{3,2}^2(s_n) = \frac{H_{TP}^2(s_n)}{H_1^1(s_n)} = \frac{\omega_{SY2,n}s_n + 1}{1 + as_n + s_n^2}$$

mit $s_n=s/\omega_0$, $\omega_{SY1,n}=\omega_{SY1}/\omega_0$, $\omega_{SY2,n}=\omega_{SY2}/\omega_0$, $\omega_{SY1,n}=1/\omega_{SY2,n}$,

b2) die vierte Übertragungsfunktion k-ter Ordnung $"H_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem Standard-Tiefpass mit der Standard-Tiefpass-Übertragungsfunktion 2. Ordnung $"H_{TP}^2(s_n)"$, der Butterworth-Filterapproximation und dem Koeffizienten $"a = \sqrt{2}"$ gebildet wird,
- wobei die Übertragungsfunktion "1" und die Standard-Tiefpass-Übertragungsfunktion 2. Ordnung $"H_{TP}^2(s_n)"$ subtraktiv nach der Maßgabe $"1-H_{TP}^2(s_n)"$ verknüpft werden, und
- die Verknüpfung aus der Übertragungsfunktion "1" und der Standard-Tiefpass-Übertragungsfunktion 2. Ordnung $"H_{TP}^2(s_n)"$ mit einer Inversen $"1/H_2^1(s_n)"$ der Übertragungsfunktion 1. Ordnung $"H_2^1(s_n)"$ des Hochpasses (HP) als das zweite elektrische System (SY2) multipliziert wird,

eine zweite Übertragungsfunktion 2. Ordnung $"H_{4,2}^2(s_n)"$ mit der Butterworth-Filterapproximation und dem Koeffizienten $"a = \sqrt{2}"$ ist:

$$H_{4,2}^2(s_n) = \frac{1 - H_{TP}^2(s_n)}{H_2^1(s_n)} = \frac{s_n^2 + (a + \omega_{SY2,n})s_n + a\omega_{SY2,n}}{1 + as_n + s_n^2}$$

mit $s_n=s/\omega_0$, $\omega_{SY1,n}=\omega_{SY1}/\omega_0$, $\omega_{SY2,n}=\omega_{SY2}/\omega_0$, $\omega_{SY1,n}=1/\omega_{SY2,n}$,

b3) die fünfte Übertragungsfunktion $"H_5(s)"$ (ÜF5) des zweiten Filtersystems (FSY2),

- das aus dem multiplikativen Produkt von der Standard-Tiefpass-Übertragungsfunktion 2. Ordnung $"H_{TP}^2(s_n)"$ mit der der Butterworth-Filterapproximation und dem Koeffizienten $"a = \sqrt{2}"$ und der Inversen $"1/H_1^1(s_n)"$ der Übertragungsfunktion 1. Ordnung $"H_1^1(s_n)"$ des Tiefpasses (TP) als das erste elektrische System (SY1) gebildet wird,

- das aus dem in dem zweiten Filtersystem (FSY2) eins-zu-eins übertragenen, zweiten Ausgangssignal (ASI2) mit der Übertragungsfunktion "1" und aus dem Standard-Tiefpass mit der Standard-Tiefpass-Übertragungsfunktion 2. Ordnung $"\mathbf{H}^2_{TP}(s_n)"$, der Butterworth-Filterapproximation und dem Koeffizienten $"a = \sqrt{2}"$, wobei die Übertragungsfunktion "1" und die Standard-Tiefpass-Übertragungsfunktion 2. Ordnung $"\mathbf{H}^2_{TP}(s_n)"$ subtraktiv nach der Maßgabe "1- $\mathbf{H}^2_{TP}(s_n)"$ verknüpft werden und wobei die Verknüpfung aus der Übertragungsfunktion "1" und der Standard-Tiefpass-Übertragungsfunktion 2. Ordnung $"\mathbf{H}^2_{TP}(s_n)"$ mit der Inversen $"1/\mathbf{H}^1_2(s_n)"$ der Übertragungsfunktion 1. Ordnung $"\mathbf{H}^1_2(s_n)"$ des Hochpasses (HP) als das zweite elektrische System (SY2) multipliziert wird, gebildet wird,
- wobei das multiplikative Produkt und das Multiplikationsprodukt aus der Verknüpfung und der Inversen $"1/\mathbf{H}^1_2(s_n)"$ der Übertragungsfunktion 1. Ordnung $"\mathbf{H}^1_2(s_n)"$ addiert werden, und
- wobei von einer durch die Addition gebildeten Summe das in dem zweiten Filtersystem (FSY2) eins-zu-eins übertragene, zweite Ausgangssignal (ASI2) mit der Übertragungsfunktion "1" subtrahiert wird,

eine zweite Übertragungsfunktion $"\mathbf{H}_{5,2v}(s_n)"$ mit der Butterworth-Filterapproximation und dem Koeffizienten $"a = \sqrt{2}"$ ist:

$$\mathbf{H}_{5,2v}(s_n) = \frac{\mathbf{H}^2_{TP}(s_n)}{\mathbf{H}^1_1(s_n)} + \frac{1 - \mathbf{H}^2_{TP}(s_n)}{\mathbf{H}^1_2(s_n)} - 1 = \frac{2\omega_{SY2,n}s_n + \omega_{SY2,n}a}{1 + as_n + s_n^2}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, v=: $\mathbf{H}_5$ ist 2. Ordnung-basiert,
<u>oder</u>

**c1)** die dritte Übertragungsfunktion k-ter Ordnung $"\mathbf{H}^k_3(s)"$ (ÜF3) des ersten Filtersystems (FSY1, FSY1'),

- wenn dieses auf dem Standard-Tiefpass mit der Standard-Tiefpass-Übertragungsfunktion 3. Ordnung $"\mathbf{H}^3_{TP}(s_n)"$ und einer Butterworth-Filterapproximation und einem Koeffizienten "$a$ = 2" basiert, und
- das aus einem multiplikative Produkt von der Standard-Tiefpass-Übertragungsfunktion 3. Ordnung $"\mathbf{H}^3_{TP}(s_n)"$ und einer Inversen $"1/\mathbf{H}^1_1(s_n)"$ der Übertragungsfunktion 1. Ordnung $"\mathbf{H}^1_1(s_n)"$ des Tiefpasses (TP) als das erste elektrische System (SY1) ist,

eine dritte Übertragungsfunktion 3. Ordnung $"\mathbf{H}^2_{3,2}(s_n)"$ mit der Butterworth-Filterapproximation und dem Koeffizienten"$a$ = 2" ist:

$$\mathbf{H}^3_{3,3}(s_n) = \frac{\mathbf{H}^2_{TP}(s_n)}{\mathbf{H}^1_1(s_n)} = \frac{\omega_{SY2,n}s_n + 1}{1 + as_n + as_n^2 + s_n^3}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$,

**c2)** die vierte Übertragungsfunktion k-ter Ordnung $"\mathbf{H}^k_4(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem Standard-Tiefpass mit der Standard-Tiefpass-Übertragungsfunktion 3. Ordnung $"\mathbf{H}^3_{TP}(s_n)"$, der Butterworth-Filterapproximation und dem Koeffizienten"*a = 2*" gebildet wird,
- wobei die Übertragungsfunktion "1" und die Standard-Tiefpass-Übertragungsfunktion 3. Ordnung
"$H_{TP}^3(s_n)$" subtraktiv nach der Maßgabe "$1-H_{TP}^3(s_n)$" verknüpft werden, und
- die Verknüpfung aus der Übertragungsfunktion "1" und der Standard-Tiefpass-Übertragungsfunktion 3.
Ordnung "$H_{TP}^3(s_n)$" mit einer Inversen "$1/H_2^1(s_n)$" der Übertragungsfunktion 1. Ordnung
"$H_2^1(s_n)$" des Hochpasses (HP) als das zweite elektrische System (SY2) multipliziert wird,

eine dritte Übertragungsfunktion 3. Ordnung "$H_{4,3}^3(s_n)$" mit der Butterworth-Filterapproximation und
dem Koeffizienten"*a = 2*" ist:

$$H_{4,3}^3(s_n) = \frac{1 - H_{TP}^3(s_n)}{H_2^1(s_n)} = \frac{s_n^3 + (a + \omega_{SY2,n})s_n^2 + (\omega_{SY2,n} + 1)as_n + \omega_{SY2,n}a}{1 + as_n + as_n^2 + s_n^3}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$,

c3) die fünfte Übertragungsfunktion "$H_5(s)$" (ÜF5) des zweiten Filtersystems (FSY2),

- das aus dem multiplikativen Produkt von der Standard-Tiefpass-Übertragungsfunktion 3. Ordnung
"$H_{TP}^3(s_n)$" mit der der Butterworth-Filterapproximation und dem Koeffizienten"*a = 2*" und der Inversen
"$1/H_1^1(s_n)$" der Übertragungsfunktion 1. Ordnung "$H_1^1(s_n)$" des Tiefpasses (TP) als das erste
elektrische System (SY1) gebildet wird,
- das aus dem in dem zweiten Filtersystem (FSY2) eins-zu-eins übertragenen, zweiten Ausgangssignal
(ASI2) mit der Übertragungsfunktion "1" und aus dem Standard-Tiefpass mit der Standard-Tiefpass-Übertragungsfunktion 3. Ordnung "$H_{TP}^3(s_n)$", der Butterworth-Filterapproximation und dem Koeffizienten"*a
= 2*", wobei die Übertragungsfunktion "1" und die Standard-Tiefpass-Übertragungsfunktion 3. Ordnung
"$H_{TP}^3(s_n)$" subtraktiv nach der Maßgabe "$1-H_{TP}^3(s_n)$" verknüpft werden und wobei die Verknüpfung aus der Übertragungsfunktion "1" und der Standard-Tiefpass-Übertragungsfunktion 3. Ordnung
"$H_{TP}^3(s_n)$" mit der Inversen "$1/H_2^1(s_n)$" der Übertragungsfunktion 1. Ordnung "$H_2^1(s_n)$" des
Hochpasses (HP) als das zweite elektrische System (SY2) multipliziert wird, gebildet wird,
- wobei das multiplikative Produkt und das Multiplikationsprodukt aus der Verknüpfung und der Inversen
"$1/H_2^1(s_n)$" der Übertragungsfunktion 1. Ordnung "$H_2^1(s_n)$" addiert werden, und
- wobei von einer durch die Addition gebildeten Summe das in dem zweiten Filtersystem (FSY2) eins-zu-
eins übertragene, zweite Ausgangssignal (ASI2) mit der Übertragungsfunktion "1" subtrahiert wird,
eine dritte Übertragungsfunktion "$H_{5,3w}(s_n)$" mit der Butterworth-Filterapproximation und dem Koeffizienten"*a = 2*" ist:

$$H_{5,3w}(s_n) = \frac{H_{TP}^3(s_n)}{H_1^1(s_n)} + \frac{1 - H_{TP}^3(s_n)}{H_2^1(s_n)} - 1 = \frac{\omega_{SY2,n}s_n + \omega_{SY2,n}a}{1 + (a - 1)s_n + s_n^2}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, w=: $H_5$ ist 3. Ordnung-basiert.

15. Elektronische Schaltungsanordnung (ESA) nach Anspruch 11, **dadurch gekennzeichnet, dass**
die Filterschaltung (FS) zur Filtersignalerzeugung (FSI1), FSI2, FSI$_K$) und die Kombinationsschaltung (KS) zur Erzeugung des Kombinationssignals (KSI) derart ausgebildet sind, dass für die mit der Filterung (flt) symmetrische und kompensatorische Erzeugung des Kombinationssignals (KS)

**a1**) die dritte Übertragungsfunktion k-ter Ordnung $"\mathbf{H}_3^k(s)"$ (ÜF3) des ersten Filtersystems (FSY1, FSY1'),

- wenn dieses auf einem Symmetrie-Tiefpass mit einer Verstärkung von "1" und einer Symmetrie-Tiefpass-Übertragungsfunktion 1. Ordnung $"\mathbf{H}_{STP}^1(s_n)"$ mit $\mathbf{H}_{STP}^1(s_n) = \frac{1}{1+s_n}$ und einer Filterapproximationsunabhängigkeit basiert, und

- das aus einem multiplikative Produkt von der Symmetrie-Tiefpass-Übertragungsfunktion 1. Ordnung $"\mathbf{H}_{STP}^1(s_n)"$ und einer Inversen $"1/\mathbf{H}_1^1(s_n)"$ der Übertragungsfunktion 1. Ordnung $"\mathbf{H}_1^1(s_n)"$ des Tiefpasses (TP) als das erste elektrische System (SY1) gebildet wird,

eine vierte Übertragungsfunktion 1. Ordnung $"\mathbf{H}_{3,4}^1(s_n)"$ mit der Filterapproximationsunabhängigkeit ist:

$$H_{3,4}^1(s_n) = \frac{H_{STP}^1(s_n)}{H_1^1(s_n)} = \frac{\omega_{SY2,n}s_n + 1}{s_n + 1}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$,

a2) die vierte Übertragungsfunktion k-ter Ordnung $"\mathbf{H}_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem Symmetrie-Tiefpass mit der Symmetrie-Tiefpass-Übertragungsfunktion 1. Ordnung $"\mathbf{H}_{STP}^1(s_n)"$ mit $\mathbf{H}_{STP}^1(s_n) = \frac{1}{1+s_n}$ und der Filterapproximationsunabhängigkeit oder aus dem Symmetrie-Tiefpass mit der Symmetrie-Tiefpass-Übertragungsfunktion 1. Ordnung $"\mathbf{H}_{STP}^1\left(s_n \to \frac{1}{s_n}\right)"$ mit $\mathbf{H}_{STP}^1\left(s_n \to \frac{1}{s_n}\right) = \frac{s_n}{s_n+1}$ und der Filterapproximationsunabhängigkeit gebildet wird,

- wobei die Übertragungsfunktion "1" und die Symmetrie-Tiefpass-Übertragungsfunktion 1. Ordnung $"\mathbf{H}_{STP}^1(s_n)"$ subtraktiv nach der Maßgabe $"1 - \mathbf{H}_{STP}^1(s_n)"$ verknüpft werden, und

- die Verknüpfung aus der Übertragungsfunktion "1" und der Symmetrie-Tiefpass-Übertragungsfunktion 1. Ordnung $"\mathbf{H}_{STP}^1(s_n)"$ mit einer Inversen $"1/\mathbf{H}_2^1(s_n)"$ der Übertragungsfunktion 1. Ordnung $"\mathbf{H}_2^1(s_n)"$ des Hochpasses (HP) als das zweite elektrische System (SY2) multipliziert wird,

eine vierte Übertragungsfunktion 1. Ordnung $"\mathbf{H}_{4,4}^1(s_n)"$ mit der Filterapproximationsunabhängigkeit ist:

$$H_{4,4}^1(s_n) = \frac{1 - H_{STP}^1(s_n)}{H_2^1(s_n)} = \frac{H_{STP}^1\left(s_n \to \frac{1}{s_n}\right)}{H_2^1(s_n)} = \frac{\omega_{SY2,n} + s_n}{s_n + 1}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$,

a3) die fünfte Übertragungsfunktion "$H_5(s)$" (ÜF5) des zweiten Filtersystems (FSY2),

- das aus dem multiplikativen Produkt von der Symmetrie-Tiefpass-Übertragungsfunktion 1. Ordnung "$H_{STP}^1(s_n)$" mit der Filterapproximationsunabhängigkeit und der Inversen "$1/H_1^1(s_n)$" der Über-tragungsfunktion 1. Ordnung "$H_1^1(s_n)$" des Tiefpasses (TP) als das erste elektrische System (SY1) gebildet wird,

- das aus dem in dem zweiten Filtersystem (FSY2) eins-zu-eins übertragenen, zweiten Ausgangssignal (ASI2) mit der Übertragungsfunktion "1" und aus dem Symmetrie-Tiefpass mit der Standard-Tiefpass-Übertragungsfunktion 1. Ordnung "$H_{STP}^1(s_n)$" und der Filterapproximationsunabhängigkeit, wobei die Übertragungsfunktion "1" und die Symmetrie-Tiefpass-Übertragungsfunktion 1. Ordnung "$H_{STP}^1(s_n)$" subtraktiv nach der Maßgabe "$1-H_{STP}^1(s_n)$" verknüpft werden und wobei die Verknüpfung aus der Übertragungsfunktion "1" und der Symmetrie-Tiefpass-Übertragungsfunktion 1. Ordnung "$H_{STP}^1(s_n)$" mit der Inversen "$1/H_2^1(s_n)$" der Übertragungsfunktion 1. Ordnung "$H_2^1(s_n)$" des Hochpasses (HP) als das zweite elektrische System (SY2) multipliziert wird, gebildet wird,
- wobei das multiplikative Produkt und das Multiplikationsprodukt aus der Verknüpfung und der Inversen "$1/H_2^1(s_n)$" der Übertragungsfunktion 1. Ordnung "$H_2^1(s_n)$" addiert werden, und
- wobei von einer durch die Addition gebildeten Summe das in dem zweiten Filtersystem (FSY2) eins-zu-eins übertragene, zweite Ausgangssignal (ASI2) mit der Übertragungsfunktion "1" subtrahiert wird, eine vierte Übertragungsfunktion "$H_{5,4u}(s_n)$" mit der Filterapproximationsunabhängigkeit ist:

$$H_{5,4u}(s_n) = \frac{H_{STP}^1(s_n)}{H_1^1(s_n)} + \frac{1 - H_{STP}^1(s_n)}{H_2^1(s_n)} - 1 = \omega_{SY2,n}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, u=: $H_5$ ist 1. Ordnung-basiert, <u>oder</u>

**b1**) die dritte Übertragungsfunktion k-ter Ordnung "$H_3^k(s)$" (ÜF3) des ersten Filtersystems (FSY1, FSY1'),

- wenn dieses auf einem Symmetrie-Tiefpass mit einer Verstärkung von "1" und einer Symmetrie-Tiefpass-Übertragungsfunktion 3. Ordnung "$H_{STP}^3(s_n)$" mit $H_{STP}^3(s_n) = \frac{1+as_n}{1+as_n+as_n^2+s_n^3}$ und einem Koeffizienten "a=3" als dreifache Polstelle basiert, und
- das aus einem multiplikative Produkt von der Symmetrie-Tiefpass-Übertragungsfunktion 3. Ordnung "$H_{STP}^3(s_n)$" und einer Inversen "$1/H_1^1(s_n)$" der Übertragungsfunktion 1. Ordnung "$H_1^1(s_n)$" des Tiefpasses (TP) als das erste elektrische System (SY1) gebildet wird,

eine vierte Übertragungsfunktion 3. Ordnung "$H_{3,4}^3(s_n)$" mit dem Koeffizienten "a=3" als dreifache Polstelle ist:

$$H_{3,4}^3(s_n) = \frac{H_{STP}^3(s_n)}{H_1^1(s_n)} = \frac{1 + (a + \omega_{SY2,n})s_n + a\omega_{SY2,n}s_n^2}{1 + as_n + as_n^2 + s_n^3}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$,

b2) die vierte Übertragungsfunktion k-ter Ordnung $"\mathbf{H}_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem Symmetrie-Tiefpass mit der Symmetrie-Tiefpass-Übertragungsfunktion 3. Ordnung $"\mathbf{H}_{STP}^3(s_n)"$ mit $\mathbf{H}_{STP}^3(s_n) = \dfrac{1+as_n}{1+as_n+as_n^2+s_n^3}$ und dem Koeffizienten "a=3" als dreifache Polstelle oder aus dem Symmetrie-Tiefpass mit der Symmetrie-Tiefpass-Übertragungsfunktion 3. Ordnung $"\mathbf{H}_{STP}^3\left(s_n \to \dfrac{1}{s_n}\right)"$ mit $\mathbf{H}_{STP}^3\left(s_n \to \dfrac{1}{s_n}\right) = \dfrac{1+a\frac{1}{s_n}}{1+a\frac{1}{s_n}+a\frac{1}{s_n^2}+\frac{1}{s_n^3}}$ und dem Koeffizienten "a=3" als dreifache Polstelle gebildet wird,

- wobei die Übertragungsfunktion "1" und die Symmetrie-Tiefpass-Übertragungsfunktion 3. Ordnung $"\mathbf{H}_{STP}^3(s_n)"$ subtraktiv nach der Maßgabe $"1-\mathbf{H}_{STP}^3(s_n)"$ verknüpft werden, und

- die Verknüpfung aus der Übertragungsfunktion "1" und der Symmetrie-Tiefpass-Übertragungsfunktion 3. Ordnung $"\mathbf{H}_{STP}^3(s_n)"$ oder die Symmetrie-Tiefpass-Übertragungsfunktion 3. Ordnung $"\mathbf{H}_{STP}^3\left(s_n \to \dfrac{1}{s_n}\right)"$ mit einer Inversen $"1/\mathbf{H}_2^1(s_n)"$ der Übertragungsfunktion 1. Ordnung $"\mathbf{H}_2^1(s_n)"$ des Hochpasses (HP) als das zweite elektrische System (SY2) multipliziert wird,

eine vierte Übertragungsfunktion 3. Ordnung $"\mathbf{H}_{4,4}^3(s_n)"$ mit dem Koeffizienten "a=3" als dreifache Polstelle ist:

$$\mathbf{H}_{4,4}^3(s_n) = \frac{1 - \mathbf{H}_{STP}^3(s_n)}{\mathbf{H}_2^1(s_n)} = \frac{\mathbf{H}_{STP}^3\left(s_n \to \dfrac{1}{s_n}\right)}{\mathbf{H}_2^1(s_n)} = \frac{a\omega_{SY2,n}s_n + \left(a + \omega_{SY2,n}\right)s_n^2 + s_n^3}{1 + as_n + as_n^2 + s_n^3}$$

mit $s_n = s/\omega_0$, $\omega_{SY1,n} = \omega_{SY1}/\omega_0$, $\omega_{SY2,n} = \omega_{SY2}/\omega_0$, $M_{SY1,n} = 1/\omega_{SY2,n}$,

b3) die fünfte Übertragungsfunktion $"\mathbf{H}_5(s)"$ (ÜF5) des zweiten Filtersystems (FSY2),

- das aus dem multiplikativen Produkt von der Symmetrie-Tiefpass-Übertragungsfunktion 3. Ordnung $"\mathbf{H}_{STP}^3(s_n)"$ mit dem Koeffizienten "a=3" als dreifache Polstelle und der Inversen $"1/\mathbf{H}_1^1(s_n)"$ der Übertragungsfunktion 1. Ordnung $"\mathbf{H}_1^1(s_n)"$ des Tiefpasses (TP) als das erste elektrische System (SY1) gebildet wird,

- das aus dem in dem zweiten Filtersystem (FSY2) eins-zu-eins übertragenen, zweiten Ausgangssignal (ASI2) mit der Übertragungsfunktion "1" und aus dem Symmetrie-Tiefpass mit der Symmetrie-Tiefpass-Übertragungsfunktion 3. Ordnung $"\mathbf{H}_{STP}^3(s_n)"$ und dem Koeffizienten "a=3" als dreifache Polstelle, wobei die Übertragungsfunktion "1" und die Symmetrie-Tiefpass-Übertragungsfunktion 3. Ordnung $"\mathbf{H}_{STP}^3(s_n)"$ subtraktiv nach der Maßgabe $"1-\mathbf{H}_{STP}^3(s_n)"$ verknüpft werden und wobei die Verknüpfung aus der Übertragungsfunktion "1" und der Symmetrie-Tiefpass-Übertragungsfunktion 3. Ordnung $"\mathbf{H}_{STP}^3(s_n)"$ mit der Inversen $"1/\mathbf{H}_2^1(s_n)"$ der Übertragungsfunktion 1. Ordnung $"\mathbf{H}_2^1(s_n)"$ des

Hochpasses (HP) als das zweite elektrische System (SY2) multipliziert wird, gebildet wird,
- wobei das multiplikative Produkt und das Multiplikationsprodukt aus der Verknüpfung und der Inversen $"1/H_2^1(s_n)"$ der Übertragungsfunktion 1. Ordnung $"H_2^1(s_n)"$ addiert werden, und
- wobei von einer durch die Addition gebildeten Summe das in dem zweiten Filtersystem (FSY2) eins-zu-eins übertragene, zweite Ausgangssignal (ASI2) mit der Übertragungsfunktion "1" subtrahiert wird,

eine vierte Übertragungsfunktion $"H_{5,5w}(s_n)"$ mit dem Koeffizienten "a=3" als dreifache Polstelle ist:

$$H_{5,5w}(s_n) = \frac{H_{STP}^3(s_n)}{H_1^1(s_n)} + \frac{1 - H_{STP}^3(s_n)}{H_2^1(s_n)} - 1 = \frac{\omega_{SY2,n}s_n + a\omega_{SY2,n}s_n}{s_n^2 + (a-1)s_n + 1}$$

mit $s_n=s/\omega_0$, $\omega_{SY1,n}=\omega_{SY1}/\omega_0$, $\omega_{SY2,n}=\omega_{SY2}/\omega_0$, $\omega_{SY1,n}=1/\omega_{SY2,n}$, w=: $H_5$ ist 3. Ordnung-basiert,
<u>oder</u>

**c1)** die dritte Übertragungsfunktion k-ter Ordnung $"H_3^k(s)"$ (ÜF3) des ersten Filtersystems (FSY1, FSY1'),

- wenn dieses auf einem Symmetrie-Tiefpass mit einer Verstärkung von "1" und einer Symmetrie-Tiefpass-Übertragungsfunktion 5. Ordnung $"H_{STP}^5(s_n)"$ mit $H_{STP}^5(s_n) = \frac{1+a_1s_n+a_2s_n^2}{1+a_1s_n+a_2s_n^2+a_2s_n^3+a_1s_n^4+s_n^5}$

und Koeffizienten "$a_1$=15,19" und $"a_2 = \frac{a_1^2}{4}$ basiert, und
- das aus einem multiplikative Produkt von der Symmetrie-Tiefpass-Übertragungsfunktion 5. Ordnung $"H_{STP}^5(s_n)"$ und einer Inversen $"1/H_1^1(s_n)"$ der Übertragungsfunktion 1. Ordnung $"H_1^1(s_n)"$ des Tiefpasses (TP) als das erste elektrische System (SY1) gebildet wird,

eine zweite Übertragungsfunktion 3. Ordnung $"H_{3,2}^5(s_n)"$ mit den Koeffizienten "$a_1$=15,19" und $"a_2 = \frac{a_1^2}{4}"$ ist:

$$H_{3,2}^5(s_n) = \frac{H_{STP}^5(s_n)}{H_1^1(s_n)} = \frac{(a_2s_n^2 + a_1s_n + 1)(1 + s_n\omega_{SY2,n})}{(s_n^5 + a_1s_n^4 + a_2s_n^3 + a_2s_n^2 + a_1s_n + 1)}$$

mit $s_n=s/\omega_0$, $\omega_{SY1,n}=\omega_{SY1}/\omega_0$, $\omega_{SY2,n}=\omega_{SY2}/\omega_0$, $\omega_{SY1,n}=1/\omega_{SY2,n}$,

**c2)** die vierte Übertragungsfunktion k-ter Ordnung $"H_4^k(s)"$ (ÜF4) des zweiten Filtersystems (FSY2),

- das aus dem in dem zweiten Filtersystem (FSY2) eins-zu-eins übertragenen, zweiten Ausgangssignal (ASI2) mit einer Übertragungsfunktion "1" und aus dem Symmetrie-Tiefpass mit der Symmetrie-Tiefpass-Übertragungsfunktion 5. Ordnung $"H_{STP}^5(s_n)"$ mit $H_{STP}^5(s_n) = \frac{1+a_1s_n+a_2s_n^2}{1+a_1s_n+a_2s_n^2+a_2s_n^3+a_1s_n^4+s_n^5}$ und

den Koeffizienten "$a_1$= 15,19" und $"a_2 = \frac{a_1^2}{4}"$ oder aus dem Symmetrie-Tiefpass mit der Symmetrie-Tiefpass-Übertragungsfunktion 5. Ordnung $"H_{STP}^5\left(s_n \to \frac{1}{s_n}\right)"$ mit $H_{STP}^5\left(s_n \to \frac{1}{s_n}\right) =$

$$\frac{1+a_1\frac{1}{s_n}+a_2\frac{1}{s_n^2}}{1+a_1\frac{1}{s_n}+a_2\frac{1}{s_n^2}+a_2\frac{1}{s_n^3}+a_1\frac{1}{s_n^4}+\frac{1}{s_n^5}}$$ und den Koeffizienten "$a_1$= 15,19" und "$a_2 = \frac{a_1^2}{4}$" gebildet wird,

- wobei die Übertragungsfunktion "1" und die Symmetrie-Tiefpass-Übertragungsfunktion 5. Ordnung "$H_{STP}^5(s_n)$" subtraktiv nach der Maßgabe "$1-H_{STP}^5(s_n)$" verknüpft werden, und

- die Verknüpfung aus der Übertragungsfunktion "1" und der Symmetrie-Tiefpass-Übertragungsfunktion 5. Ordnung "$H_{STP}^5(s_n)$" oder die Symmetrie-Tiefpass-Übertragungsfunktion 5. Ordnung "$H_{STP}^5\left(s_n \rightarrow \frac{1}{s_n}\right)$" mit einer Inversen "$1/H_2^1(s_n)$" der Übertragungsfunktion 1. Ordnung "$H_2^1(s_n)$" des Hochpasses (HP) als das zweite elektrische System (SY2) multipliziert wird,

eine zweite Übertragungsfunktion 5. Ordnung "$H_{4,2}^5(s_n)$" mit den Koeffizienten "$a_1$ = 15,19" und "$a_2 = \frac{a_1^2}{4}$" ist:

$$H_{4,2}^5(s_n) = \frac{1 - H_{STP}^5(s_n)}{H_2^1(s_n)} = \frac{H_{STP}^5\left(s_n \rightarrow \dfrac{1}{s_n}\right)}{H_2^1(s_n)}$$
$$= \frac{\left(s_n^4 + a_1 s_n^3 + a_2 s_n^2\right)\left(\omega_{SY2,n} + s_n\right)}{\left(s_n^5 + a_1 s_n^4 + a_2 s_n^3 + a_2 s_n^2 + a_1 s_n + 1\right)}$$

mit $s_n=s/\omega_0$, $\omega_{SY1,n}=\omega_{SY1}/\omega_0$, $\omega_{SY2,n}=\omega_{SY2}/\omega_0$, $\omega_{SY1,n}=1/\omega_{SY2,n}$,

c3) die fünfte Übertragungsfunktion "$H_5(s)$" (ÜF5) des zweiten Filtersystems (FSY2),

- das aus dem multiplikativen Produkt von der Symmetrie-Tiefpass-Übertragungsfunktion 5. Ordnung "$H_{STP}^5(s_n)$" mit mit den Koeffizienten "$a_1$ = **15,19**" und "$a_2 = \frac{a_1^2}{4}$" und der Inversen "$1/H_1^1(s_n)$" der Übertragungsfunktion 1. Ordnung "$H_1^1(s_n)$" des Tiefpasses (TP) als das erste elektrische System (SY1) gebildet wird,

- das aus dem in dem zweiten Filtersystem (FSY2) eins-zu-eins übertragenen, zweiten Ausgangssignal (ASI2) mit der Übertragungsfunktion "1" und aus dem Symmetrie-Tiefpass mit der Symmetrie-Tiefpass-Übertragungsfunktion 5. Ordnung "$H_{STP}^5(s_n)$" und den Koeffizienten "**$a_1$ = 15,19**" und "**$a_2$ =** $\frac{a_1^2}{4}$", wobei die Übertragungsfunktion "1" und die Symmetrie-Tiefpass-Übertragungsfunktion 5. Ordnung "$H_{STP}^5(s_n)$" subtraktiv nach der Maßgabe "$1-H_{STP}^5(s_n)$" verknüpft werden und wobei die Verknüpfung aus der Übertragungsfunktion "1" und der Symmetrie-Tiefpass-Übertragungsfunktion 5. Ordnung "$H_{STP}^5(s_n)$" mit der Inversen "$1/H_2^1(s_n)$" der Übertragungsfunktion 1. Ordnung "$H_2^1(s_n)$" des Hochpasses (HP) als das zweite elektrische System (SY2) multipliziert wird, gebildet wird,

- wobei das multiplikative Produkt und das Multiplikationsprodukt aus der Verknüpfung und der Inversen "$1/H_2^1(s_n)$" der Übertragungsfunktion 1. Ordnung "$H_2^1(s_n)$" addiert werden, und

- wobei von einer durch die Addition gebildeten Summe das in dem zweiten Filtersystem (FSY2) eins-zu-eins übertragene, zweite Ausgangssignal (ASI2) mit der Übertragungsfunktion "1" subtrahiert wird,

eine fünfte Übertragungsfunktion $"\mathbf{H}_{5,6x}(s_n)"$ mit den Koeffizienten $\mathbf{a_1 = 15{,}19}$ und $"a_2 = \frac{a_1^2}{4}"$ ist:

$$\mathbf{H}_{5,6x}(s_n) = \frac{\mathbf{H}_{STP}^5(s_n)}{\mathbf{H}_1^1(s_n)} + \frac{1 - \mathbf{H}_{STP}^5(s_n)}{\mathbf{H}_2^1(s_n)} - 1$$

$$= \frac{\omega_{SY2,n}s_n^{\ 3} + (a_2 + a_1 - 1)\omega_{SY2,n}s_n^{\ 2} + s_n\omega_{SY2,n}}{(s_n^{\ 4} + (a_1 - 1)s_n^{\ 3} + (a_2 - a_1 + 1)s_n^{\ 2} + (a_1 - 1)s_n + 1)}$$

mit $s_n = s/\omega_0$, $\omega_{SY1,n} = \omega_{SY1}/\omega_0$, $\omega_{SY2,n} = \omega_{SY2}/\omega_0$, $\omega_{SY1,n} = 1/\omega_{SY2,n}$, x=: $\mathbf{H}_5$ ist 5. Ordnung-basiert.

**16.** Elektronische Schaltungsanordnung (ESA) nach einem der Ansprüche 9 bis 15, **gekennzeichnet durch**

- einen "Direct Current <DC>"-Sensor, z.B. einen Fluxgate-Wandler (FGW) in Closed Loop-Ausführung oder einen Hall Effect Sensor (HES) in Open Loop/Closed Loop-Ausführung oder einen Pearson-Wandler (PW) mit "wide-band current transformer"-Charakteristik, zur Messung eines Stroms als Messgröße MG und dem Eingangssignal ESI mit einer oberen Grenzfrequenz $f_{o,\ Gr}$= 200kHz, dies entspricht einem Wert der Grenzkreisfrequenz $\omega_{SY1}$ von "$2\pi$ x 200kHz", als das erste elektrische System (SY1) und
- einen "Alternate Current <AC>"-Sensor, z.B. einen PEM-Wandler (PEM-W) als Rogowski-Spule mit Integrierer oder einen Stromwandler (STW) mit Sekundär-Shunt, zur Messung des Stroms als Messgröße MG und dem Eingangssignal ESI mit einer unteren Grenzfrequenz $f_{u,Gr}$= 20Hz, dies entspricht einem Wert der Grenzkreisfrequenz $\omega_{SY2}$ von "$2\pi$ x 20Hz", als das zweite elektrische System (SY2).

Europäisches
Patentamt

European
Patent Office

Office européen
des brevets

## EUROPÄISCHER RECHERCHENBERICHT

Nummer der Anmeldung

EP 21 16 4380

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | THOMAS DEHAEZE ET AL: "Complementary Filters Shaping Using H[infinity] Synthesis", 2019 7TH INTERNATIONAL CONFERENCE ON CONTROL, MECHATRONICS AND AUTOMATION (ICCMA), IEEE, 6. November 2019 (2019-11-06), Seiten 459-464, XP033709897, DOI: 10.1109/ICCMA46720.2019.8988642 [gefunden am 2020-02-07] * das ganze Dokument * | 1-16 | INV. G01R15/08 |
| A | US 2013/176016 A1 (KANG SHIN JAE [KR]) 11. Juli 2013 (2013-07-11) * Absatz [0064] - Absatz [0092]; Abbildungen 1-4 * | 1-16 | |
| A | US 2018/252748 A1 (WOOD STEPHEN JAMES MARTIN [GB] ET AL) 6. September 2018 (2018-09-06) * Absätze [0032], [0033], [0109] - [0113] * | 1-16 | |
| A,D | WO 2017/197269 A1 (UNIV NORTH CAROLINA CHARLOTTE [US]) 16. November 2017 (2017-11-16) * Absatz [0035]; Abbildung 6 * | 1-16 | RECHERCHIERTE SACHGEBIETE (IPC)  G01R |
| A | DE 10 2005 059202 A1 (MITSUBISHI ELECTRIC CORP [JP]) 21. Dezember 2006 (2006-12-21) * Absatz [0041] - Absatz [0046]; Abbildungen 1,5,7 * | 1-16 | |

Der vorliegende Recherchenbericht wurde für alle Patentansprüche erstellt

| Recherchenort | Abschlußdatum der Recherche | Prüfer |
|---|---|---|
| München | 14. September 2021 | O'Callaghan, D |

## ANHANG ZUM EUROPÄISCHEN RECHERCHENBERICHT
## ÜBER DIE EUROPÄISCHE PATENTANMELDUNG NR.

EP 21 16 4380

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-09-2021

| Im Recherchenbericht angeführtes Patentdokument | Datum der Veröffentlichung | Mitglied(er) der Patentfamilie | Datum der Veröffentlichung |
|---|---|---|---|
| US 2013176016 A1 | 11-07-2013 | KR 20130055341 A<br>US 2013176016 A1 | 28-05-2013<br>11-07-2013 |
| US 2018252748 A1 | 06-09-2018 | EP 2756318 A2<br>EP 3441775 A2<br>EP 3736578 A2<br>US 2014253102 A1<br>US 2016291060 A1<br>US 2018252748 A1<br>WO 2013038176 A2 | 23-07-2014<br>13-02-2019<br>11-11-2020<br>11-09-2014<br>06-10-2016<br>06-09-2018<br>21-03-2013 |
| WO 2017197269 A1 | 16-11-2017 | US 2019064225 A1<br>WO 2017197269 A1 | 28-02-2019<br>16-11-2017 |
| DE 102005059202 A1 | 21-12-2006 | CN 1877245 A<br>DE 102005059202 A1<br>JP 4536602 B2<br>JP 2006343236 A<br>US 2006289408 A1 | 13-12-2006<br>21-12-2006<br>01-09-2010<br>21-12-2006<br>28-12-2006 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3671226 A1
- WO 2018185151 A1
- EP 3561524 A1
- WO 2020151926 A1
- WO 2017197269 A1

**In der Beschreibung aufgeführte Nicht-Patentliteratur**

- **B. HUDOFFSKY.** Berührungslose Messung schnell veränderlicher Ströme. *Dissertation*